# EUROPEAN PATENT APPLICATION

(11) **EP 4 671 866 A1**
(43) Date of publication of application: **31.12.2025**
(21) Application number: 24763874.5
(22) Date of filing: 27.02.2024
(51) Int. Cl.: G03F 7/11, G03F 7/20, H01L 21/312

(54) **COMPOSITION FOR FORMING SILICON-CONTAINING RESIST UNDERLAYER FILM HAVING CARBON-CARBON DOUBLE BOND**

(30) Priority: 28.02.2023 JP 2023029846
(71) Applicant: Nissan Chemical Corporation, Tokyo 103-6119 (JP)
(72) Inventor: TAKEDA, Satoshi, Toyama-shi, Toyama 939-2792 (JP); KATO, Kodai, Toyama-shi, Toyama 939-2792 (JP); SHIBAYAMA, Wataru, Toyama-shi, Toyama 939-2792 (JP)
(74) Representative: Müller-Boré & Partner Patentanwälte PartG mbB
(86) International application number: PCT/JP2024/006926
(87) International publication number: WO 2024/181394

(57) **Abstract**

A silicon-containing resist underlayer film-forming composition including:
component [A]: a polysiloxane; and
component [C]: a solvent,
in which
the polysiloxane contains a constituent unit derived from a hydrolyzable silane (A) represented by the following Formula (A-1), 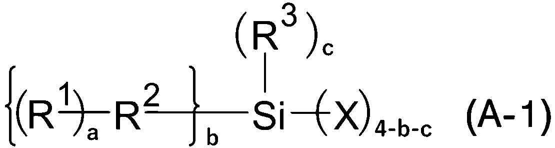 in the Formula (A-1), a and b each independently represent an integer of 1 to 3,
c represents an integer of 0 to 2,
b+c represents an integer of 1 to 3,
R¹ represents a group represented by the following Formula (A-1-1),
R² represents a (a+1)-valent group having no ring structure or a (a+1)-valent group having an aromatic hydrocarbon ring,
R³ represents a specific group,
X represents, for example, an alkoxy group, 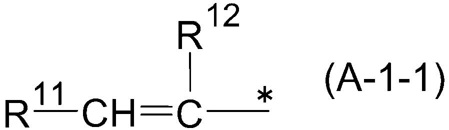 in the Formula (A-1-1), R¹¹ represents a hydrogen atom or a hydrocarbon group having 1 to 6 carbon atoms, R¹² represents a hydrogen atom, a hydrocarbon group having 1 to 4 carbon atoms, or a halogen atom, and * represents a bonding hand.

## Description

### Technical Field

The present invention relates to a silicon-containing resist underlayer film-forming composition and a silicon-containing resist underlayer film.

### Background Art

Conventionally, microfabrication by lithography using a photoresist has been performed in the production of a semiconductor device. The microfabrication is a processing method of forming microrelief corresponding to a pattern on a substrate surface by forming a thin film of a photoresist on a semiconductor substrate such as a silicon wafer, irradiating the thin film with an active ray such as an ultraviolet ray through a mask pattern on which a semiconductor device pattern is drawn, developing the thin film, and etching the substrate using the obtained photoresist pattern as a protective film.

While the degree of integration of semiconductor devices has been increased, the wavelength of an active ray to be used also tends to be shortened from a KrF excimer laser (248 nm) to an ArF excimer laser (193 nm), and furthermore, an exposure technique using an extreme ultraviolet (EUV) or an electron beam has been studied. With the shortening of the wavelength of an active ray, the influence of reflection of the active ray from the semiconductor substrate becomes a major problem, and a method for providing a resist underlayer film called an antireflection film (Bottom Anti-Reflective Coating, BARC) between a photoresist and a substrate to be processed has been widely applied. As such a resist underlayer film, for example, an underlayer film containing silicon or the like has been proposed (Patent Literature 1 and the like).

With the miniaturization of a resist pattern in the most advanced semiconductor devices in recent years, the demand for thinning a resist has become more remarkable. In particular, in a three-layer process including a resist film, a silicon-containing resist underlayer film, and an organic underlayer film, good lithography characteristics of the resist on the silicon-containing resist underlayer film are desired.

### Citation List

### Patent Literature

Patent Literature 1: JP 2007-163846 A

### Summary of Invention

### Technical Problem

Aiming at finer patterning of the resist as described above, a lithography technique using a metal oxide resist (MOR) having excellent etching resistance as compared with a known chemically amplified resist has been actively developed in recent years. For finer patterning in the future, it is essential to reduce the thickness of the resist film. However, the metal oxide resist (MOR) (hereinafter, also referred to as "metal-containing resist") has sufficient etching resistance to perform fine patterning even on a thin film. Thus, the metal oxide resist is recently expected as a material to be used for next generation EUV lithography technique. Under such a background, the performance of imparting good lithography characteristics to the metal oxide resist underlayer film, which is different from the known chemically amplified resist underlayer film, may be an important object.

The present invention has been made in view of the above circumstances, and an object of the present invention is to provide a silicon-containing resist underlayer film-forming composition for forming a resist underlayer film capable of improving sensitivity without reducing roughness of a pattern in fine patterning with a resist film, preferably a metal-containing resist film.

### Solution to Problem

As a result of intensive studies to solve the above problem, the present inventors have found that the above problem can be solved, and completed the present invention having the following gist.

That is, the present invention includes the following aspects.
[1] A silicon-containing resist underlayer film-forming composition including:
   component [A]: a polysiloxane; and
   component [C]: a solvent,
   wherein
   the polysiloxane contains a constituent unit derived from a hydrolyzable silane (A) represented by Formula (A-1) below: 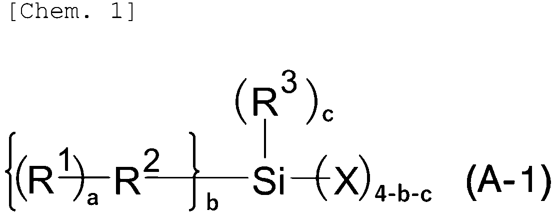
   in the Formula (A-1), a and b each independently represent an integer of 1 to 3,
   c represents an integer of 0 to 2,
   b+c represents an integer of 1 to 3,
   R¹ represents a group represented by Formula (A-1-1) below,
   R² represents a (a+1)-valent group having no ring structure or a (a+1)-valent group having an aromatic hydrocarbon ring,
   R³ represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group or an optionally substituted alkoxyaralkyl group, or an organic group having an epoxy group, an organic group having a mercapto group, an organic group having an amino group, an organic group having an alkoxy group, an organic group having a sulfonyl group or an organic group having a cyano group, or a combination of two or more thereof,
   X represents an alkoxy group, an aralkyloxy group, an acyloxy group, or a halogen atom, and
   for a plurality of R¹, R², R³, and X, the plurality of R¹, R², R³, and X may be same or different, 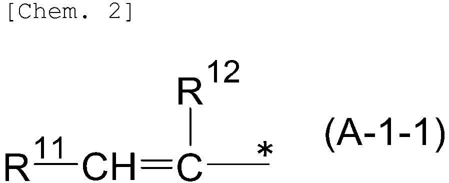
   in the Formula (A-1-1), R¹¹ represents a hydrogen atom or a hydrocarbon group having 1 to 6 carbon atoms, R¹² represents a hydrogen atom, a hydrocarbon group having 1 to 4 carbon atoms, or a halogen atom, and * represents a bonding hand.
[2] The silicon-containing resist underlayer film-forming composition, including:
   component [A']: a polysiloxane;
   component [B]: a hydrolyzable silane (A) represented by Formula (A-1) below; and
   component [C]: a solvent, 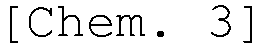 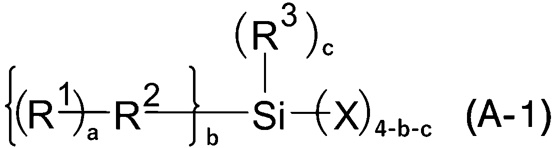
   in the Formula (A-1), a and b each independently represent an integer of 1 to 3,
   c represents an integer of 0 to 2,
   b+c represents an integer of 1 to 3,
   R¹ represents a group represented by Formula (A-1-1) below,
   R² represents a (a+1)-valent group having no ring structure or a (a+1)-valent group having an aromatic hydrocarbon ring,
   R³ represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group or an optionally substituted alkoxyaralkyl group, or an organic group having an epoxy group, an organic group having a mercapto group, an organic group having an amino group, an organic group having an alkoxy group, an organic group having a sulfonyl group or an organic group having a cyano group, or a combination of two or more thereof,
   X represents an alkoxy group, an aralkyloxy group, an acyloxy group, or a halogen atom, and
   for a plurality of R¹, R², R³, and X, the plurality of R¹, R², R³, and X may be same or different, 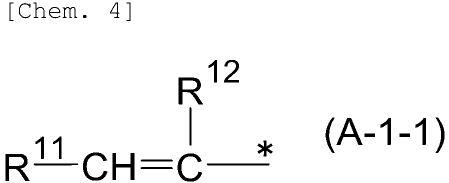
   in the Formula (A-1-1), R¹¹ represents a hydrogen atom or a hydrocarbon group having 1 to 6 carbon atoms, R¹² represents a hydrogen atom, a hydrocarbon group having 1 to 4 carbon atoms, or a halogen atom, and * represents a bonding hand.
[3] The silicon-containing resist underlayer film-forming composition according to [1] or [2], wherein the silicon-containing resist underlayer film-forming composition is a composition for forming a silicon-containing resist underlayer film formed between a metal-containing resist film and a substrate.
[4] The silicon-containing resist underlayer film-forming composition according to [1] or [3], wherein the component [A] does not have an alkyl iodide group.
[5] The silicon-containing resist underlayer film-forming composition according to [2] or [3], wherein the component [A'] does not have an alkyl iodide group.
[6] The silicon-containing resist underlayer film-forming composition according to [1] or [3], wherein
   the component [A] contains a constituent unit derived from a hydrolyzable silane (1) represented by Formula (1) below,
   b in the Formula (A-1) is 1, and c is 0, and
   a total molar ratio of the constituent unit (Aᵤₙᵢₜ) derived from the hydrolyzable silane (A) represented by the Formula (A-1) and the constituent unit (1ᵤₙᵢₜ) derived from the hydrolyzable silane (1) represented by the Formula (1) in all T units in the component [A] is 5 mol% or more and 100 mol% or less,
      [Chem. 5]

      R¹ₐSi(R²)₄₋ₐ (1)
   in the Formula (1), R¹ is a group bonded to a silicon atom, and each independently represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, or an optionally substituted alkenyl group, or an organic group having an epoxy group, an organic group having a mercapto group, an organic group having an amino group, an organic group having an alkoxy group, an organic group having a sulfonyl group, or an organic group having a cyano group, or a combination of two or more thereof,
   R² is a group or atom bonded to a silicon atom, and each independently represents an alkoxy group, an aralkyloxy group, an acyloxy group, or a halogen atom, and
   a represents 1.
[7] The silicon-containing resist underlayer film-forming composition according to any one of [1] to [6], wherein the component [C] contains an alcohol-based solvent.
[8] The silicon-containing resist underlayer film-forming composition according to [7], wherein the component [C] contains a propylene glycol monoalkyl ether.
[9] The silicon-containing resist underlayer film-forming composition according to any one of [1] to [8], further including component [D]: a curing catalyst.
[10] The silicon-containing resist underlayer film-forming composition according to any one of [1] to [9], further including component [E]: nitric acid.
[11] The silicon-containing resist underlayer film-forming composition according to any one of [1] to [10], wherein the component [C] contains water.
[12] The silicon-containing resist underlayer film-forming composition according to any one of [1] to [11], which is for forming a resist underlayer film for use in EUV lithography.
[13] The silicon-containing resist underlayer film-forming composition according to any one of [1] to [12], which is used in EUV lithography using a metal oxide resist film.
[14] A silicon-containing resist underlayer film which is a cured product of the silicon-containing resist underlayer film-forming composition described in any one of [1] to [13].
[15] A semiconductor processing substrate including:
   a semiconductor substrate; and
   the silicon-containing resist underlayer film according to [14].
[16] A method for producing a semiconductor element, the method including:
   a step of forming an organic underlayer film on a substrate;
   a step of forming a resist underlayer film on the organic underlayer film using the silicon-containing resist underlayer film-forming composition according to any one of [1] to [13]; and
   a step of forming a metal-containing resist film on the resist underlayer film.
[17] The method for producing a semiconductor element according to [16], wherein
   the metal-containing resist film is formed from a metal-containing resist for use in EUV lithography.
[18] The method for manufacturing a semiconductor element according to [16] or [17], wherein
   in the step of forming a resist underlayer film, a silicon-containing resist underlayer film-forming composition filtered through a nylon filter is used.
[19] A method for forming a pattern, including steps of:
   a step of forming an organic underlayer film on a semiconductor substrate;
   a step of forming a resist underlayer film by applying and baking the silicon-containing resist underlayer film-forming composition according to according to any one of [1] to [13] on the organic underlayer film;
   a step of forming a metal-containing resist film on the resist underlayer film;
   a step of obtaining a resist pattern by exposing and developing the metal-containing resist film;
   a step of etching the resist underlayer film by using the resist pattern as a mask; and
   a step of etching the organic underlayer film by using the patterned resist underlayer film as a mask.
[20] The method for forming a pattern according to [19], further including:
   a step of removing the resist underlayer film by a wet method using a chemical liquid after the step of etching the organic underlayer film.
[21] The method for forming a pattern according to [19] or [20], wherein
   the metal-containing resist film is formed from a metal-containing resist for use in EUV lithography.

### Advantageous Effects of Invention

According to the present invention, it is possible to provide a silicon-containing resist underlayer film-forming composition for forming a resist underlayer film capable of improving sensitivity without reducing roughness of a pattern in fine patterning with a resist film, preferably a metal-containing resist film.

### Description of Embodiments

### (Silicon-Containing Resist Underlayer Film-Forming Composition)

Embodiments of the silicon-containing resist underlayer film-forming composition of the present invention are, for example, the following first embodiment and second embodiment.

### <First Embodiment>

The silicon-containing resist underlayer film-forming composition of the present invention according to a first embodiment contains a polysiloxane as component [A] and a solvent as component [C], and further contains an additional component, if necessary.

The polysiloxane as the component [A] contains a structural unit derived from a hydrolyzable silane (A) represented by the following Formula (A-1). The polysiloxane as the component [A] is, for example, a hydrolysis condensate of the hydrolyzable silane containing the hydrolyzable silane (A) represented by the following Formula (A-1) or a modified product of the hydrolysis condensate.

### <Second Embodiment>

The silicon-containing resist underlayer film-forming composition of the present invention according to a second embodiment contains a polysiloxane (hereinafter, may be referred to as "polysiloxane [A']") as component [A'], a hydrolyzable silane (A) represented by the following Formula (A-1) as component [B], and a solvent as component [C], and further contains additional component, if necessary.

The present inventors consider as follows.

When the silicon-containing resist underlayer film formed from the silicon-containing resist underlayer film-forming composition of the present invention has, as an organic group bonded to Si, an organic group having a carbon-carbon double bond and a linking group as represented by the Formula (A-1-1), the sensitivity can be improved without reducing the roughness of the pattern in fine patterning by the metal-containing resist film. Although it is considered that electrons are involved in the curing of the metal-containing resist film, it is considered that the carbon-carbon double bond not directly bonded to Si in the silicon-containing resist underlayer film moderately traps electrons, thereby suppressing excessive diffusion of electrons and improving the sensitivity without reducing the roughness of the pattern.

For example, in patterning of an extremely fine metal-containing resist film having a resolution (hp) of less than 25 nm or even 8 to 20 nm, the sensitivity is improved without reducing the roughness of the pattern.

The silicon-containing resist underlayer film-forming composition is preferably a composition for forming a silicon-containing resist underlayer film formed between a metal-containing resist film and a substrate.

### <Hydrolyzable Silane (A)>

The hydrolyzable silane (A) is a compound represented by the following Formula (A-1).

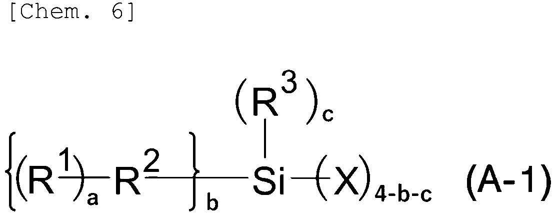

In the Formula (A-1), a and b each independently represent an integer of 1 to 3,
c represents an integer of 0 to 2,
b+c represents an integer of 1 to 3,
R¹ represents a group represented by the following Formula (A-1-1),
R² represents a (a+1)-valent group having no ring structure or a (a+1)-valent group having an aromatic hydrocarbon ring,
R³ represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group or an optionally substituted alkoxyaralkyl group, or an organic group having an epoxy group, an organic group having a mercapto group, an organic group having an amino group, an organic group having an alkoxy group, an organic group having a sulfonyl group or an organic group having a cyano group, or a combination of two or more thereof,
X represents an alkoxy group, an aralkyloxy group, an acyloxy group, or a halogen atom, and
for a plurality of R¹, R², R³, and X, the plurality of R¹, R², R³, and X may be the same or different.

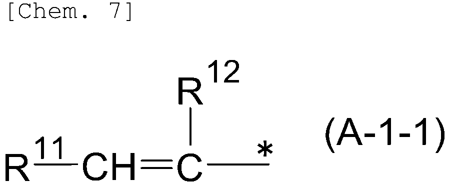

In the Formula (A-1-1), R¹¹ represents a hydrogen atom or a hydrocarbon group having 1 to 6 carbon atoms, R¹² represents a hydrogen atom, a hydrocarbon group having 1 to 4 carbon atoms, or a halogen atom, and * represents a bonding hand.

X and R³ are groups different from the [(R₁)ₐ-R²]_{b}-group.

In addition, the [(R₁)ₐ-R²]_{b}- group and R³ are not hydrolyzable groups.

The component [A] may not have an alkyl iodide group.

The component [A'] may not have an alkyl iodide group. Specifically, the alkyl iodide group is a group in which one or more hydrogen atoms of an alkyl group exemplified below are replaced with an iodine atom.

### <<R¹ in Formula (A-1) [Formula (A-1-1)]>>

Examples of the hydrocarbon group having 1 to 6 carbon atoms of R¹¹ in the Formula (A-1-1) include an alkyl group and an alkenyl group.

The alkyl group having 1 to 6 carbon atoms may be linear, branched, or cyclic.

Examples of the alkyl group having 1 to 6 carbon atoms include a methyl group, an ethyl group, a n-propyl group, an i-propyl group, a cyclopropyl group, a n-butyl group, an i-butyl group, an s-butyl group, a t-butyl group, a cyclobutyl group, a 1-methyl-cyclopropyl group, a 2-methyl-cyclopropyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

The alkenyl group having 1 to 6 carbon atoms may be linear, branched, or cyclic.

Examples of the alkenyl group having 1 to 6 carbon atoms include ethenyl group, 1-propenyl group, 2-propenyl group, 1-methyl-1-ethenyl group, 1-butenyl group, 2-butenyl group, 3-butenyl group, 2-methyl-1-propenyl group, 2-methyl-2-propenyl group, 1-ethylethenyl group, 1-methyl-1-propenyl group, 1-methyl-2-propenyl group, 1-pentenyl group, 2-pentenyl group, 3-pentenyl group, 4-pentenyl group, 1-n-propylethenyl group, 1-methyl-1-butenyl group, 1-methyl-2-butenyl group, 1-methyl-3-butenyl group, 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3 pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4-pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-t-butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, 2-methyl-3-cyclopentenyl group, 2-methyl-4-cyclopentenyl group, 2-methyl-5-cyclopentenyl group, 2-methylene-cyclopentyl group, 3-methyl-1-cyclopentenyl group, 3-methyl-2-cyclopentenyl group, 3-methyl-3-cyclopentenyl group, 3-methyl-4-cyclopentenyl group, 3-methyl-5-cyclopentenyl group, 3-methylene-cyclopentyl group, 1-cyclohexenyl group, 2-cyclohexenyl group, and 3-cyclohexenyl group.

Examples of the hydrocarbon group having 1 to 4 carbon atoms of R¹² in the Formula (A-1-1) include an alkyl group and an alkenyl group.

Specific examples of the alkyl group having 1 to 4 carbon atoms include specific examples of the alkyl group having 1 to 4 carbon atoms among the alkyl groups having 1 to 6 carbon atoms mentioned as specific examples of R¹¹.

Specific examples of the alkenyl group having 1 to 4 carbon atoms include specific examples of the alkenyl group having 1 to 4 carbon atoms in the alkenyl group having 1 to 6 carbon atoms mentioned as the specific examples of R¹¹.

Examples of the halogen atom of R¹² in the Formula (A-1-1) include a fluorine atom, a chlorine atom, a bromine atom, and an iodine atom.

### <<R² in Formula (A-1)>>

R² in the Formula (A-1) represents a (a+1)-valent group having no ring structure or a (a+1)-valent group having an aromatic hydrocarbon ring.

Examples of the (a+1)-valent group having no ring structure include a linear or branched saturated hydrocarbon group.

Examples of such a saturated hydrocarbon group include an alkylene group having 1 to 6 carbon atoms when a in the Formula (A-1) is 1. Examples of the alkylene group having 1 to 6 carbon atoms include a methylene group, a 1,1-ethylene group, a 1,2-ethylene group, a trimethylene group, a tetramethylene group, a pentamethylene group, and a hexamethylene group.

Examples of such a saturated hydrocarbon group include a trivalent saturated hydrocarbon group having 1 to 6 carbon atoms when a in the Formula (A-1) is 2.

When a in the Formula (A-1) is 1, examples of the (a+1)-valent group having no ring structure include a divalent organic group represented by the following Formula (Z-1).

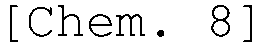

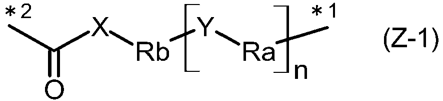

In the Formula (Z-1), -X- represents -O- or -N(H)-,
Ra and Rb each independently represent an alkylene group having 1 to 6 carbon atoms,
Y represents an ether bond, an ester bond, a urethane bond, or a urea bond,
n represents 0 or 1, and
*1 represents a bonding hand bonded to a silicon atom in the Formula (A-1), and *2 represents a bonding hand bonded to R¹ in the Formula (A-1).

The alkylene group having 1 to 6 carbon atoms in Ra and Rb in the Formula (Z-1) may be linear or branched. Examples of the alkylene group having 1 to 6 carbon atoms include a methylene group, an ethylene group, a trimethylene group, a tetramethylene group, a pentamethylene group, and a hexamethylene group.

Examples of the (a+1)-valent group having an aromatic hydrocarbon ring include (a+1)-valent groups having a benzene ring. When a in the Formula (A-1) is 1, examples of such a group include a divalent organic group represented by the following Formula (Z-2).

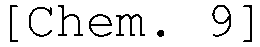

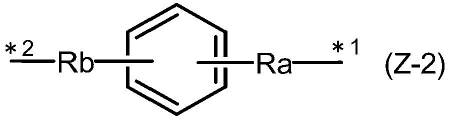

In the Formula (Z-2), Ra and Rb each independently represent a single bond or an alkylene group having 1 to 6 carbon atoms, and
*1 represents a bonding hand bonded to a silicon atom in the Formula (A-1), and *2 represents a bonding hand bonded to R¹ in the Formula (A-1).

The alkylene group having 1 to 6 carbon atoms in Ra and Rb in the Formula (Z-2) may be linear, branched, or cyclic. Examples of the alkylene group having 1 to 6 carbon atoms include a methylene group, an ethylene group, a trimethylene group, a tetramethylene group, a pentamethylene group, and a hexamethylene group.

### <<R³ in Formula (A-1)>>

The alkyl group may be linear, branched, or cyclic, and the number of carbon atoms thereof is not particularly limited, but is preferably 40 or less, more preferably 30 or less, still more preferably 20 or less, and yet still more preferably 10 or less.

Specific examples of the linear or branched alkyl group as the alkyl group include a methyl group, an ethyl group, a n-propyl group, an i-propyl group, a n-butyl group, an i-butyl group, an s-butyl group, a t-butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

Specific examples of the cyclic alkyl group include cycloalkyl groups, such as cyclopropyl group, cyclobutyl group, 1-methyl-cyclopropyl group, 2-methyl-cyclopropyl group, cyclopentyl group, 1-methyl-cyclobutyl group, 2-methyl-cyclobutyl group, 3-methyl-cyclobutyl group, 1,2-dimethyl-cyclopropyl group, 2,3-dimethyl-cyclopropyl group, 1-ethyl-cyclopropyl group, 2-ethyl-cyclopropyl group, cyclohexyl group, 1-methyl-cyclopentyl group, 2-methyl-cyclopentyl group, 3-methyl-cyclopentyl group, 1-ethyl-cyclobutyl group, 2-ethyl-cyclobutyl group, 3-ethyl-cyclobutyl group, 1,2-dimethyl-cyclobutyl group, 1,3-dimethyl-cyclobutyl group, 2,2-dimethyl-cyclobutyl group, 2,3-dimethyl-cyclobutyl group, cycloalkyl groups, such as 2,4-dimethyl-cyclobutyl group, 3,3-dimethyl-cyclobutyl group, 1-n-propyl-cyclopropyl group, 2-n-propyl-cyclopropyl group, 1-i-propyl-cyclopropyl group, 2-i-propyl-cyclopropyl group, 1,2,2-trimethyl-cyclopropyl group, 1,2,3-trimethyl-cyclopropyl group, 2,2,3-trimethyl-cyclopropyl group, 1-ethyl-2-methyl-cyclopropyl group, 2-ethyl-1-methyl-cyclopropyl group, 2-ethyl-2-methyl-cyclopropyl group, and 2-ethyl-3-methyl-cyclopropyl group; and crosslinked cyclic cycloalkyl groups, such as bicyclobutyl group, bicyclopentyl group, bicyclohexyl group, bicycloheptyl group, bicyclooctyl group, bicyclononyl group, and bicyclodecyl group.

The aryl group may be any of a phenyl group, a monovalent group derived by removing one hydrogen atom of a condensed ring aromatic hydrocarbon compound, and a monovalent group derived by removing one hydrogen atom of a ring-linked aromatic hydrocarbon compound, and the number of carbon atoms thereof is not particularly limited, but is preferably 40 or less, more preferably 30 or less, and still more preferably 20 or less.

Examples of the aryl group include an aryl group having 6 to 20 carbon atoms, and examples thereof include a phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 5-naphthacenyl group, 2-chrysenyl group, 1-pyrenyl group, 2-pyrenyl group, pentacenyl group, benzopyrenyl group, and triphenylenyl group, biphenyl-2-yl group (o-biphenylyl group), biphenyl-3-yl group (m-biphenylyl group), biphenyl-4-yl group (p-biphenylyl group), paraterphenyl-4-yl group, metaterphenyl-4-yl group, orthoterphenyl-4-yl group, 1,1'-binaphthyl-2-yl group, and 2,2'-binaphthyl-1-yl group, but are not limited thereto.

The aralkyl group is an alkyl group substituted with an aryl group, and specific examples of such an aryl group and an alkyl group include the same groups as those described above. The number of carbon atoms of the aralkyl group is not particularly limited, but is preferably 40 or less, more preferably 30 or less, and still more preferably 20 or less.

Specific examples of the aralkyl group include a phenylmethyl group (benzyl group), a 2-phenylethylene group, a 3-phenyl-n-propyl group, a 4-phenyl-n-butyl group, a 5-phenyl-n-pentyl group, a 6-phenyl-n-hexyl group, a 7-phenyl-n-heptyl group, an 8-phenyl-n-octyl group, a 9-phenyl-n-nonyl group, and a 10-phenyl-n-decyl group, but are not limited thereto.

The halogenated alkyl group, the halogenated aryl group, and the halogenated aralkyl group are respectively an alkyl group, an aryl group, and an aralkyl group substituted with one or more halogen atoms, and specific examples of such an alkyl group, an aryl group, and an aralkyl group include the same groups as those described above.

Examples of the halogen atom include a fluorine atom, a chlorine atom, a bromine atom, and an iodine atom.

The number of carbon atoms of the halogenated alkyl group is not particularly limited, but is preferably 40 or less, more preferably 30 or less, still more preferably 20 or less, and yet still more preferably 10 or less.

Specific examples of the halogenated alkyl group include a monofluoromethyl group, a difluoromethyl group, a trifluoromethyl group, a bromodifluoromethyl group, a 2-chloroethyl group, a 2-bromoethyl group, a 1,1-difluoroethyl group, a 2,2,2-trifluoroethyl group, a 1,1,2,2-tetrafluoroethyl group, a 2-chloro-1,1,2-trifluoroethyl group, a pentafluoroethyl group, a 3-bromopropyl group, a 2,2,3,3-tetrafluoropropyl group, a 1,1,2,3,3,3-hexafluoropropyl group, a 1,1,1,3,3,3-hexafluoropropane-2-yl group, a 3-bromo-2-methylpropyl group, a 4-bromobutyl group, and a perfluoropentyl group, but are not limited thereto.

The number of carbon atoms of the halogenated aryl group is not particularly limited, but is preferably 40 or less, more preferably 30 or less, and still more preferably 20 or less.

Specific examples of the halogenated aryl group include a 2-fluorophenyl group, a 3-fluorophenyl group, a 4-fluorophenyl group, a 2,3-difluorophenyl group, a 2,4-difluorophenyl group, a 2,5-difluorophenyl group, a 2,6-difluorophenyl group, a 3,4-difluorophenyl group, a 3,5-difluorophenyl group, a 2,3,4-trifluorophenyl group, a 2,3,5-trifluorophenyl group, a 2,3,6-trifluorophenyl group, a 2,4,5-trifluorophenyl group, a 2,4,6-trifluorophenyl group, a 3,4,5-trifluorophenyl group, a 2,3,4,5-tetrafluorophenyl group, a 2,3,4,6-tetrafluorophenyl group, a 2,3,5,6-tetrafluorophenyl group, a pentafluorophenyl group, a 2-fluoro-1-naphthyl group, a 3-fluoro-1-naphthyl group, a 4-fluoro-1-naphthyl group, a 6-fluoro-1-naphthyl group, a 7-fluoro-1-naphthyl group, an 8-fluoro-1-naphthyl group, a 4,5-difluoro-1-naphthyl group, a 5,7-difluoro-1-naphthyl group, a 5,8-difluoro-1-naphthyl group, a 5,6,7,8-tetrafluoro-1-naphthyl group, a heptafluoro-1-naphthyl group, a 1-fluoro-2-naphthyl group, a 5-fluoro-2-naphthyl group, a 6-fluoro-2-naphthyl group, a 7-fluoro-2-naphthyl group, a 5,7-difluoro-2-naphthyl group, and a heptafluoro-2-naphthyl group, and groups obtained as fluorine atoms (fluoro groups) of the groups are optionally substituted with chlorine atoms (chloro groups), bromine atoms (bromo groups), and iodine atoms (iodine groups), but are not limited thereto.

The number of carbon atoms of the halogenated aralkyl group is not particularly limited, but is preferably 40 or less, more preferably 30 or less, and still more preferably 20 or less.

Specific examples of the halogenated aralkyl group include a 2-fluorobenzyl group, a 3-fluorobenzyl group, a 4-fluorobenzyl group, a 2,3-difluorobenzyl group, a 2,4-difluorobenzyl group, a 2,5-difluorobenzyl group, a 2,6-difluorobenzyl group, a 3,4-difluorobenzyl group, a 3,5-difluorobenzyl group, a 2,3,4-trifluorobenzyl group, a 2,3,5-trifluorobenzyl group, a 2,3,6-trifluorobenzyl group, a 2,4,5-trifluorobenzyl group, a 2,4,6-trifluorobenzyl group, a 2,3,4,5-tetrafluorobenzyl group, a 2,3,4,6-tetrafluorobenzyl group, a 2,3,5,6-tetrafluorobenzyl group, a 2,3,4,5,6-pentafluorobenzyl group, and groups obtained as fluorine atoms (fluoro groups) of the groups are optionally substituted with chlorine atoms (chloro groups), bromine atoms (bromo groups), and iodine atoms (iodine groups), but are not limited thereto.

The alkoxyalkyl group, the alkoxyaryl group, and the alkoxyaralkyl group are respectively an alkyl group, an aryl group, and an aralkyl group substituted with one or more alkoxy groups, and specific examples of such an alkyl group, an aryl group, and an aralkyl group include the same groups as those described above.

The alkoxy group as the substituent is, for example, an alkoxy group having at least any one of linear, branched, and cyclic alkyl moieties having 1 to 20 carbon atoms.

Examples of the linear or branched alkoxy group include a methoxy group, ethoxy group, n-propoxy group, i-propoxy group, n-butoxy group, i-butoxy group, s-butoxy group, t-butoxy group, n-pentyloxy group, 1-methyl-n-butoxy group, 2-methyl-n-butoxy group, 3-methyl-n-butoxy group, 1,1-dimethyl-n-propoxy group, 1,2-dimethyl-n-propoxy group, 2,2-dimethyl-n-propoxy group, 1-ethyl-n-propoxy group, n-hexyloxy group, 1-methyl-n-pentyloxy group, 2-methyl-n-pentyloxy group, 3-methyl-n-pentyloxy group, 4-methyl-n-pentyloxy group, 1,1-dimethyl-n-butoxy group, 1,2-dimethyl-n-butoxy group, 1,3-dimethyl-n-butoxy group, 2,2-dimethyl-n-butoxy group, 2,3-dimethyl-n-butoxy group, 3,3-dimethyl-n-butoxy group, 1-ethyl-n-butoxy group, 2-ethyl-n-butoxy group, 1,1,2-trimethyl-n-propoxy group, 1,2,2-trimethyl-n-propoxy group, 1-ethyl-1-methyl-n-propoxy group, and 1-ethyl-2-methyl-n-propoxy group.

Examples of the cyclic alkoxy group include a cyclopropoxy group, cyclobutoxy group, 1-methyl-cyclopropoxy group, 2-methyl-cyclopropoxy group, cyclopentyloxy group, 1-methyl-cyclobutoxy group, 2-methyl-cyclobutoxy group, 3-methyl-cyclobutoxy group, 1,2-dimethyl-cyclopropoxy group, 2,3-dimethyl-cyclopropoxy group, 1-ethyl-cyclopropoxy group, 2-ethyl-cyclopropoxy group, cyclohexyloxy group, 1-methyl-cyclopentyloxy group, 2-methyl-cyclopentyloxy group, 3-methyl-cyclopentyloxy group, 1-ethyl-cyclobutoxy group, 2-ethyl-cyclobutoxy group, 3-ethyl-cyclobutoxy group, 1,2-dimethyl-cyclobutoxy group, 1,3-dimethyl-cyclobutoxy group, 2,2-dimethyl-cyclobutoxy group, 2,3-dimethyl-cyclobutoxy group, 2,4-dimethyl-cyclobutoxy group, 3,3-dimethyl-cyclobutoxy group, 1-n-propyl-cyclopropoxy group, 2-n-propyl-cyclopropoxy group, 1-i-propyl-cyclopropoxy group, 2-i-propyl-cyclopropoxy group, 1,2,2-trimethyl-cyclopropoxy group, 1,2,3-trimethyl-cyclopropoxy group, 2,2,3-trimethyl-cyclopropoxy group, 1-ethyl-2-methyl-cyclopropoxy group, 2-ethyl-1-methyl-cyclopropoxy group, 2-ethyl-2-methyl-cyclopropoxy group, and 2-ethyl-3-methyl-cyclopropoxy group.

Specific examples of the alkoxyalkyl group include a lower (about 5 or less carbon atoms) alkyloxy-lower (about 5 or less carbon atoms) alkyl group such as a methoxymethyl group, an ethoxymethyl group, a 1-ethoxyethyl group, a 2-ethoxyethyl group, and an ethoxymethyl group, but are not limited thereto.

Specific examples of the alkoxyaryl group include a 2-methoxyphenyl group, a 3-methoxyphenyl group, a 4-methoxyphenyl group, a 2-(1-ethoxy) phenyl group, a 3-(1-ethoxy) phenyl group, a 4-(1-ethoxy) phenyl group, a 2-(2-ethoxy) phenyl group, a 3-(2-ethoxy) phenyl group, a 4-(2-ethoxy) phenyl group, a 2-methoxynaphthalene-1-yl group, a 3-methoxynaphthalene-1-yl group, a 4-methoxynaphthalene-1-yl group, a 5-methoxynaphthalene-1-yl group, a 6-methoxynaphthalene-1-yl group, and a 7-methoxynaphthalene-1-yl group, but are not limited thereto.

Specific examples of the alkoxyaralkyl group include a 3-(methoxyphenyl) benzyl group and a 4-(methoxyphenyl) benzyl group, but are not limited thereto.

Examples of the substituent in the alkyl group, the aryl group, the aralkyl group, the halogenated alkyl group, the halogenated aryl group, the halogenated aralkyl group, and the alkoxyalkyl group, and the alkoxyaryl group, and the alkoxyaralkyl group described above include an alkyl group, an aryl group, an aralkyl group, a halogenated alkyl group, a halogenated aryl group, a halogenated aralkyl group, an alkoxyalkyl group, an aryloxy group, an alkoxyaryl group, an alkoxyaralkyl group, an alkoxy group, and an aralkyloxy group, and specific examples thereof and suitable carbon atom numbers thereof include those same as those described above or below.

The aryloxy group as described in the substituent is a group in which an aryl group is bonded via an oxygen atom (-O-), and specific examples of the aryl group are the same as those described above. The number of carbon atoms of the aryloxy group is not particularly limited, but is preferably 40 or less, more preferably 30 or less, and still more preferably 20 or less, and specific examples thereof include a phenoxy group and a naphthalene-2-yloxy group, but are not limited thereto.

When two or more substituents are present, the substituents may be bonded together to form a ring.

Examples of the organic group having an epoxy group include glycidoxymethyl group, glycidoxyethyl group, glycidoxypropyl group, glycidoxybutyl group, and epoxy cyclohexyl group.

Examples of the organic group having a mercapto group include mercaptoethyl group, mercaptobutyl group, mercaptohexyl group, and mercaptooctyl group.

Examples of the organic group having an amino group include, but are not limited to, amino group, aminomethyl group, aminoethyl group, dimethylaminoethyl group, and dimethylaminopropyl group. The organic group having an amino group will be described later in more detail.

Examples of the organic group having an alkoxy group include, but are not limited to, a methoxymethyl group and a methoxyethyl group. However, the organic group excludes a group wherein an alkoxy group is directly bonded to a silicon atom.

Examples of the organic group having a sulfonyl group include, but are not limited to, sulfonylalkyl group.

Examples of the organic group having a cyano group include cyanoethyl group, cyanopropyl group, and thiocyanate group.

The organic group having an amino group is, for example, an organic group having at least one of a primary amino group, a secondary amino group, or a tertiary amino group. A hydrolysis condensate in which a hydrolyzable silane having a tertiary amino group is hydrolyzed with a strong acid to form a counter cation having a tertiary ammonium group can be preferably used. The organic group may contain a heteroatom such as an oxygen atom or a sulfur atom, in addition to the nitrogen atom forming the amino group.

A preferable example of the organic group having an amino group is a group represented by the following Formula (A1).

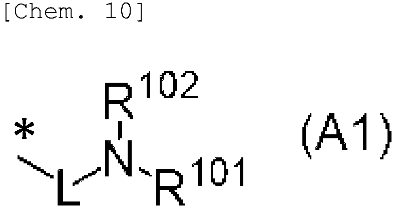

In the Formula (A1), R¹⁰¹ and R¹⁰² each independently represent a hydrogen atom or a hydrocarbon group, and L represents an independently and optionally substituted alkylene group. An asterisk * represents a bonding hand.

Examples of the hydrocarbon group include, but are not limited to, alkyl group and alkenyl group. Specific examples of the alkyl group and the alkenyl group are the same as those described above regarding R².

The alkylene group may be linear or branched, and the carbon atom number of the linear or branched alkylene group is ordinarily 1 to 10, preferably 1 to 5. Examples of the linear or branched alkylene group include linear alkylene groups such as methylene group, ethylene group, trimethylene group, tetramethylene group, pentamethylene group, hexamethylene group, heptamethylene group, octamethylene group, nonamethylene group, and decamethylene group.

Examples of the organic group having an amino group include, but are not limited to, amino group, aminomethyl group, aminoethyl group, dimethylaminoethyl group, and dimethylaminopropyl group.

### <<X in Formula (A-1)>>

Examples of the alkoxy group in X include the alkoxy group exemplified in the description of R³.

Examples of the halogen atom in X include the halogen atom exemplified in the description of R³.

The aralkyloxy group is a monovalent group derived by removing a hydrogen atom from a hydroxy group of aralkyl alcohol, and specific examples of the aralkyl group in the aralkyloxy group are the same as those described above.

The carbon atom number of the aralkyloxy group is not particularly limited, but may be, for example, 40 or less, preferably 30 or less, and more preferably 20 or less.

Specific examples of the aralkyloxy group include, but are not limited to, phenylmethyloxy group (benzyloxy group), 2-phenylethyleneoxy group, 3-phenyl-n-propyloxy group, 4-phenyl-n-butyloxy group, 5-phenyl-n-pentyloxy group, 6-phenyl n-hexyloxy group, 7-phenyl-n-heptyloxy group, 8-phenyl-n-octyloxy group, 9-phenyl-n-nonyloxy group, and 10-phenyl-n-decyloxy group.

The acyloxy group is a monovalent group derived by removing a hydrogen atom from a carboxyl group (-COOH) of a carboxylic acid compound, and examples of the acyloxy group typically include, but are not limited to, an alkylcarbonyloxy group, an arylcarbonyloxy group, or an aralkylcarbonyloxy group, derived by removing a hydrogen atom from a carboxyl group of an alkyl carboxylic acid, an aryl carboxylic acid, or an aralkyl carboxylic acid. Specific examples of the alkyl group, the aryl group, and the aralkyl group in the alkyl carboxylic acid, the aryl carboxylic acid, and the aralkyl carboxylic acid include the same groups as those described above.

Specific examples of the acyloxy group include an acyloxy group having 2 to 20 carbon atoms, and examples thereof include a methylcarbonyloxy group, an ethylcarbonyloxy group, a n-propylcarbonyloxy group, an i-propylcarbonyloxy group, a n-butylcarbonyloxy group, an i-butylcarbonyloxy group, an s-butylcarbonyloxy group, a t-butylcarbonyloxy group, a n-pentylcarbonyloxy group, a 1-methyl-n-butylcarbonyloxy group, a 2-methyl-n-butylcarbonyloxy group, a 3-methyl-n-butylcarbonyloxy group, a 1,1-dimethyl-n-propylcarbonyloxy group, a 1,2-dimethyl-n-propylcarbonyloxy group, a 2,2-dimethyl-n-propylcarbonyloxy group, a 1-ethyl-n-propylcarbonyloxy group, a n-hexylcarbonyloxy group, a 1-methyl-n-pentylcarbonyloxy group, a 2-methyl-n-pentylcarbonyloxy group, a 3-methyl-n-pentylcarbonyloxy group, a 4-methyl-n-pentylcarbonyloxy group, a 1,1-dimethyl-n-butylcarbonyloxy group, a 1,2-dimethyl-n-butylcarbonyloxy group, a 1,3-dimethyl-n-butylcarbonyloxy group, a 2,2-dimethyl-n-butylcarbonyloxy group, a 2,3-dimethyl-n-butylcarbonyloxy group, a 3,3-dimethyl-n-butylcarbonyloxy group, a 1-ethyl-n-butylcarbonyloxy group, a 2-ethyl-n-butylcarbonyloxy group, a 1,1,2-trimethyl-n-propylcarbonyloxy group, a 1,2,2-trimethyl-n-propylcarbonyloxy group, a 1-ethyl-1-methyl-n-propylcarbonyloxy group, a 1-ethyl-2-methyl-n-propylcarbonyloxy group, a phenylcarbonyloxy group, and a tosylcarbonyloxy group.

Specific examples of the hydrolyzable silane (A) represented by the Formula (A-1) include the following compounds, but the hydrolyzable silane (A) represented by the Formula (A-1) is not limited to these compounds.

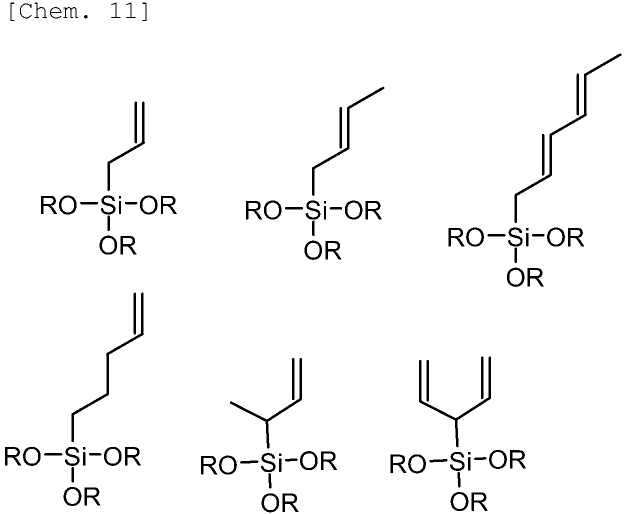

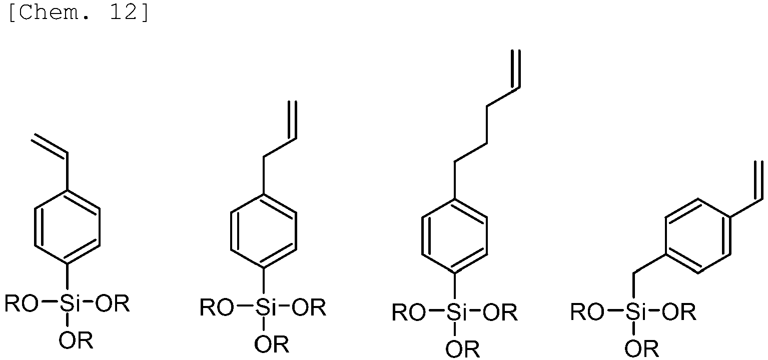

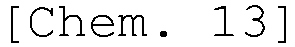

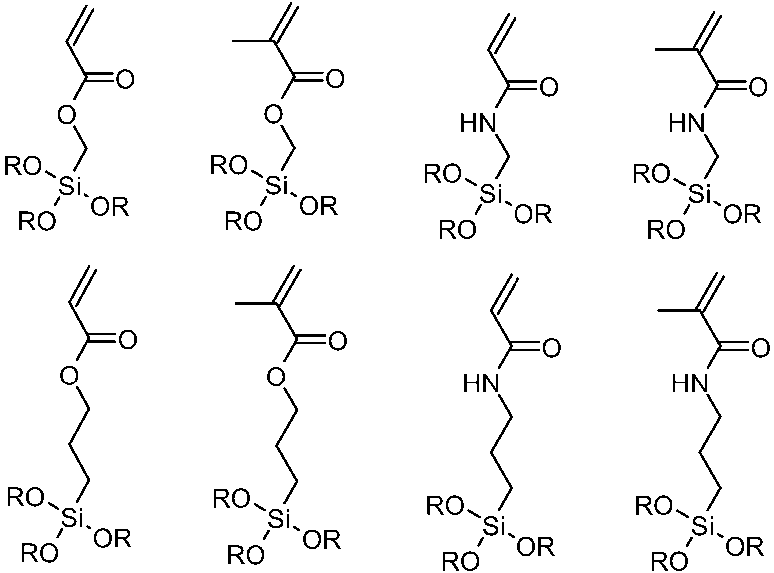

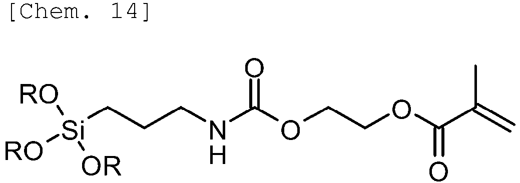

In the Formula, OR represents, for example, a methoxy group or an ethoxy group.

In the present invention, the following hydrolyzable silane may be used in place of the hydrolyzable silane (A) represented by the Formula (A-1).

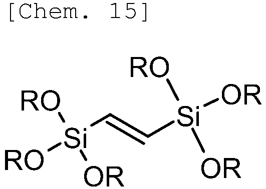

In the Formula, OR represents, for example, a methoxy group or an ethoxy group.

In the first embodiment, the amount of the hydrolyzable silane (A) in synthesizing the polysiloxane containing the constituent unit derived from the hydrolyzable silane (A) represented by the Formula (A-1) [A] is preferably 0.01 to 100 parts by mass, more preferably 0.05 to 50 parts by mass, still more preferably 0.1 to 30 parts by mass, and particularly preferably 1 to 20 parts by mass, relative to 100 parts by mass of the total amount of the hydrolyzable silane used for synthesizing the polysiloxane, from the viewpoint of more sufficiently achieving the effects of the present invention.

In the second embodiment, the content of the hydrolyzable silane (A) represented by the Formula (A-1) as the component [B] in the silicon-containing resist underlayer film-forming composition is preferably 0.01 to 100 parts by mass, more preferably 0.05 to 50 parts by mass, still more preferably 0.1 to 30 parts by mass, and particularly preferably 1 to 20 parts by mass, relative to 100 parts by mass of polysiloxane [A'], from the viewpoint of more sufficiently achieving the effects of the present invention.

### <Component [A] and component [A']: polysiloxane>

The polysiloxane as the component [A] is not particularly limited as long as it contains the constituent unit derived from the hydrolyzable silane (A) represented by the Formula (A-1) and is a polymer having a siloxane bond.

The polysiloxane as the component [A'] is not particularly limited as long as it is a polymer having a siloxane bond. The polysiloxane as the component [A'] may be a polysiloxane as the component [A].

The polysiloxane may be a modified polysiloxane in which a part of silanol groups is modified, for example, a polysiloxane modified product in which a part of silanol groups is alcohol-modified or acetal-protected.

In addition, the polysiloxane may be, as an example, a hydrolysis condensate of a hydrolyzable silane, or may be a modified product in which at least a part of silanol groups of the hydrolysis condensate is alcohol-modified or acetal-protected (hereinafter, sometimes referred to as a "modified product of a hydrolysis condensate"). The hydrolyzable silane corresponding to the hydrolysis condensate may contain one or two or more hydrolyzable silanes.

In addition, the polysiloxane as the component [A] or component [A'] can have a structure having any of a cage type, a ladder type, a linear type, and a branched type main chain. Further, as the polysiloxane as component [A'], a commercially available polysiloxane can be used.

Note that, in the present invention, the "hydrolysis condensate" of the hydrolyzable silane, that is, the product of the hydrolysis condensation includes not only a polyorganosiloxane polymer that is a condensate in which the condensation is completely completed but also a polyorganosiloxane polymer that is a partial hydrolysis condensate in which the condensation is not completely completed. Such a partial hydrolysis condensate is a polymer prepared through hydrolysis and condensation of a hydrolyzable silane compound, as in the case of a condensate prepared through complete condensation. However, the partial hydrolysis condensate contains remaining Si-OH groups, due to partial or incomplete hydrolysis and condensation of the silane compound. Further, the silicon-containing resist underlayer film-forming composition may contain an uncondensed hydrolysate (complete hydrolysate or partial hydrolysate) or a remaining monomer (hydrolyzable silane), in addition to the hydrolysis condensate.

Note that, in the present specification, the "hydrolyzable silane" may also be simply referred to as a "silane compound".

The polysiloxane as the component [A] does not have, for example, an alkyl iodide group.

The polysiloxane as the component [A'] does not have, for example, an alkyl iodide group.

The polysiloxane as the component [A] may be, for example, a hydrolysis condensate of a hydrolyzable silane containing the hydrolyzable silane (A) represented by the Formula (A-1) or a modified product of the hydrolysis condensate.

The polysiloxane as the component [A] may be, for example, a hydrolysis condensate of a hydrolyzable silane containing the hydrolyzable silane (A) represented by the Formula (A-1) and at least one hydrolyzable silane represented by the following Formula (1) or a modified product of the hydrolysis condensate.

Examples of the polysiloxane as the component [A'] include a hydrolysis condensate of a hydrolyzable silane containing at least one hydrolyzable silane represented by the Formula (1) described below, or a modified product thereof.

### <<Formula (1)>>

[Chem. 16]

R¹ₐSi(R²)₄₋ₐ (1)

In the Formula (1), R¹ is a group bonded to a silicon atom, and each independently represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, or an optionally substituted alkenyl group, or an organic group having an epoxy group, an organic group having a mercapto group, an organic group having an amino group, an organic group having an alkoxy group, an organic group having a sulfonyl group, or an organic group having a cyano group, or a combination of two or more thereof.

R² is a group or atom bonded to a silicon atom, and each independently represents an alkoxy group, an aralkyloxy group, an acyloxy group, or a halogen atom.
a represents an integer of 0 to 3.
a represents, for example, 1.

Specific examples of the groups and atoms of R¹ in the Formula (1) and preferred carbon atom numbers thereof are the same as the groups and carbon atoms described above regarding R³ in the Formula (A-1).

Specific examples of each group and atom in R² in the Formula (1) and the suitable number of carbon atoms thereof may include the groups, atoms, and the number of carbon atoms described above for X in the Formula (A-1).

R¹ is not a hydrolyzable group.

### <<<Specific Example of Hydrolyzable Silane Represented by Formula (1)>>>

Specific examples of the hydrolyzable silane represented by the Formula (1) include tetramethoxysilane, tetrachlorosilane, tetraacetoxysilane, tetraethoxysilane, tetra-n-propoxysilane, tetra-i-propoxysilane, tetra-n-butoxysilane, methyltrimethoxysilane, methyltrichlorosilane, methyltriacetoxysilane, methyltriethoxysilane, methyltripropoxysilane, methyltributoxysilane, methyltriamyloxysilane, methyltriphenoxysilane, methyltribenzyloxysilane, methyltriphenethyloxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltrimethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylethyldimethoxysilane, α-glycidoxypropylmethyldimethoxysilane, α-glycidoxypropylmethyldiethoxysilane, β-glycidoxypropylmethyldimethoxysilane, β-glycidoxypropylethyldimethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldiphenoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, ethyltrimethoxysilane, ethyltriethoxysilane, vinyltrimethoxysilane, vinyltriethoxysilane, vinyltrichlorosilane, vinyltriacetoxysilane, methylvinyldimethoxysilane, methylvinyldiethoxysilane, methylvinyldichlorosilane, methylvinyldiacetoxysilane, dimethylvinylmethoxysilane, dimethylvinylethoxysilane, dimethylvinylchlorosilane, dimethylvinylacetoxysilane, divinyldimethoxysilane, divinyldiethoxysilane, divinyldichlorosilane, divinyldiacetoxysilane, γ-glycidoxypropylvinyldimethoxysilane, γ-glycidoxypropylvinyldiethoxysilane, p-styryltrimethoxysilane, phenyltrimethoxysilane, phenyltriethoxysilane, phenyltrichlorosilane, phenyltriacetoxysilane, phenylmethyldimethoxysilane, phenylmethyldiethoxysilane, phenylmethyldichlorosilane, phenylmethyldiacetoxysilane, phenyldimethylmethoxysilane, phenyldimethylethoxysilane, phenyldimethylchlorosilane, phenyldimethylacetoxysilane, diphenylmethylmethoxysilane, diphenylmethylethoxysilane, diphenylmethylchlorosilane, diphenylmethylacetoxysilane, diphenyldimethoxysilane, diphenyldiethoxysilane, diphenyldichlorosilane, diphenyldiacetoxysilane, triphenylmethoxysilane, triphenylethoxysilane, triphenylacetoxysilane, triphenylchlorosilane, 3-phenylaminopropyltrimethoxysilane, 3-phenylaminopropyltriethoxysilane, dimethoxymethyl-3-(3-phenoxypropylthiopropyl)silane, triethoxy((2-methoxy-4-(methoxymethyl)phenoxy)methyl) silane, benzyltrimethoxysilane, benzyltriethoxysilane, benzylmethyldimethoxysilane, benzylmethyldiethoxysilane, benzyldimethylmethoxysilane, benzyldimethylethoxysilane, benzyldimethylchlorosilane, phenethyltrimethoxysilane, phenethyltriethoxysilane, phenethyltrichlorosilane, phenethyltriacetoxysilane, phenethylmethyldimethoxysilane, phenethylmethyldiethoxysilane, phenethylmethyldichlorosilane, phenethylmethyldiacetoxysilane, methoxyphenyltrimethoxysilane, methoxyphenyltriethoxysilane, methoxyphenyltriacetoxysilane, methoxyphenyltrichlorosilane, methoxybenzyltrimethoxysilane, methoxybenzyltriethoxysilane, methoxybenzyltriacetoxysilane, methoxybenzyltrichlorosilane, methoxyphenethyltrimethoxysilane, methoxyphenethyltriethoxysilane, methoxyphenethyltriacetoxysilane, methoxyphenethyltrichlorosilane, ethoxyphenyltrimethoxysilane, ethoxyphenyltriethoxysilane, ethoxyphenyltriacetoxysilane, ethoxyphenyltrichlorosilane, ethoxybenzyltrimethoxysilane, ethoxybenzyltriethoxysilane, ethoxybenzyltriacetoxysilane, ethoxybenzyltrichlorosilane, i-propoxyphenyltrimethoxysilane, i-propoxyphenyltriethoxysilane, i-propoxyphenyltriacetoxysilane, i-propoxyphenyltrichlorosilane, i-propoxybenzyltrimethoxysilane, i-propoxybenzyltriethoxysilane, i-propoxybenzyltriacetoxysilane, i-propoxybenzyltrichlorosilane, t-butoxyphenyltrimethoxysilane, t-butoxyphenyltriethoxysilane, t-butoxyphenyltriacetoxysilane, t-butoxyphenyltrichlorosilane, t-butoxybenzyltrimethoxysilane, t-butoxybenzyltriethoxysilane, t-butoxybenzyltriacetoxysilane, t-butoxybenzyltrichlorosilane, methoxynaphthyltrimethoxysilane, methoxynaphthyltriethoxysilane, methoxynaphthyltriacetoxysilane, methoxynaphthyltrichlorosilane, ethoxynaphthyltrimethoxysilane, ethoxynaphthyltriethoxysilane, ethoxynaphthyltriacetoxysilane, ethoxynaphthyltrichlorosilane, γ-chloropropyltrimethoxysilane, γ-chloropropyltriethoxysilane, γ-chloropropyltriacetoxysilane, 3,3,3-trifluoropropyltrimethoxysilane, γ-mercaptopropyltrimethoxysilane, γ-mercaptopropyltriethoxysilane, β-cyanoethyltriethoxysilane, thiocyanatepropyltriethoxysilane, chloromethyltrimethoxysilane, chloromethyltriethoxysilane, triethoxysilylpropyldiallylisocyanate ester, bicyclo[2,2,1]heptenyltriethoxysilane, benzenesulfonylpropyltriethoxysilane, benzenesulfonamidopropyltriethoxysilane, dimethylaminopropyltrimethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-mercaptopropylmethyldimethoxysilane, γ-mercaptomethyldiethoxysilane, methylvinyldimethoxysilane, methylvinyldiethoxysilane, and silanes represented by the following formulas, and are not limited thereto. 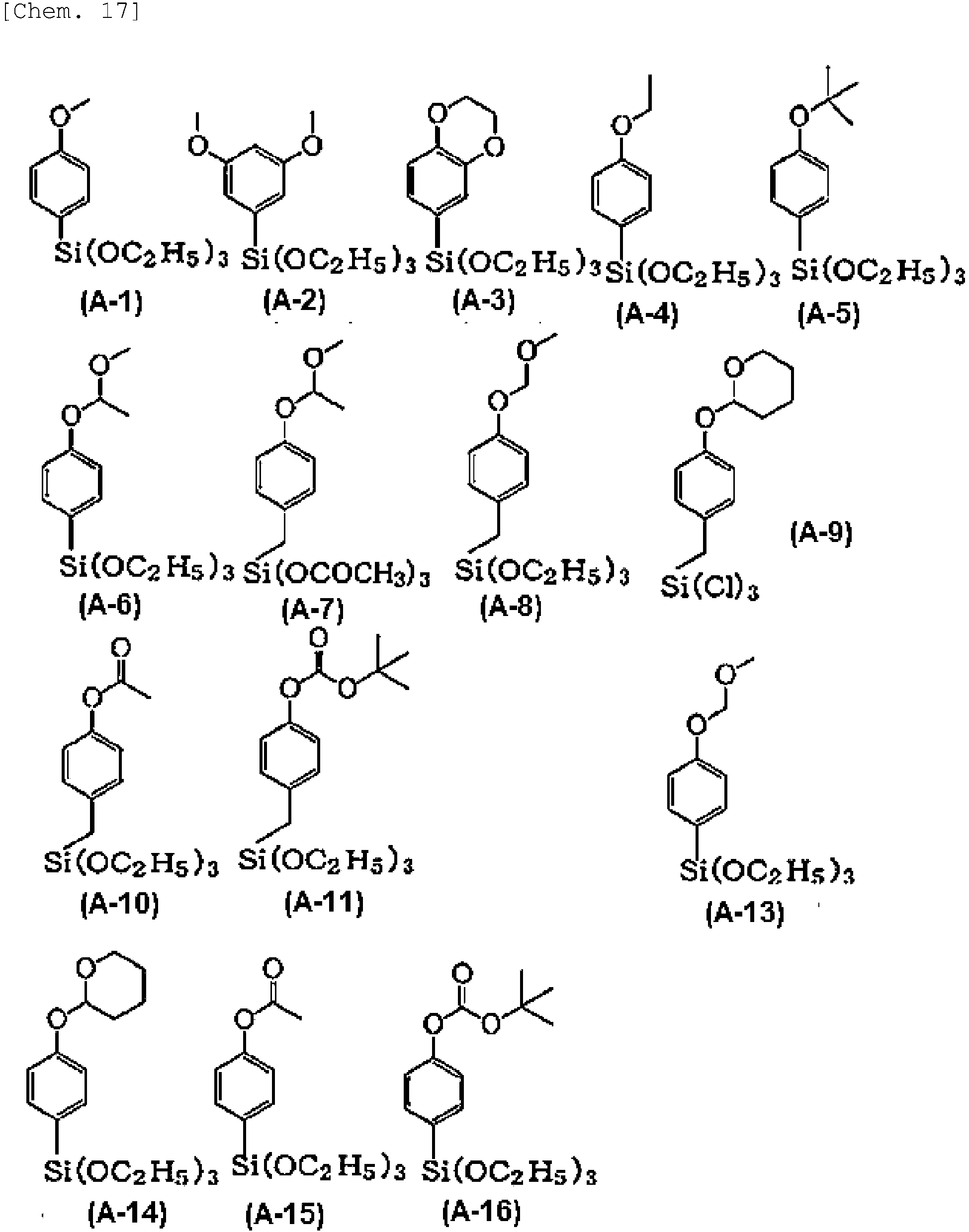 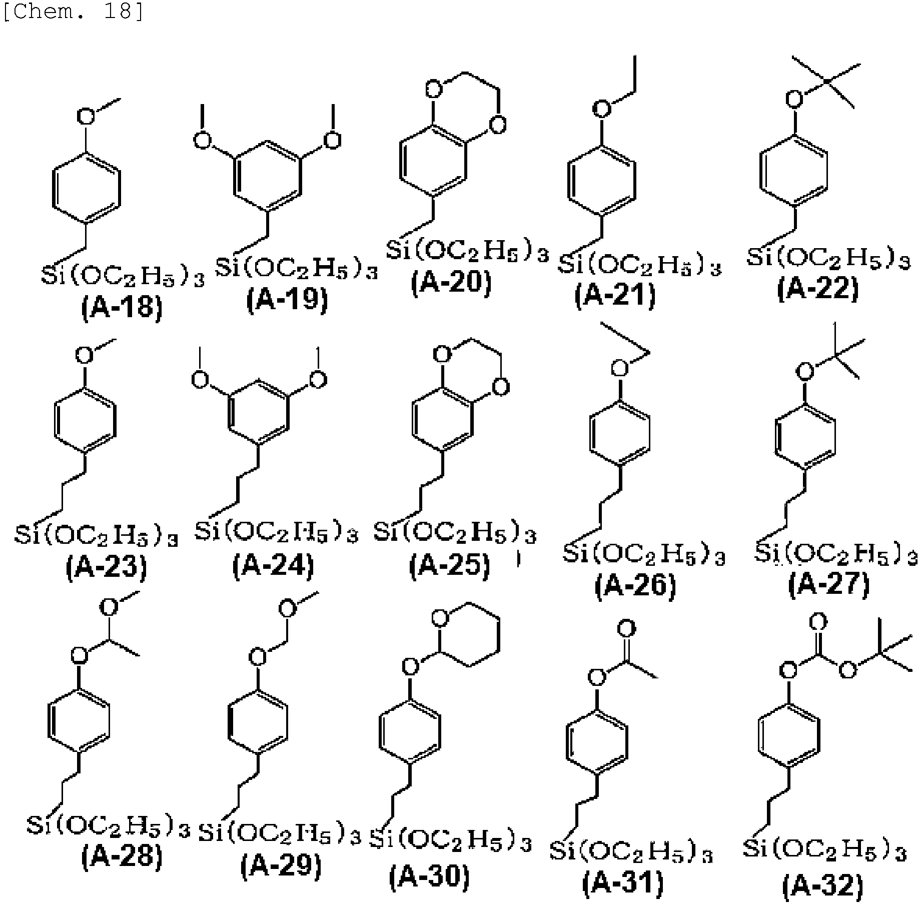 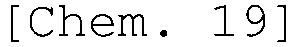 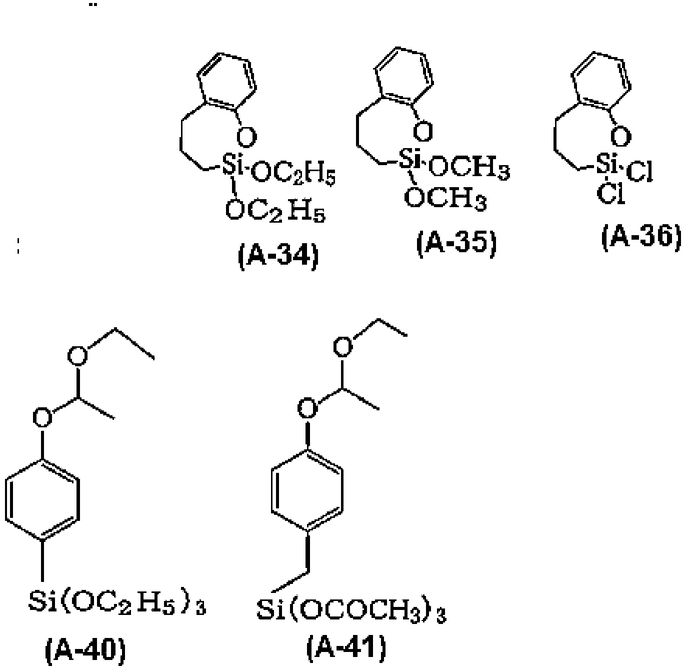 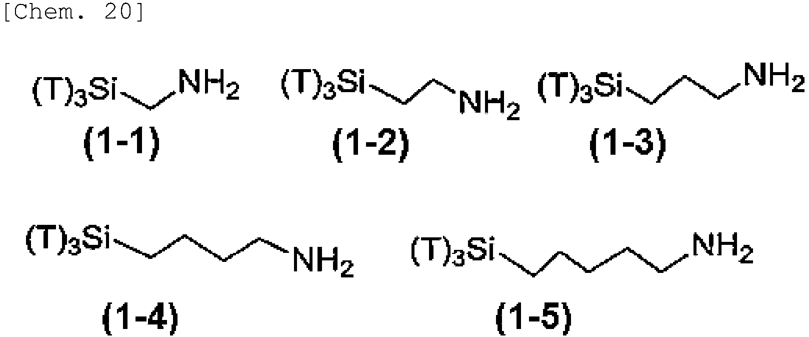 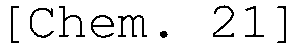 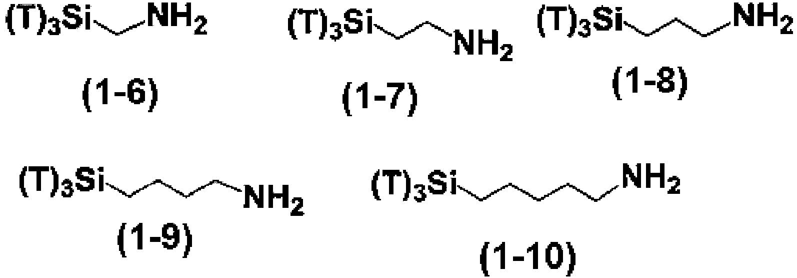 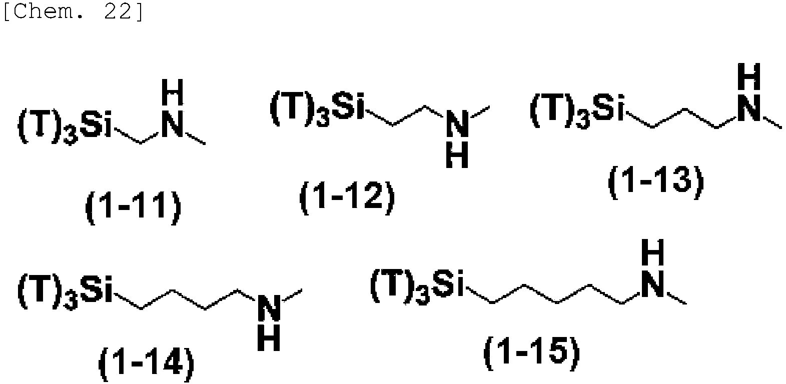 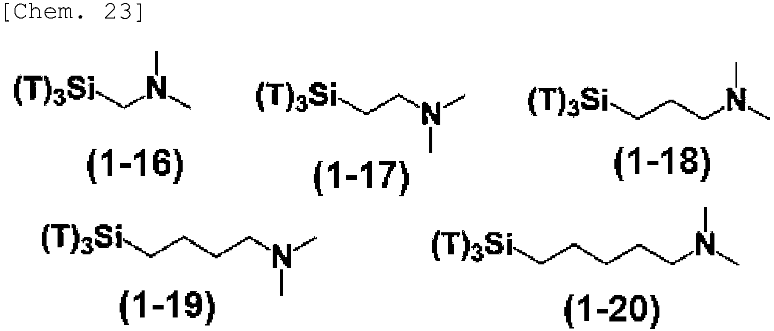 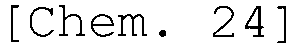 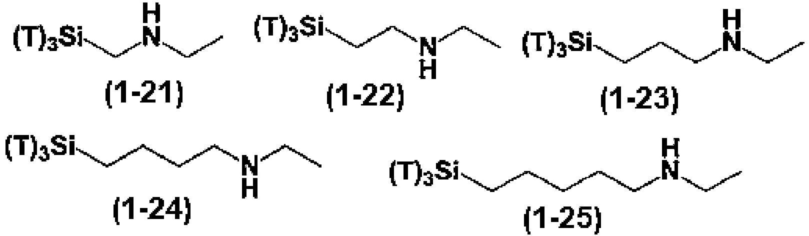 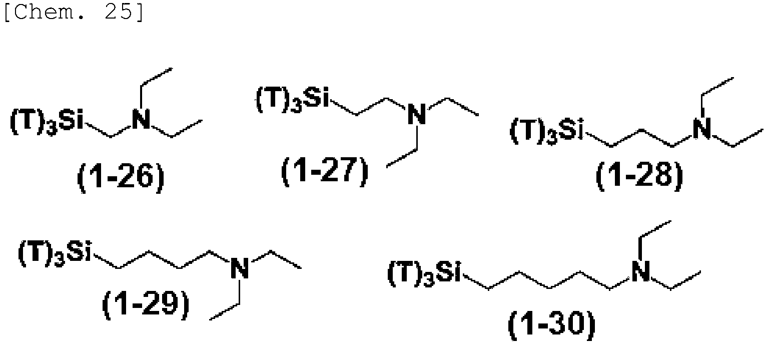 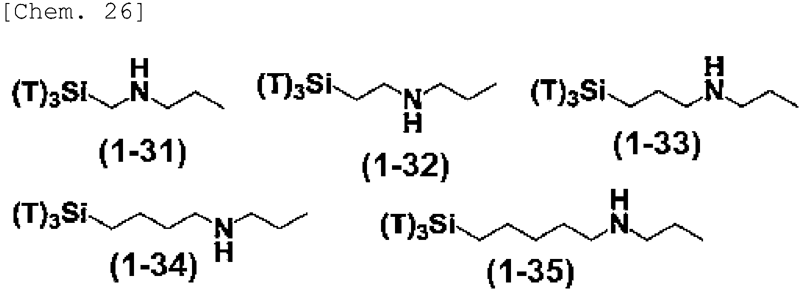 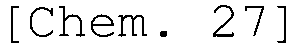 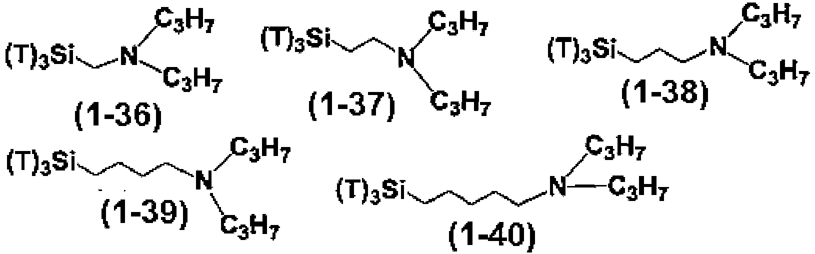 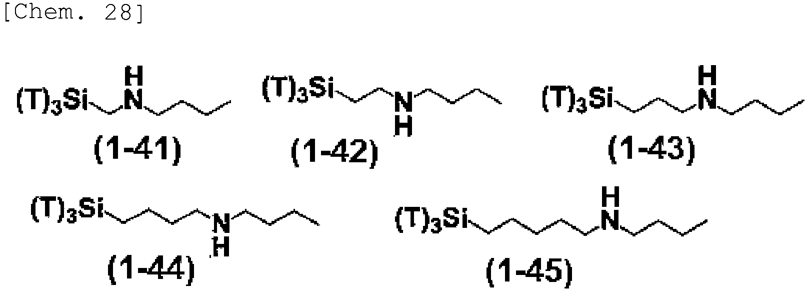 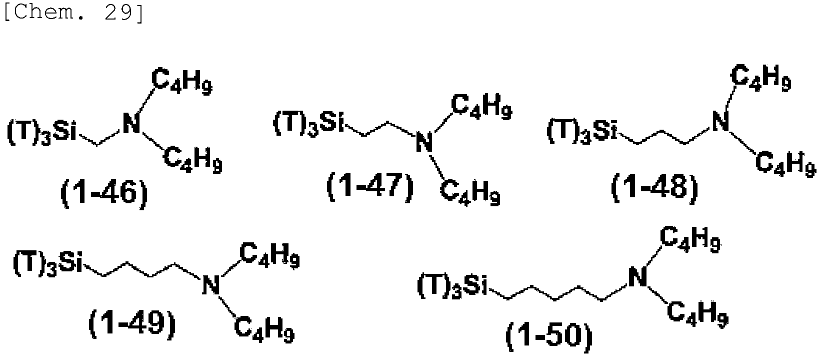 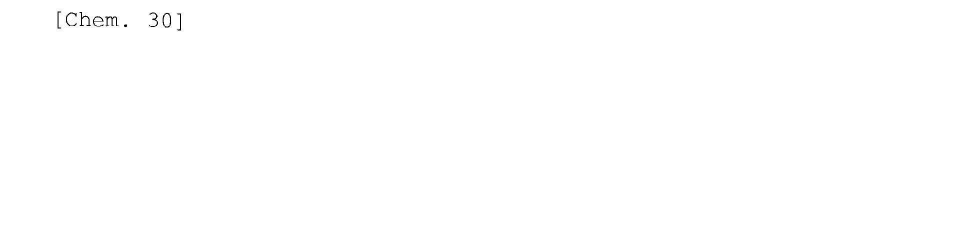 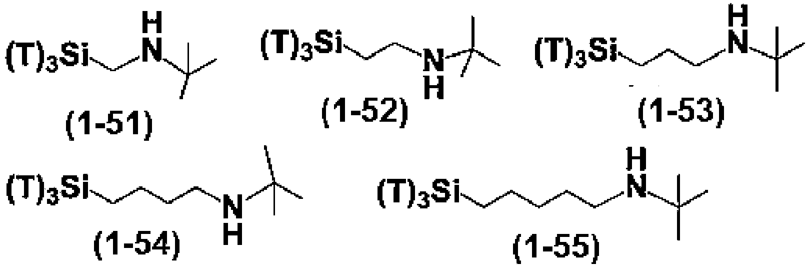 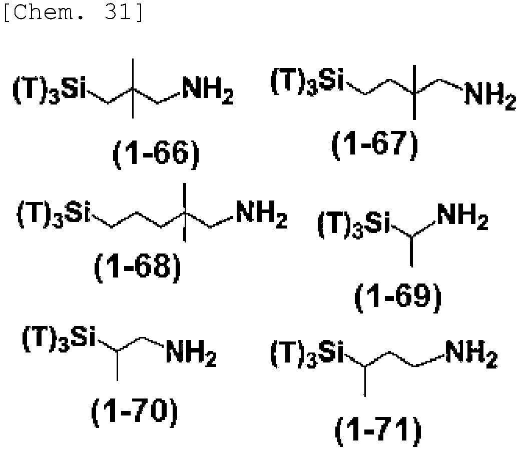 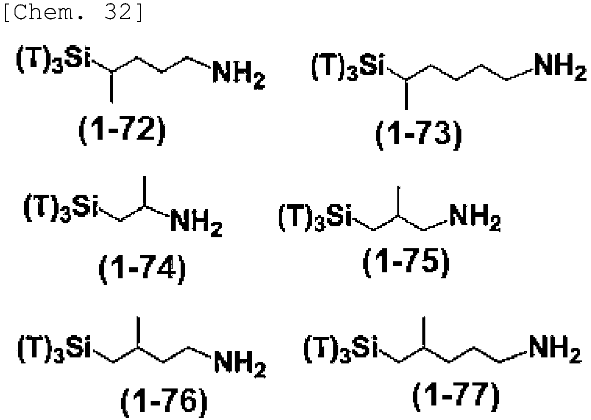 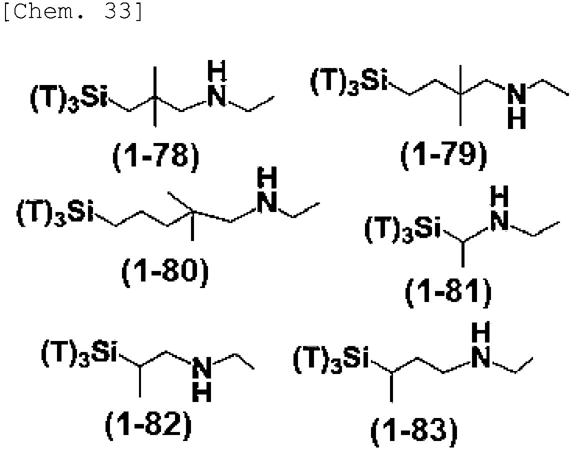 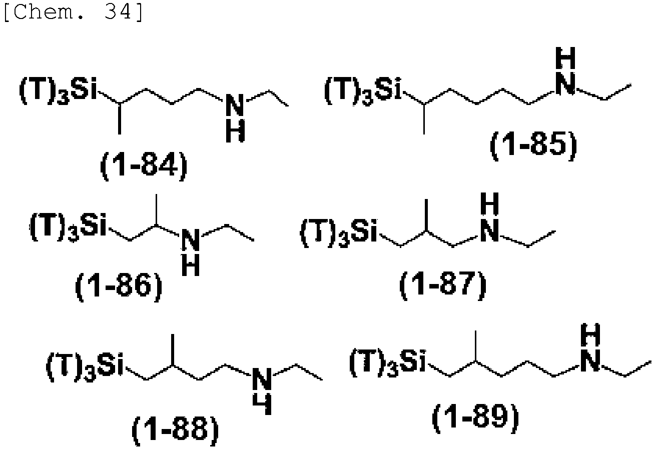 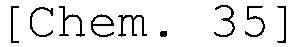 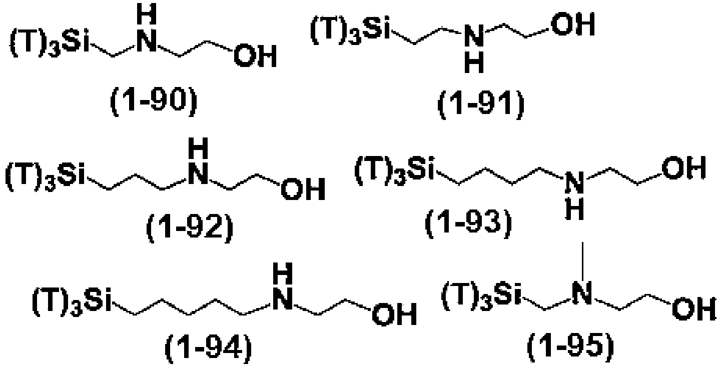 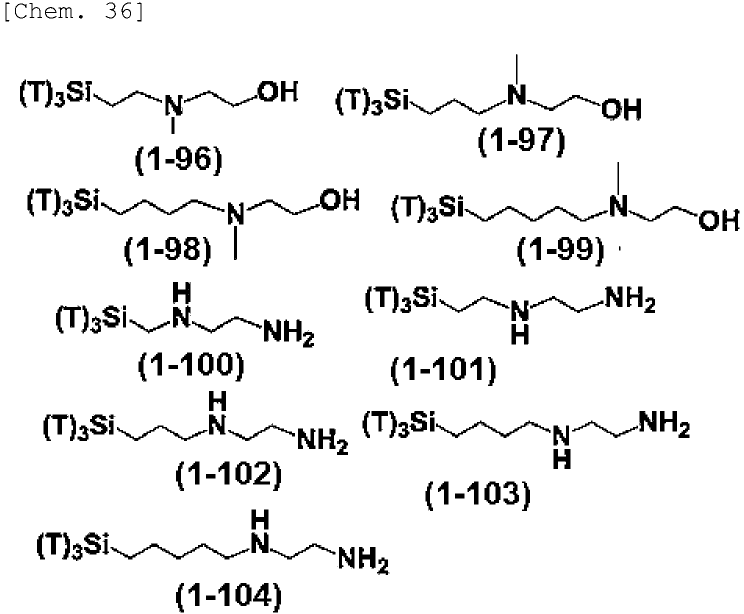 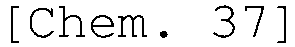 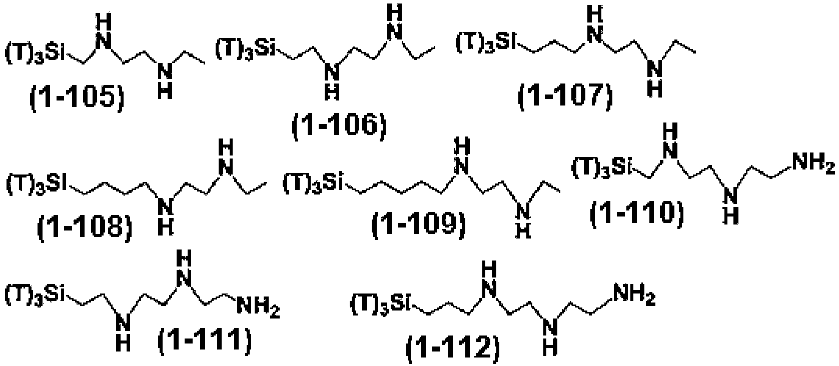 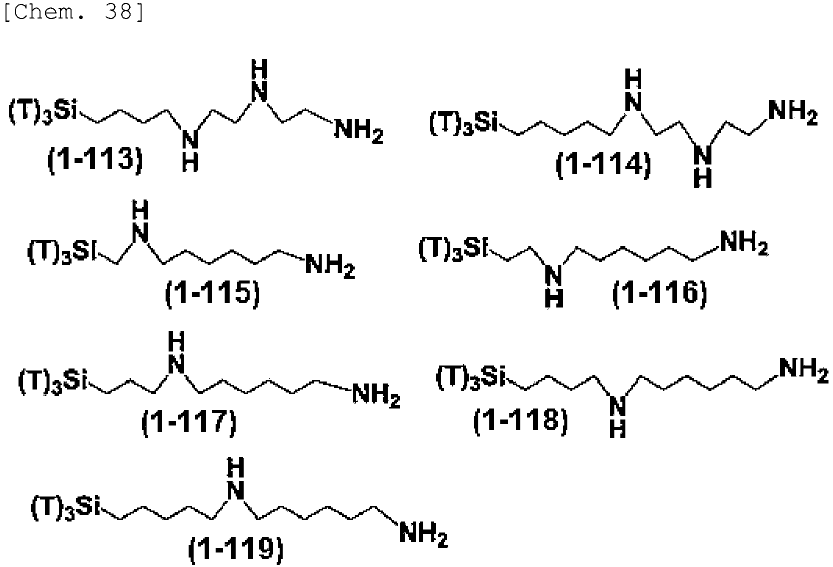 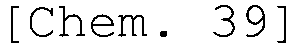 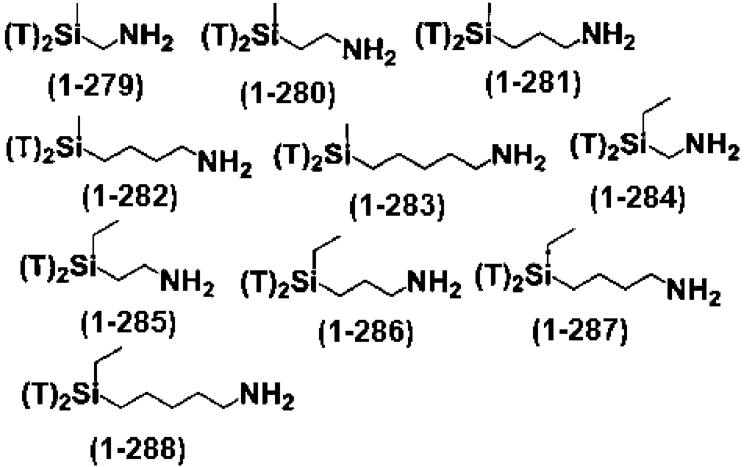 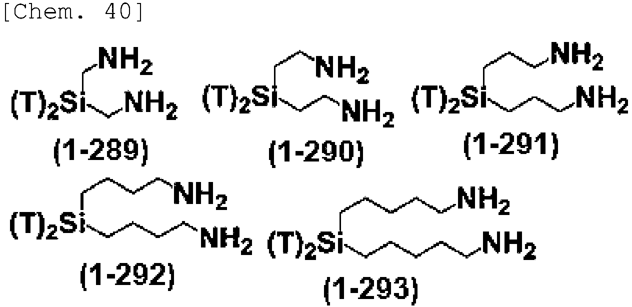 where Ts each independently represent an alkoxy group, an acyloxy group, or a halogen group, and represents preferably a methoxy group or an ethoxy group, for example.

When the component [A] contains the constituent unit derived from the hydrolyzable silane (1) represented by the Formula (1), it is preferable that b in the Formula (A-1) is 1 and c is 0, and the total molar ratio of the constituent unit (Aᵤₙᵢₜ) derived from the hydrolyzable silane (A) represented by the Formula (A-1) and the constituent unit (1ᵤₙᵢₜ) derived from the hydrolyzable silane (1) represented by the Formula (1) in the total T units in the component [A] is 5 mol% or more and 100 mol% or less.

Note that, in this case, a in the hydrolyzable silane (1) represented by the Formula (1) is 1.

The T unit means an organosiloxy unit represented by RSiO_{3/2}(R represents a hydrogen atom or an organic group,). That is, the T unit is a unit having one silicon atom and having one hydrogen atom or organic group bonded to the silicon atom and three oxygen atoms O* bonded to the silicon atom.

Note that the oxygen atom O* bonded to the silicon atom is an oxygen atom that bonds between two silicon atoms, and means an oxygen atom in a bond represented by Si-O-Si. Thus, there is one O* between the silicon atoms of the two organosiloxy units.

The polysiloxane [A] may be, for example, a hydrolysis condensate of a hydrolyzable silane containing the hydrolyzable silane (A) represented by the Formula (A-1) and a hydrolyzable silane represented by the following Formula (2) or a modified product of the hydrolysis condensate.

The polysiloxane [A] may be, for example, a hydrolysis condensate of a hydrolyzable silane containing the hydrolyzable silane (A) represented by the Formula (A-1), a hydrolyzable silane represented by the Formula (1), and a hydrolyzable silane represented by the following Formula (2), or a modified product of the hydrolysis condensate.

Examples of polysiloxane [A'] include a hydrolysis condensate of a hydrolyzable silane including the hydrolyzable silane represented by the Formula (2) described below together with the hydrolyzable silane represented by the Formula (1) or in place of the hydrolyzable silane represented by the Formula (1), or a modified product thereof.

### <Formula (2)>

[Chem. 41]

[R³_{b}Si(R⁴)_{3-b}]₂R⁵_{c} (2)

In the Formula (2), R³ is a group bonded to a silicon atom, and each independently represents an optionally substituted alkyl group, an optionally substituted halogenated alkyl group, an optionally substituted alkoxyalkyl group, or an optionally substituted alkenyl group, or represents an organic group having an epoxy group, an organic group having a mercapto group, an organic group having an amino group, an organic group having an alkoxy group, an organic group having a sulfonyl group, or an organic group having a cyano group, or a combination of two or more thereof.

R⁴ is a group or atom bonded to a silicon atom, and each independently represents an alkoxy group, an aralkyloxy group, an acyloxy group, or a halogen atom.

R⁵ is a group bonded to a silicon atom, and each independently represents an alkylene group or an arylene group.

b represents 0 or 1, and c represents 0 or 1.

Specific examples of each group and atom in R³ and the suitable number of carbon atoms thereof may include the groups and the number of carbon atoms described above for R³ in the Formula (A-1).

Specific examples of each group and atom in R⁴ and the suitable number of carbon atoms thereof may include the groups, atoms, and the number of carbon atoms described above for X in the Formula (A-1).

Specific examples of the alkylene group in R⁵ include, but are not limited to, alkylene groups, for example, linear alkylene groups such as a methylene group, an ethylene group, a trimethylene group, a tetramethylene group, a pentamethylene group, a hexamethylene group, a heptamethylene group, an octamethylene group, a nonamethylene group, a decamethylene group; branched alkylene groups, such as a 1-methyltrimethylene group, a 2-methyltrimethylene group, a 1,1-dimethylethylene group, a 1-methyltetramethylene group, a 2-methyltetramethylene group, a 1,1-dimethyltrimethylene group, a 1,2-dimethyltrimethylene group, a 2,2-dimethyltrimethylene group, a 1-ethyltrimethylene group; and alkanetriyl groups, such as a methanetriyl group, an ethane-1,1,2-triyl group, an ethane-1,2,2-triyl group, an ethane-2,2,2-triyl group, a propane-1,1,1-triyl group; a propane-1,1,2-triyl group, a propane-1,2,3-triyl group, a propane-1,2,2-triyl group, a propane-1,1,3-triyl group, a butane-1,1,1-triyl group, a butane-1,1,2-triyl group, a butane-1,1,3-triyl group, a butane-1,2,3-triyl group, a butane-1,2,4-triyl group, a butane-1,2,2-triyl group, a butane-2,2,3-triyl group, a 2-methylpropane-1,1,1-triyl group, a 2-methylpropane-1,1,2-triyl group, and a 2-methylpropane-1,1,3-triyl group.

Specific examples of the arylene group in R⁵ include a 1,2-phenylene group, a 1,3-phenylene group, and a 1,4-phenylene group; groups derived by removing two hydrogen atoms on the aromatic ring of a fused ring aromatic hydrocarbon compound such as a 1,5-naphthalenediyl group, a 1,8-naphthalenediyl group, a 2,6-naphthalenediyl group, a 2,7-naphthalenediyl group, a 1,2-anthracenediyl group, a 1,3-anthracenediyl group, a 1,4-anthracenediyl group, a 1,5-anthracenediyl group, a 1,6-anthracenediyl group, a 1,7-anthracenediyl group, a 1,8-anthracenediyl group, a 2,3-anthracenediyl group, a 2,6-anthracenediyl group, a 2,7-anthracenediyl group, a 2,9-anthracenediyl group, a 2,10-anthracenediyl group, and a 9,10-anthracenediyl group; and a group derived by removing two hydrogen atoms on the aromatic rings of a ring-linked aromatic hydrocarbon compound such as a 4,4'-biphenyldiyl group and a 4,4"-p-terphenyldiyl group, but are not limited thereto.

b is preferably 0.

c is preferably 1.

Specific examples of the hydrolyzable silane represented by the Formula (2) include, but are not limited to, methylenebistrimethoxysilane, methylenebistrichlorosilane, methylenebistriacetoxysilane, ethylenebistriethoxysilane, ethylenebistrichlorosilane, ethylenebistriacetoxysilane, propylenebistriethoxysilane, butylenebistrimethoxysilane, phenylenebistrimethoxysilane, phenylenebistriethoxysilane, phenylenebismethyldiethoxysilane, phenylenebismethyldimethoxysilane, naphthylenebistrimethoxysilane, bistrimethoxysilane, bistrimethoxydisilane, bistriethoxydisilane, bisethyldiethoxydisilane, and bismethyldimethoxydisilane.

The polysiloxane [A] may be, for example, a hydrolysis condensate of a hydrolyzable silane containing the hydrolyzable silane (A) represented by the Formula (A-1), the hydrolyzable silane represented by the Formula (1) and/or the hydrolyzable silane represented by the Formula (2), and an additional hydrolyzable silane described below, or a modified product of the hydrolysis condensate.

Examples of polysiloxane [A'] include a hydrolysis condensate of a hydrolyzable silane including the hydrolyzable silane represented by the Formula (1) and/or the hydrolyzable silane represented by the Formula (2) and other hydrolyzable silanes described below, or a modified product thereof.

Examples of the additional hydrolyzable silane include, but are not limited to, silane compounds having an onium group in the molecule.

### <<Silane Compound Having Onium Group in Molecule (Hydrolyzable Organosilane)>>

A silane compound having an onium group in the molecule is expected to effectively and efficiently promote the crosslinking reaction of a hydrolyzable silane.

One preferred example of the silane compound having an onium group in the molecule is shown in the following Formula (3).
[Chem. 42]

R¹¹_{f}R¹²_{g}Si(R¹³)_{4-(f+g)} (3)

R¹¹ is a group bonded to a silicon atom, and represents an onium group or an organic group having the onium group.

R¹² is a group bonded to a silicon atom, and each independently represents an optionally substituted alkyl group, an optionally substituted halogenated alkyl group, an optionally substituted alkoxyalkyl group or an optionally substituted alkenyl group, or represents an organic group having an epoxy group, an organic group having a mercapto group, an organic group having an amino group, or an organic group having a cyano group, or a combination of two or more of the groups.

R¹³ is a group or atom bonded to a silicon atom, and each independently represents an alkoxy group, an aralkyloxy group, an acyloxy group, or a halogen atom.

f represents 1 or 2, g represents 0 or 1, and 1 ≤ f + g ≤ 2 is satisfied.

Specific examples of the alkyl group, the halogenated alkyl group, the alkoxyalkyl group, the alkenyl group, and the organic group having an epoxy group, the organic group having a mercapto group, the organic group having an amino group, the organic group having a cyano group, the alkoxy group, the aralkyloxy group, the acyloxy group, and the halogen atom, and specific examples of the substituents of the alkyl group, the halogenated alkyl group, the alkoxyalkyl group, and the alkenyl group, and preferred carbon atom numbers thereof are the same as those described above regarding R³ in the Formula (A-1) (for R¹²), and regarding X in the Formula (A-1) (for R¹³).

More specifically, the onium group is, for example, a cyclic ammonium group or a chain ammonium group, and is preferably a tertiary ammonium group or a quaternary ammonium group.

That is, preferred specific examples of the onium group or the organic group having the onium group include a cyclic ammonium group, a chain ammonium group, or an organic group containing at least one of the cyclic ammonium group or the chain ammonium group. Preferred is a tertiary ammonium group or a quaternary ammonium group or an organic group containing at least one of the tertiary ammonium group or the quaternary ammonium group.

When the onium group is a cyclic ammonium group, a nitrogen atom forming the ammonium group also serves as an atom constituting the ring. In this case, the nitrogen atom forming the ring and the silicon atom are bonded directly or via a divalent linking group, or the carbon atom forming the ring and the silicon atom are bonded directly or via a divalent linking group.

In one preferred aspect, R¹¹, i.e. the group bonding to the silicon atom in the Formula (3), may be a heteroaliphatic cyclic ammonium group represented by the following Formula (S2).

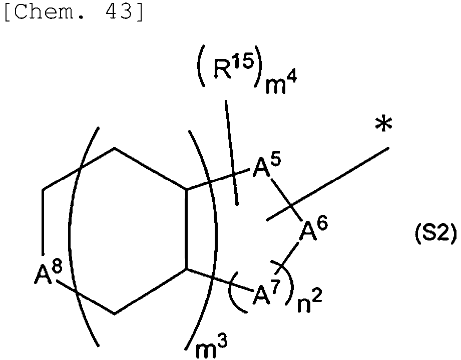

In the Formula (S2), A⁵, A⁶, A⁷, and A⁸ each independently represent a group represented by any one of the following Formulae (J4) to (J6), and at least one of A⁵ to A⁸ represents a group represented by the following Formula (J5). Depending on to which atom of A⁵ to A⁸ a silicon atom in the Formula (3) is bonded, it is determined whether a bond between any one of A⁵ to A⁸ and a ring-forming atom adjacent to the any one is a single bond or a double bond so that the ring to be formed exhibits non-aromaticity. An asterisk * represents a bonding hand.

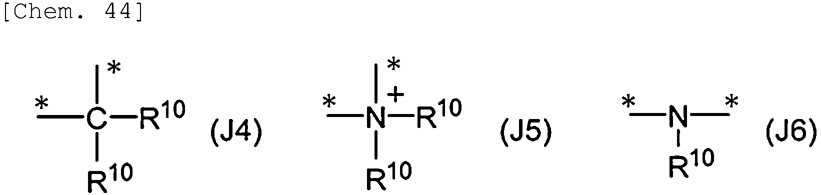

In the Formulae (J4) to (J6), R¹⁰ each independently represents a single bond, a hydrogen atom, an alkyl group, or a halogenated alkyl group. Specific examples of the alkyl group, the halogenated alkyl group, and preferred carbon atom numbers thereof are the same as those described above. An asterisk * represents a bonding hand.

In the Formula (S2), R¹⁵ each independently represents an alkyl group, a halogenated alkyl group, or a hydroxy group. When two or more of R¹⁵s are present, the two R¹⁵s may be bonded together to form a ring, and the ring formed by the two R¹⁵s may have a crosslinked ring structure. In such a case, the cyclic ammonium group has an adamantane ring, a spiro ring, or the like.

Specific examples of the alkyl group, the halogenated alkyl group, and preferred carbon atom numbers thereof are the same as those described above.

In the Formula (S2), n² is an integer of 1 to 8, m³ is 0 or 1, and m⁴ is 0 or a positive integer ranging from 1 to the possible maximum number being substituted on a monocyclic or polycyclic ring.

When m³ is 0, a (4+n²)-membered ring including A⁵ to A⁸ is formed. That is, when n² is 1, a 5-membered ring is formed; when n² is 2, a 6-membered ring is formed; when n² is 3, a 7-membered ring is formed; when n² is 4, an 8-membered ring is formed; when n² is 5, a 9-membered ring is formed; when n² is 6, a 10-membered ring is formed; when n² is 7, a 11-membered ring is formed; and when n² is 8, a 12-membered ring is formed.

When m³ is 1, a condensed ring is formed by condensation between a (4+n²)-membered ring including A⁵ to A⁷ and a 6-membered ring including A⁸.

Since each of A⁵ to A⁸ is any of the groups of Formulae (J4) to (J6), the ring-forming atom has or does not have a hydrogen atom. In each of A⁵ to A⁸, when the ring-forming atom has a hydrogen atom, the hydrogen atom may be substituted with R¹⁵. Alternatively, a ring-forming atom other than the ring-forming atom in each of A⁵ to A⁸ may be substituted with R¹⁵.

Because of such circumstances, as described above, m⁴ is selected from 0 or an integer ranging from 1 to the possible maximum number being substituted on a monocyclic or polycyclic ring.

The bonding hand of the heteroaliphatic cyclic ammonium group represented by the Formula (S2) is present on any carbon atom or nitrogen atom present in such a monocyclic ring or condensed ring, and is directly bonded to a silicon atom. Alternatively, the bonding hand is bonded to a linking group to form an organic group containing the cyclic ammonium group, and the organic group is bonded to a silicon atom.

Examples of the linking group include an alkylene group, and specific examples of the alkylene group and preferred carbon atom numbers thereof are the same as those described above.

Specific examples of the silane compound (hydrolyzable organosilane) represented by the Formula (3) having the heteroaliphatic cyclic ammonium group represented by the Formula (S2) include, but are not limited to, silanes represented by the following Formula.

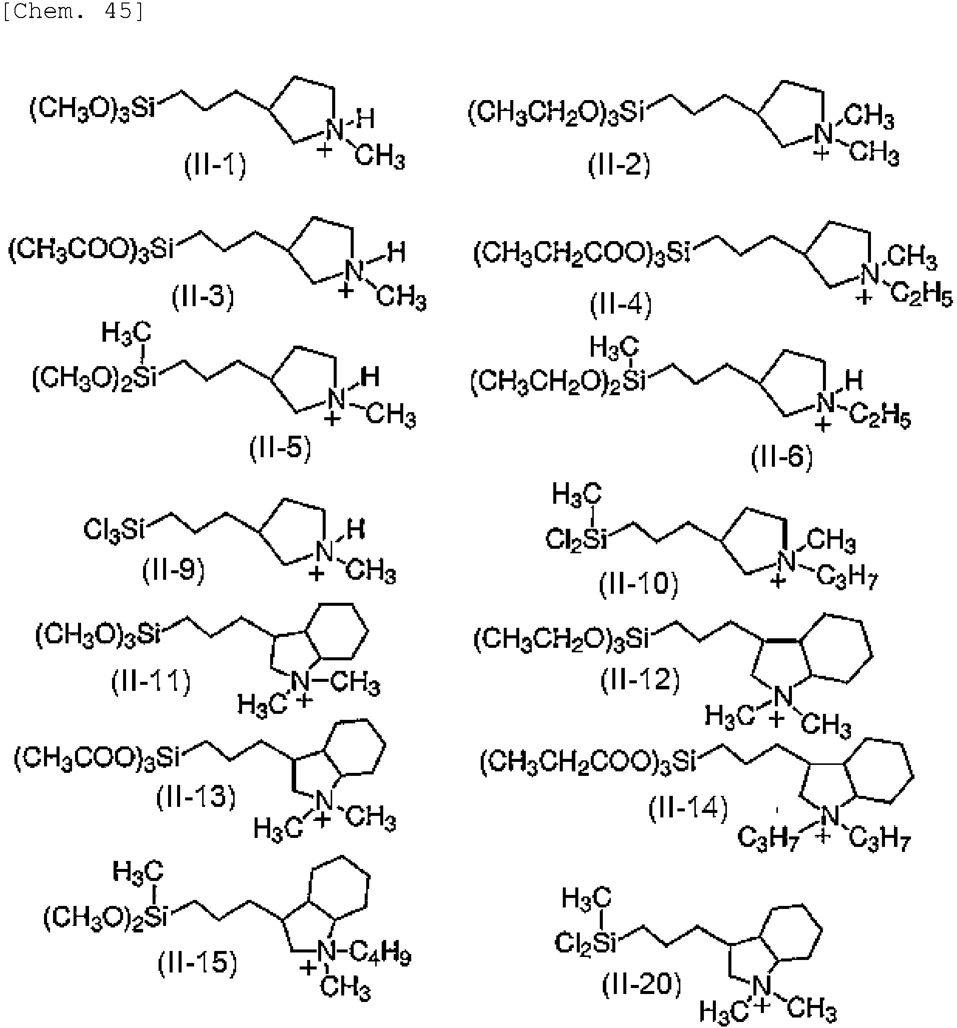

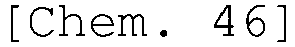

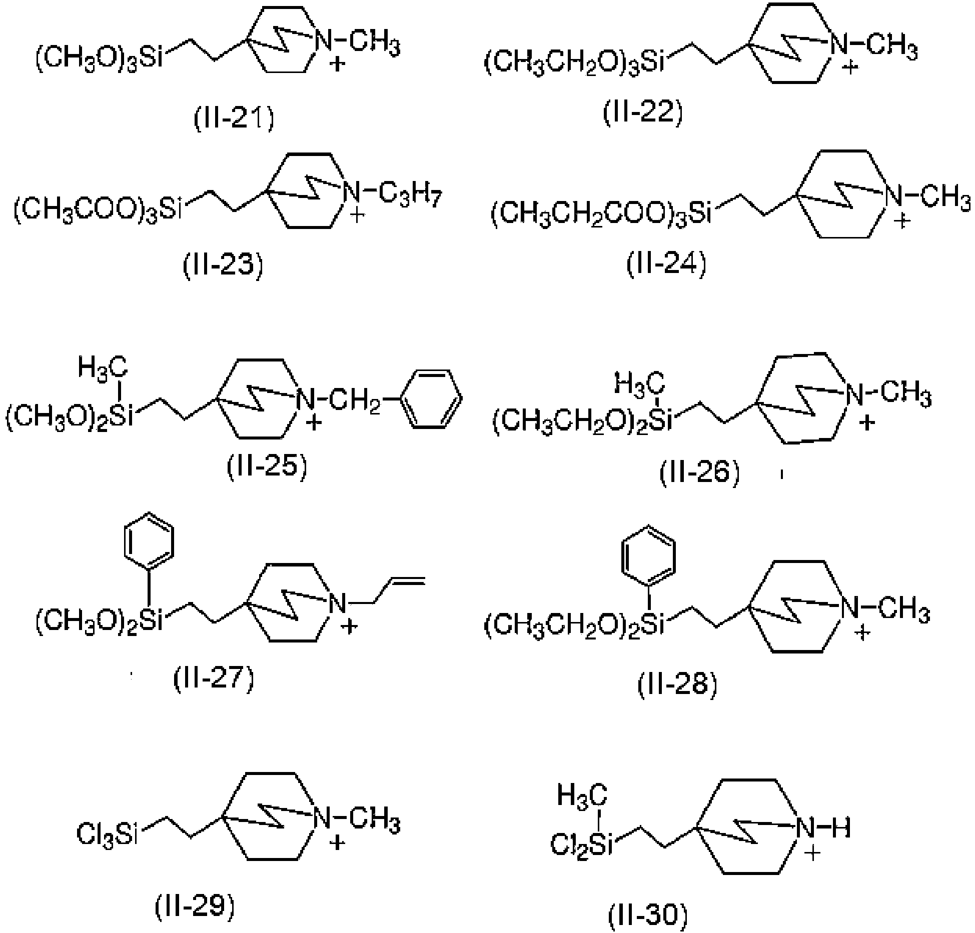

In another example, R¹¹, i.e. the group bonding to the silicon atom in the Formula (3), may be a chain ammonium group represented by the following Formula (S3).

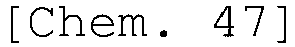

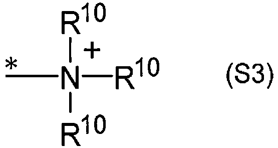

In the Formula (S3), R¹⁰ each independently represents a hydrogen atom, an alkyl group, a halogenated alkyl group, or an alkenyl group. Specific examples of the alkyl group, the alkyl halide, the halogenated alkyl group, and preferred carbon atom numbers thereof are the same as those described above. An asterisk * represents a bonding hand.

The chain ammonium group represented by the Formula (S3) is directly bonded to a silicon atom. Alternatively, the chain ammonium group is bonded to a linking group to form an organic group containing the chain ammonium group, and the organic group is bonded to a silicon atom.

The linking group is, for example, an alkylene group or an alkenylene group. Specific examples of the alkylene group and the alkenylene group are the same as those as described above.

Specific examples of the silane compound (hydrolyzable organosilane) represented by the Formula (3) having the chain ammonium group represented by the Formula (S3) include, but are not limited to, silanes represented by the following Formula.

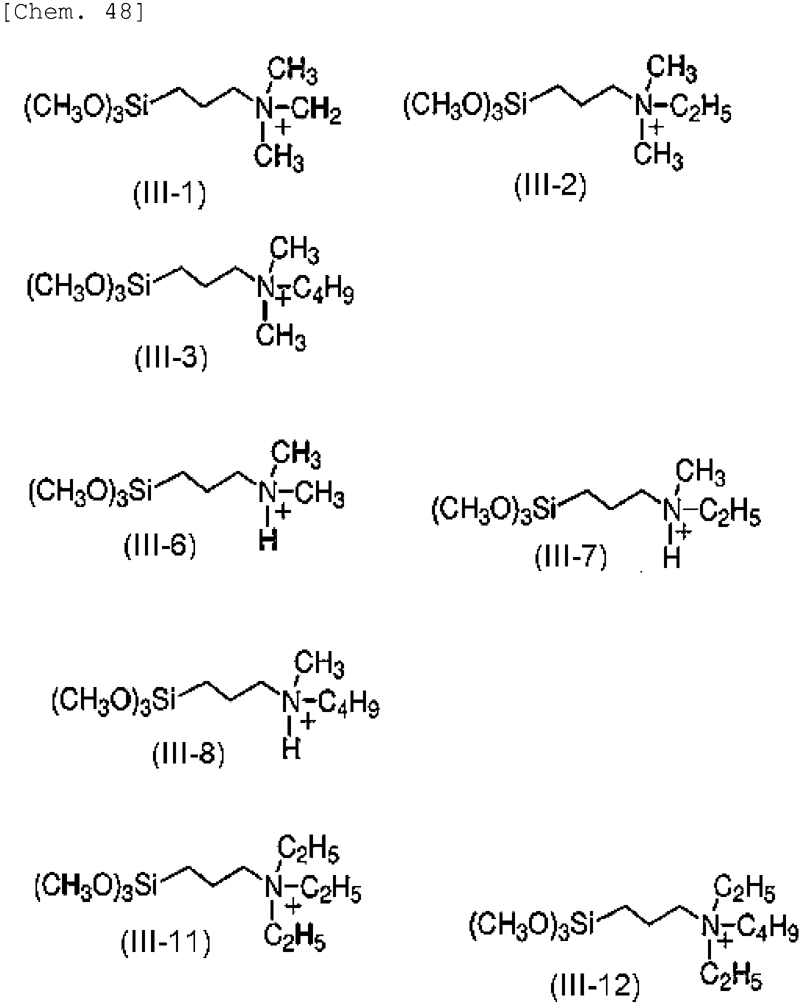

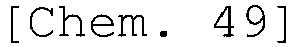

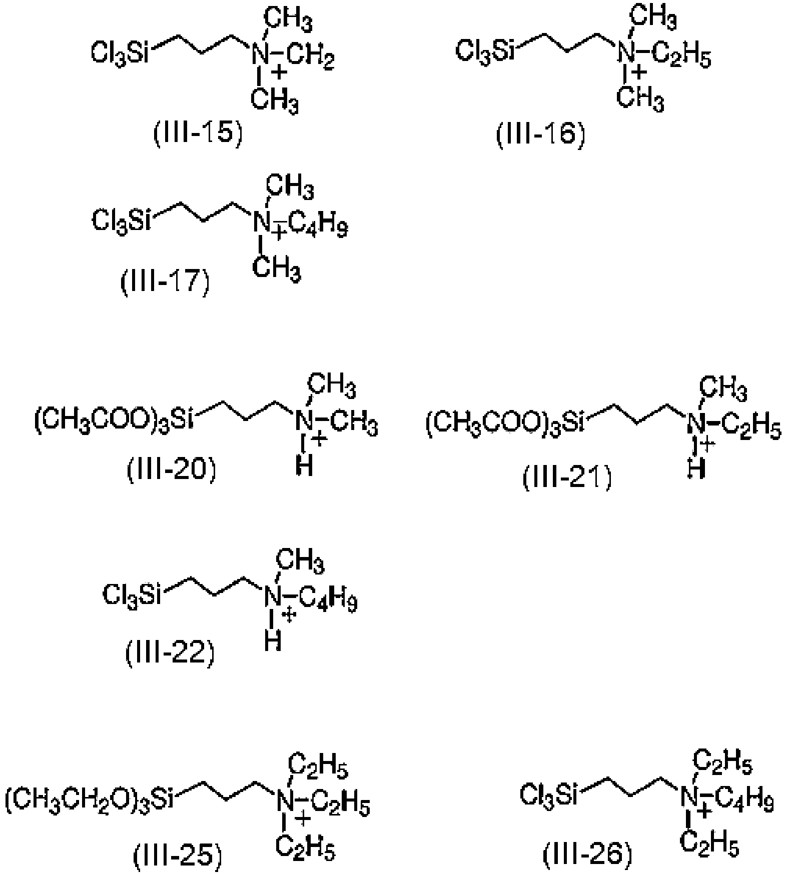

Polysiloxane [A] and polysiloxane [A'] can be a hydrolysis condensate of a hydrolyzable silane including another silane compound other than those exemplified above or a modified product thereof as long as the effect of the present invention is not impaired.

As described above, as the polysiloxane [A] and the polysiloxane [A'], a modified product in which at least a part of the silanol group of the hydrolysis condensate is modified can be used. For example, a modified product in which a part of silanol groups is alcohol-modified or acetal-protected can be used.

Examples of the polysiloxane as the modified product include a product prepared by a reaction between at least some of silanol groups of the above-described hydrolysis condensate of hydrolyzable silane and a hydroxy group of an alcohol, a product prepared by dehydration reaction between the condensate and an alcohol, and a modified product prepared by protection of at least some of silanol groups of the condensate with an acetal group.

As the alcohol, a monohydric alcohol can be used. Examples of the monohydric alcohol include methanol, ethanol, 2-propanol, 1-butanol, 2-butanol, isobutyl alcohol, tert-butyl alcohol, 1-pentanol, 2-pentanol, 3-pentanol, 1-heptanol, 2-heptanol, tert-amyl alcohol, neopentyl alcohol, 2-methyl-1-propanol, 2-methyl-1-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-diethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, and cyclohexanol.

For example, alkoxy group-containing alcohols such as 3-methoxybutanol, ethylene glycol monomethyl ether, ethylene glycol monoethyl ether, diethylene glycol monomethyl ether, diethylene glycol monoethyl ether, propylene glycol monomethyl ether (1-methoxy-2-propanol), propylene glycol monoethyl ether (1-ethoxy-2-propanol), and propylene glycol monobutyl ether (1-butoxy-2 propanol) can be used.

The reaction between silanol groups of the hydrolysis condensate and hydroxy groups of the alcohol is performed by bringing the hydrolysis condensate into contact with the alcohol. A modified product containing capped silanol groups is prepared by performing the reaction at a temperature of 40 to 160°C (e.g. 60°C) for 0.1 to 48 hours (e.g. 24 hours). In this case, the alcohol serving as a capping agent may be used as a solvent in the composition containing the polysiloxane.

The product by dehydration reaction between the hydrolysis condensate of hydrolyzable silane and the alcohol can be produced by reacting the hydrolysis condensate with the alcohol in the presence of an acid as a catalyst, capping silanol groups with the alcohol, and removing water generated through the dehydration to the outside of the reaction system.

As the acid, an organic acid having an acid dissociation constant (pka) of -1 to 5, preferably 4 to 5 can be used. Examples of the acid include trifluoroacetic acid, maleic acid, benzoic acid, isobutyric acid, and acetic acid, and among them, benzoic acid, isobutyric acid, acetic acid, and the like can be exemplified.

As the acid, an acid having a boiling point of 70 to 160°C can be used, and examples thereof include trifluoroacetic acid, isobutyric acid, acetic acid, and nitric acid.

As described above, the acid preferably has a physical property of an acid dissociation constant (pka) of 4 to 5 or a boiling point of 70 to 160°C. That is, one having a low acidity or one having a low boiling point even if the acidity is high can be used.

Either of these properties: acid dissociation constant and boiling point of the acid may be utilized.

The acetal protection of silanol groups of the hydrolysis condensate can be performed with a vinyl ether; for example, a vinyl ether represented by the following Formula (5). Such a reaction can be performed to introduce a partial structure represented by the following Formula (6) into the polysiloxane. 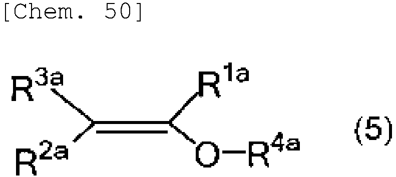 In the Formula (5), R¹³, R^{2a}, and R^{3a} each represent a hydrogen atom or an alkyl group having 1 to 10 carbon atoms, R^{4a} represents an alkyl group having 1 to 10 carbon atoms, and R^{2a} and R^{4a} may be bonded together to form a ring. Examples of the alkyl group are the same as those described above.

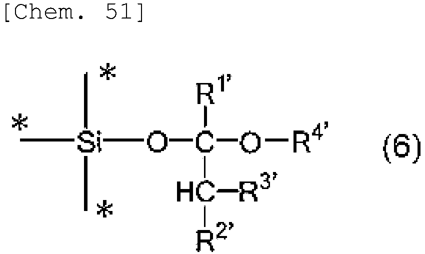

In the Formula (6), R^{1'}, R^{2'}, and R^{3'} each represent a hydrogen atom or an alkyl group having 1 to 10 carbon atoms, R^{4'} represents an alkyl group having 1 to 10 carbon atoms, and R^{2'} and R^{4'} may be bonded together to form a ring. In the Formula (6), * represents a bond to an adjacent atom. The adjacent atom is, for example, an oxygen atom of a siloxane bond, an oxygen atom of a silanol group, or a carbon atom derived from R¹ of Formula (1). Examples of the alkyl group are the same as those described above.

As the vinyl ether represented by the Formula (5), for example, aliphatic vinyl ether compounds, such as methyl vinyl ether, ethyl vinyl ether, isopropyl vinyl ether, normal butyl vinyl ether, 2-ethylhexyl vinyl ether, tert-butyl vinyl ether, and cyclohexyl vinyl ether; and cyclic vinyl ether compounds, such as 2,3-dihydrofuran, 4-methyl-2,3-dihydrofuran, and 3,4-dihydro-2H-pyran, may be used. In particular, ethyl vinyl ether, propyl vinyl ether, butyl vinyl ether, ethylhexyl vinyl ether, cyclohexyl vinyl ether, 3,4-dihydro-2H-pyran, or 2,3-dihydrofuran may be preferably used.

The acetal protection of silanol groups can be performed using a hydrolysis condensate, a vinyl ether, and an aprotic solvent such as propylene glycol monomethyl ether acetate, ethyl acetate, dimethylformamide, tetrahydrofuran, or 1,4-dioxane as a solvent, and a catalyst such as pyridium p-toluenesulfonate, trifluoromethanesulfonic acid, p-toluenesulfonic acid, methanesulfonic acid, hydrochloric acid, or sulfuric acid.

The capping of silanol groups with an alcohol or the acetal protection of silanol groups may be performed simultaneously with the hydrolysis and condensation of the hydrolyzable silane described below.

The hydrolysis condensate of hydrolyzable silane or a modified product of the hydrolysis condensate may have a weight average molecular weight of, for example, 500 to 1,000,000. From the viewpoint of suppressing precipitation of a hydrolysis condensate s or a modified product thereof in the composition, or the like, the weight average molecular weight can be preferably 500,000 or less, more preferably 250,000 or less, and still more preferably 100,000 or less, and from the viewpoint of achieving both storage stability and coatability, or the like, the weight average molecular weight can be preferably 700 or more, and more preferably 1,000 or more.

Note that the weight average molecular weight is a molecular weight obtained in terms of polystyrene by GPC analysis. The GPC analysis can be performed under the following conditions: GPC apparatus (trade name: HLC-8220GPC, manufactured by Tosoh Corporation), GPC columns (trade name: Shodex (registered trademark) KF803L, KF802, and KF801, manufactured by Showa Denko K.K.), column temperature of 40°C, tetrahydrofuran as an eluent (elution solvent), flow amount (flow rate) of 1.0 mL/min, and polystyrene (Shodex (registered trademark) manufactured by Showa Denko K.K.) as a standard sample.

The hydrolysis condensate of hydrolyzable silane is prepared by hydrolysis and condensation of the above-described silane compound (hydrolyzable silane).

The above-described silane compound (hydrolyzable silane) contains an alkoxy group, aralkyloxy group, acyloxy group, or halogen atom directly bonded to a silicon atom; i.e. an alkoxysilyl group, an aralkyloxysilyl group, an acyloxysilyl group, or a halogenated silyl group (hereinafter, such a group is referred to as "hydrolyzable group").

For the hydrolysis of the hydrolyzable group, ordinarily 0.1 to 100 mol, for example, 0.5 to 100 mol, preferably 1 to 10 mol, of water is used per mol of the hydrolyzable group.

During hydrolysis and condensation, a hydrolysis catalyst may be used for the purpose of promoting the reaction. Alternatively, the hydrolysis and condensation may be performed without use of a hydrolysis catalyst. When a hydrolysis catalyst is used, the amount of the hydrolysis catalyst is ordinarily 0.0001 to 10 mol, preferably 0.001 to 1 mol per mol of the hydrolyzable group.

The reaction temperature for the hydrolysis and condensation is ordinarily equal to or higher than room temperature, or equal to or lower than the reflux temperature at normal pressure of an organic solvent usable for hydrolysis. The reaction temperature may be, for example, 20 to 110°C, or, for example, 20 to 80°C.

The hydrolysis may be performed completely; i.e. all hydrolyzable groups may be converted into silanol groups, or may be performed partially; i.e. unreacted hydrolyzable groups may remain.

Examples of the hydrolysis catalyst usable for the hydrolysis and condensation include a metal chelate compound, an organic acid, an inorganic acid, an organic base, and an inorganic base.

Examples of the metal chelate compound as the hydrolysis catalyst include, but are not limited to, titanium chelate compounds such as triethoxy-mono(acetylacetonate)titanium, tri-n-propoxy-mono(acetylacetonate)titanium, tri-i-propoxy-mono(acetylacetonate)titanium, tri-n-butoxy-mono(acetylacetonate)titanium, tri-sec-butoxy-mono(acetylacetonate)titanium, tri-t-butoxy-mono(acetylacetonate)titanium, diethoxy-bis(acetylacetonate)titanium, di-n-propoxy-bis(acetylacetonate)titanium, di-i-propoxy-bis(acetylacetonate)titanium, di-n-butoxy-bis(acetylacetonate)titanium, di-sec-butoxy-bis(acetylacetonate)titanium, di-t-butoxy-bis(acetylacetonate)titanium, monoethoxy-tris(acetylacetonate)titanium, mono-n-propoxy-tris(acetylacetonate)titanium, mono-i-propoxy-tris(acetylacetonate)titanium, mono-n-butoxy-tris(acetylacetonate)titanium, mono-sec-butoxy-tris(acetylacetonate)titanium, mono-t-butoxy-tris(acetylacetonate)titanium, tetrakis(acetylacetonate)titanium, triethoxy-mono(ethyl acetoacetate) titanium, tri-n-propoxy-mono(ethyl acetoacetate) titanium, tri-i-propoxy-mono(ethyl acetoacetate) titanium, tri-n-butoxy-mono(ethyl acetoacetate) titanium, tri-sec-butoxy-mono(ethyl acetoacetate) titanium, tri-t-butoxy-mono(ethyl acetoacetate) titanium, diethoxy-bis(ethyl acetoacetate) titanium, di-n-propoxy-bis(ethyl acetoacetate) titanium, di-i-propoxy-bis(ethyl acetoacetate) titanium, di-n-butoxy-bis(ethyl acetoacetate) titanium, di-sec-butoxy-bis(ethyl acetoacetate) titanium, di-t-butoxy-bis(ethyl acetoacetate) titanium, monoethoxy-tris(ethyl acetoacetate) titanium, mono-n-propoxy-tris(ethyl acetoacetate) titanium, mono-i-propoxy-tris(ethyl acetoacetate) titanium, mono-n-butoxy-tris(ethyl acetoacetate) titanium, mono-sec-butoxy-tris(ethyl acetoacetate) titanium, mono-t-butoxy-tris(ethyl acetoacetate) titanium, tetrakis(ethyl acetoacetate) titanium, mono(acetylacetonate)tris(ethyl acetoacetate) titanium, bis(acetylacetonate)bis(ethyl acetoacetate) titanium, and tris(acetylacetonate)mono(ethyl acetoacetate)titanium; zirconium chelate compounds such as triethoxy-mono(acetylacetonate) zirconium, tri-n-propoxy-mono(acetylacetonate) zirconium, tri-i-propoxy-mono(acetylacetonate) zirconium, tri-n-butoxy-mono(acetylacetonate) zirconium, tri-sec-butoxy-mono(acetylacetonate) zirconium, tri-t-butoxy-mono(acetylacetonate) zirconium, diethoxy-bis(acetylacetonate)zirconium, di-n-propoxy-bis(acetylacetonate)zirconium, di-i-propoxy-bis(acetylacetonate)zirconium, di-n-butoxy-bis(acetylacetonate)zirconium, di-sec-butoxy-bis(acetylacetonate)zirconium, di-t-butoxy-bis(acetylacetonate)zirconium, monoethoxy-tris(acetylacetonate)zirconium, mono-n-propoxy-tris(acetylacetonato)zirconium, mono-i-propoxy-tris(acetylacetonate)zirconium, mono-n-butoxy-tris(acetylacetonate)zirconium, mono-sec-butoxy-tris(acetylacetonate)zirconium, mono-t-butoxy-tris(acetylacetonate)zirconium, tetrakis(acetylacetonate)zirconium, triethoxy-mono(ethyl acetoacetate) zirconium, tri-n-propoxy-mono(ethyl acetoacetate) zirconium, tri-i-propoxy-mono(ethyl acetoacetate) zirconium, tri-n-butoxy-mono(ethyl acetoacetate) zirconium, tri-sec-butoxy-mono(ethyl acetoacetate) zirconium, tri-t-butoxy-mono(ethyl acetoacetate) zirconium, diethoxy-bis(ethyl acetoacetate) zirconium, di-n-propoxy-bis(ethyl acetoacetate) zirconium, di-i-propoxy-bis(ethyl acetoacetate) zirconium, di-n-butoxy-bis(ethyl acetoacetate) zirconium, di-sec-butoxy-bis(ethyl acetoacetate) zirconium, di-t-butoxy-bis(ethyl acetoacetate) zirconium, monoethoxy-tris(ethyl acetoacetate) zirconium, mono-n-propoxy-tris(ethyl acetoacetate) zirconium, mono-i-propoxy-tris(ethyl acetoacetate) zirconium, mono-n-butoxy-tris(ethyl acetoacetate) zirconium, mono-sec-butoxy-tris(ethyl acetoacetate) zirconium, mono-t-butoxy-tris(ethyl acetoacetate) zirconium, tetrakis(ethyl acetoacetate) zirconium, mono(acetylacetonate)tris(ethyl acetoacetate) zirconium, bis(acetylacetonate)bis(ethyl acetoacetate) zirconium, and tris(acetylacetonate)mono(ethyl acetoacetate) zirconium; and aluminum chelate compounds such as tris(acetylacetonate)aluminum and tris(ethyl acetoacetate)aluminum.

Examples of the organic acid as the hydrolysis catalyst include, but are not limited to, acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, and tartaric acid.

Examples of the inorganic acid as the hydrolysis catalyst include, but are not limited to, hydrochloric acid, nitric acid, sulfuric acid, hydrofluoric acid, and phosphoric acid.

Examples of the organic base as the hydrolysis catalyst include, but are not limited to, pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, tetraethylammonium hydroxide, tetrapropylammonium hydroxide, tetrabutylammonium hydroxide, trimethylphenylammonium hydroxide, benzyltrimethylammonium hydroxide, and benzyltriethylammonium hydroxide.

Examples of the inorganic base as the hydrolysis catalyst include, but are not limited to, ammonia, sodium hydroxide, potassium hydroxide, barium hydroxide, and calcium hydroxide.

Among these catalysts, a metal chelate compound, an organic acid, and an inorganic acid is preferred. These catalysts may be used singly or in combination of two or more kinds thereof.

In particular, nitric acid can be suitably used as a hydrolysis catalyst in the present invention. By using a nitric acid, the storage stability of the reaction solution after hydrolysis and condensation can be improved, and in particular, a change in the molecular weight of the hydrolysis condensate or its modified product can be suppressed. The stability of the hydrolysis condensate or its modified product in the solution has been found to depend on the pH of the solution. As a result of intensive studies, it has been found that the pH of the solution becomes a stable region by using an appropriate amount of nitric acid.

As described above, nitric acid can also be used for preparation of a modified product of the hydrolysis condensate; for example, for capping of silanol groups with an alcohol. Thus, nitric acid is preferred from the viewpoint that it can contribute to the reactions of hydrolysis and condensation of the hydrolyzable silane, as well as the reaction of capping of the hydrolysis condensate with an alcohol.

When hydrolysis and condensation are performed, an organic solvent may be used as a solvent, and specific examples thereof include aliphatic hydrocarbon-based solvents such as n-pentane, i-pentane, n-hexane, i-hexane, n-heptane, i-heptane, 2,2,4-trimethylpentane, n-octane, i-octane, cyclohexane, and methylcyclohexane; aromatic hydrocarbon-based solvents such as benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, and n-amylnaphthalene; monoalcohol-based solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, n-heptanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; polyhydric alcohol-based solvents such as ethylene glycol, propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin; ketone-based solvents such as acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethylnonanone, cyclohexanone, methylcyclohexanone, 2,4-pentanedione, acetonylacetone, diacetone alcohol, acetophenone, and fenchon; ether-based solvents such as ethyl ether, i-propyl ether, n-butyl ether, n-hexyl ether, 2-ethylhexyl ether, ethylene oxide, 1,2-propylene oxide, dioxolane, 4-methyldioxolane, dioxane, dimethyldioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethyl butyl ether, ethylene glycol dibutyl ether, diethylene glycol monomethyl ether, diethylene glycol monoethyl ether, diethylene glycol diethyl ether, diethylene glycol mono-n-butyl ether, diethylene glycol din-butyl ether, diethylene glycol mono-n-hexyl ether, ethoxy triglycol, tetraethylene glycol di-n-butyl ether, propylene glycol monomethyl ether (1-methoxy-2-propanol), propylene glycol monoethyl ether (1-ethoxy-2-propanol), propylene glycol monopropyl ether, propylene glycol monobutyl ether, propylene glycol monomethyl ether acetate (1-methoxy-2-propanol monoacetate), dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, and 2-methyltetrahydrofuran; ester-based solvents such as diethyl carbonate, methyl acetate, ethyl acetate, γ-butyrolactone, γ-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethylene glycol diacetate, triethylene glycol methyl ether acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, and diethyl phthalate; nitrogen-containing solvents such as N-methylformamide, N,N-dimethylformamide, N,N-diethylformamide, acetamide, N-methylacetamide, N,N-dimethylacetamide, N-methylpropionamide, and N-methyl-2-pyrrolidone; and sulfur-containing solvents such as dimethyl sulfide, diethyl sulfide, thiophene, tetrahydrothiophene, dimethyl sulfoxide, sulfolane, and 1,3-propane sultone, but are not limited thereto. These solvents can be used singly or in combination of two or more kinds thereof.

After completion of the hydrolysis and condensation reactions, the reaction solution is used as is, or diluted or concentrated. The resultant reaction solution can be neutralized or treated with an ion exchange resin, and thus the hydrolysis catalyst, e.g. an acid or a base, used for the hydrolysis and condensation can be removed. Before or after such a treatment, alcohols: by-products, water, the used hydrolysis catalyst, and the like can be removed from the reaction solution, for example, by distillation under reduced pressure.

The thus-prepared hydrolysis condensate or a modified product of the hydrolysis condensate (hereinafter, also referred to as "polysiloxane") is in the form of a polysiloxane varnish dissolved in an organic solvent, which may be used as is for preparation of the silicon-containing resist underlayer film-forming composition. That is, the reaction solution can be used as it is (or after dilution) for the preparation of the silicon-containing resist underlayer film-forming composition, and at this time, the hydrolysis catalyst used for hydrolysis and condensation, by-products, and the like may remain in the reaction solution as long as the effect of the present invention is not impaired. For example, nitric acid used as a hydrolysis catalyst or used for capping of silanol groups with an alcohol may remain in the polymer varnish solution in an amount of about 100 ppm to 5,000 ppm.

The resultant polysiloxane varnish may be subjected to solvent replacement, or may be appropriately diluted with a solvent. In a case where the storage stability of the resultant polysiloxane varnish is not poor, the organic solvent may be distilled off to achieve a film-forming component concentration of 100%. The film-forming component refers to a component resulted from the removal of a solvent component from all the components of the composition.

The organic solvent used for solvent replacement, dilution, or the like of the polysiloxane varnish may be identical to or different from the organic solvent used for the hydrolysis and condensation reactions of the hydrolyzable silane. The solvent for dilution is not particularly limited, and one kind or two or more kinds of solvents may be arbitrarily selected and used.

### <Component [C]: Solvent>

In the first embodiment, for the solvent as the component [C], any solvent can be used without particular limitation as long as it is a solvent capable of dissolving and mixing the component [A] and, if necessary, other components contained in the silicon-containing resist underlayer film-forming composition.

In the second embodiment, the solvent as the component [C] can be used without particular limitation as long as it is a solvent capable of dissolving and mixing the component [A'] and the component [B] and, if necessary, other components contained in the silicon-containing resist underlayer film-forming composition.

The solvent [C] is preferably an alcohol-based solvent, more preferably alkylene glycol monoalkyl ether: alcohol-based solvent, and still more preferably propylene glycol monoalkyl ether. Since these solvents are also capping agents for silanol groups of the hydrolysis condensate, it is possible to prepare a silicon-containing resist underlayer film-forming composition from a solution obtained by preparing polysiloxane [A] or polysiloxane [A'] without requiring solvent substitution or the like.

Examples of the alkylene glycol monoalkyl ether include ethylene glycol monomethyl ether, ethylene glycol monoethyl ether, ethylene glycol monopropyl ether, ethylene glycol monobutyl ether, propylene glycol monomethyl ether (1-methoxy-2-propanol), propylene glycol monoethyl ether (1-ethoxy-2-propanol), methyl isobutyl carbinol, and propylene glycol monobutyl ether.

Specific examples of other solvent [C] include methyl cellosolve acetate, ethyl cellosolve acetate, propylene glycol monomethyl ether acetate (1-methoxy-2-propanol monoacetate), propylene glycol monoethyl ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether acetate, ethylene glycol monoethyl ether acetate, ethylene glycol monopropyl ether acetate, ethylene glycol monobutyl ether acetate, diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, ethyl hydroxyacetate, ethyl 2-hydroxy-2-methylpropionate, methyl 3-methoxy-2-methylpropionate, methyl 2-hydroxy-3-methybutyrate, ethyl methoxyacetate, ethyl ethoxyacetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, toluene, xylene, methyl ethyl ketone, methyl propyl ketone, methyl butyl ketone, 2-heptanone, 3-heptanone, 4-heptanone, cyclohexanone, N,N-dimethylformamide, N-methylacetamide, N,N-dimethylacetamide, N-methyl-2-pyrrolidone, 4-methyl-2-pentanol, and γ-butyrolactone. These solvents can be used singly or in combination of two or more kinds thereof.

The silicon-containing resist underlayer film-forming composition of the present invention may contain water as a solvent. When water is contained as the solvent, the content thereof may be, for example, 30 mass% or less, preferably 20 mass% or less, and still more preferably 15 mass% or less relative to the total mass of the solvent contained in the composition.

### <Component [D]: Curing Catalyst>

The silicon-containing resist underlayer film-forming composition may contain no curing catalyst. However, the composition preferably contains a curing catalyst (component [D]).

The curing catalyst may be, for example, an ammonium salt, a phosphine compound, a phosphonium salt, or a sulfonium salt. The salt described below as an example of a curing catalyst may be added in the form of a salt, or may be a compound that forms a salt in the composition (i.e. a compound that forms a salt in the system, but is in a form different from the salt during addition).

Examples of the ammonium salt include a quaternary ammonium salt having a structure represented by the Formula (D-1): 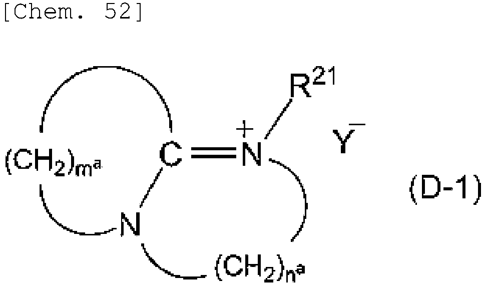
wherein m^{a} represents an integer of 2 to 11, n^{a} represents an integer of 2 to 3, R²¹ represents an alkyl group, an aryl group, or an aralkyl group, and Y⁻ represents an anion;
a quaternary ammonium salt having a structure represented by the Formula (D-2):
   [Chem. 53]

   R²²R²³R²⁴R²⁵N⁺Y⁻ (D-2)
wherein R²², R²³, R²⁴, and R²⁵ each independently represent an alkyl group, an aryl group, or an aralkyl group, Y⁻ represents an anion, and R²², R²³, R²⁴, and R²⁵ are each bonded to the nitrogen atom;
a quaternary ammonium salt having a structure represented by the Formula (D-3): 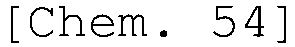 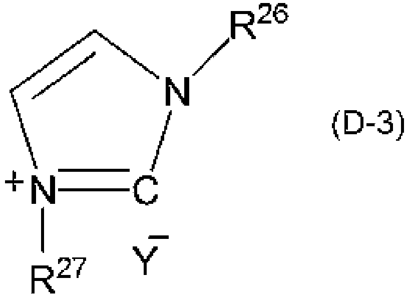
wherein R²⁶ and R²⁷ each independently represent an alkyl group, an aryl group, or an aralkyl group, and Y⁻ represents an anion;
a quaternary ammonium salt having a structure represented by the Formula (D-4): 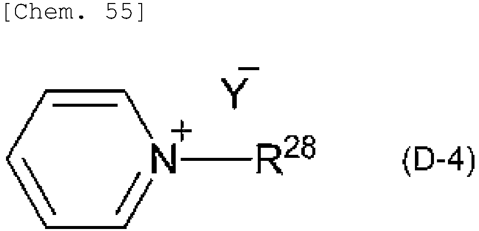
wherein R²⁸ represents an alkyl group, an aryl group, or an aralkyl group, and Y⁻ represents an anion;
a quaternary ammonium salt having a structure represented by the Formula (D-5): 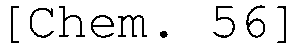 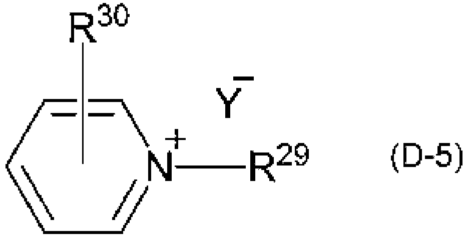
wherein R²⁹ and R³⁰ each independently represent an alkyl group, an aryl group, or an aralkyl group, and Y⁻ represents an anion; and
a tertiary ammonium salt having a structure represented by the Formula (D-6): 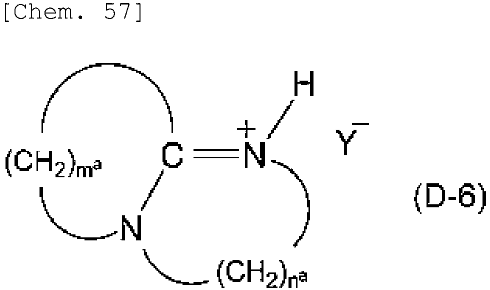
wherein m^{a} represents an integer of 2 to 11, n^{a} represents an integer of 2 to 3, and Y⁻ represents an anion.

Examples of the phosphonium salt include a quaternary phosphonium salt represented by the Formula (D-7):
[Chem. 58]

R³¹R³²R³³R³⁴P⁺Y⁻ (D-7)

wherein R³¹, R³², R³³, and R³⁴ each independently represent an alkyl group, an aryl group, or an aralkyl group, Y⁻ represents an anion, and R³¹, R³², R³³, and R³⁴ are each bonded to the phosphorus atom.

Examples of the sulfonium salt include a tertiary sulfonium salt represented by the Formula (D-8):
[Chem. 59]

R³⁵R³⁶R³⁷S⁺Y⁻ (D-8)

wherein R³⁵, R³⁶, and R³⁷ each independently represent an alkyl group, an aryl group, or an aralkyl group, Y⁻ represents an anion, and R³⁵, R³⁶, and R³⁷ are each bonded to the sulfur atom.

The compound of the Formula (D-1) is a quaternary ammonium salt derived from an amine, where m^{a} represents an integer of 2 to 11, and n^{a} represents an integer of 2 to 3. R²¹ of this quaternary ammonium salt represents, for example, an alkyl group having 1 to 18 and preferably 2 to 10 carbon atoms, an aryl group having 6 to 18 carbon atoms, or an aralkyl group having 7 to 18 carbon atoms, and examples thereof include a linear alkyl group such as an ethyl group, a propyl group, or a butyl group, a benzyl group, a cyclohexyl group, a cyclohexylmethyl group, and a dicyclopentadienyl group. Further, examples of the anion (Y⁻) include halide ions, such as chlorine ion (Cl⁻), bromine ion (Br⁻), and iodine ion (I⁻); and acid groups, such as carboxylate (-COO⁻), sulfonate (-SO₃⁻), and alcoholate (-O⁻).

The compound of the Formula (D-2) is a quaternary ammonium salt represented by R²²R²³R²⁴R²⁵N+Y-. R²², R²³, R²⁴, and R²⁵ of this quaternary ammonium salt are, for example, an alkyl group having 1 to 18 carbon atoms such as an ethyl group, a propyl group, a butyl group, a cyclohexyl group, and a cyclohexylmethyl group, an aryl group having 6 to 18 carbon atoms such as a phenyl group, or an aralkyl group having 7 to 18 carbon atoms such as a benzyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). The quaternary ammonium salt is commercially available, and examples of the quaternary ammonium salt include tetramethylammonium acetate, tetrabutylammonium acetate, triethylbenzylammonium chloride, triethylbenzylammonium bromide, trioctylmethylammonium chloride, tributylbenzylammonium chloride, and trimethylbenzylammonium chloride.

The compound of the Formula (D-3) is a quaternary ammonium salt derived from 1-substituted imidazole. The carbon atom number of each of R²⁶ and R²⁷ is, for example, 1 to 18, and the total number of carbon atoms of R²⁶ and R²⁷ is preferably 7 or more. Examples of R²⁶ include an alkyl group such as a methyl group, an ethyl group, and a propyl group, an aryl group such as a phenyl group, and an aralkyl group such as a benzyl group, and examples of R²⁷ include an aralkyl group such as a benzyl group, and an alkyl group such as an octyl group and an octadecyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between an imidazole compound (e.g. 1-methylimidazole or 1-benzylimidazole) and an aralkyl halide, an alkyl halide, or an aryl halide, such as benzyl bromide, methyl bromide, or benzene bromide.

The compound of the Formula (D-4) is a quaternary ammonium salt derived from pyridine. R²⁸ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include butyl group, octyl group, benzyl group, and lauryl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between pyridine and an alkyl halide or an aryl halide, such as lauryl chloride, benzyl chloride, benzyl bromide, methyl bromide, or octyl bromide. Examples of this compound include N-laurylpyridinium chloride and N-benzylpyridinium bromide.

The compound of the Formula (D-5) is a quaternary ammonium salt derived from a substituted pyridine, such as picoline. R²⁹ is, for example, an alkyl group having 1 to 18 carbon atoms, preferably 4 to 18 carbon atoms, an aryl group having 6 to 18 carbon atoms, or an aralkyl group having 7 to 18 carbon atoms. Examples thereof include methyl group, octyl group, lauryl group, and benzyl group. R³⁰ is, for example, an alkyl group having 1 to 18 carbon atoms, an aryl group having 6 to 18 carbon atoms, or an aralkyl group having 7 to 18 carbon atoms, and for example, when the compound represented by the Formula (D-5) is quaternary ammonium derived from picoline, R³⁰ is a methyl group. Examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), and alcoholate (-O⁻). Although this compound is commercially available, the compound may be produced through, for example, reaction between a substituted pyridine (e.g. picoline) and an alkyl halide or an aryl halide, such as methyl bromide, octyl bromide, lauryl chloride, benzyl chloride, or benzyl bromide. Examples of this compound include N-benzylpicolinium chloride, N-benzylpicolinium bromide, and N-laurylpicolinium chloride.

The compound of the Formula (D-6) is a tertiary ammonium salt derived from an amine, where m^{a} represents an integer of 2 to 11, and n^{a} represents 2 or 3. Further, examples of the anion (Y⁻) include halide ions, such as chlorine ion (Cl⁻), bromine ion (Br⁻), and iodine ion (I⁻); and acid groups, such as carboxylate (-COO⁻), sulfonate (-SO₃⁻), and alcoholate (-O⁻). The compound may be produced through reaction between an amine and a weak acid, such as a carboxylic acid or phenol. Examples of the carboxylic acid include formic acid and acetic acid. When formic acid is used, the anion (Y⁻) is (HCOO⁻). When acetic acid is used, the anion (Y⁻) is (CH₃COO⁻). When phenol is used, the anion (Y⁻) is (C₆H₅O⁻).

The compound of the Formula (D-7) is a quaternary phosphonium salt having a structure of R³¹R³²R³³R³⁴P+Y-. R³¹, R³², R³³, and R³⁴ are, for example, an alkyl group having 1 to 18 carbon atoms such as an ethyl group, a propyl group, a butyl group, or cyclohexylmethyl, an aryl group having 6 to 18 carbon atoms such as a phenyl group, or an aralkyl group having 7 to 18 carbon atoms such as a benzyl group, preferably three of the four substituent groups R³¹ to R³⁴ are an unsubstituted phenyl group or a substituted phenyl group, and for example, a phenyl group or a tolyl group can be exemplified, and the remaining one is an alkyl group having 1 to 18 carbon atoms, an aryl group having 6 to 18 carbon atoms, or an aralkyl group having 7 to 18 carbon atoms. Further, examples of the anion (Y⁻) include halide ions, such as chlorine ion (Cl⁻), bromine ion (Br⁻), and iodine ion (I⁻); and acid groups, such as carboxylate (-COO⁻), sulfonate (-SO₃⁻) , and alcoholate (-O⁻). This compound is commercially available, and examples of the compound include tetraalkylphosphonium halides, such as tetra-n-butylphosphonium halide and tetra-n-propylphosphonium halide; trialkylbenzylphosphonium halides, such as triethylbenzylphosphonium halide; triphenylmonoalkylphosphonium halides, such as triphenylmethylphosphonium halide and triphenylethylphosphonium halide; triphenylbenzylphosphonium halide; tetraphenylphosphonium halide; tritolylmonoarylphosphonium halide; or tritolylmonoalkylphosphonium halide, where the halogen atom is a chlorine atom or a bromine atom. Particularly preferred are triphenylmonoalkylphosphonium halides, such as triphenylmethylphosphonium halide and triphenylethylphosphonium halide; triphenylmonoarylphosphonium halides, such as triphenylbenzylphosphonium halide; tritolylmonoarylphosphonium halides, such as tritolylmonophenylphosphonium halide; and tritolylmonoalkylphosphonium halides, such as tritolylmonomethylphosphonium halide (where the halogen atom is a chlorine atom or a bromine atom).

Examples of the phosphine compound include primary phosphines, such as methylphosphine, ethylphosphine, propylphosphine, isopropylphosphine, isobutylphosphine, and phenylphosphine; secondary phosphines, such as dimethylphosphine, diethylphosphine, diisopropylphosphine, diisoamylphosphine, and diphenylphosphine; and tertiary phosphines, such as trimethylphosphine, triethylphosphine, triphenylphosphine, methyldiphenylphosphine, and dimethylphenylphosphine.

The compound of the Formula (D-8) is a tertiary sulfonium salt having a structure of R³⁵R³⁶R³⁷S⁺Y⁻. R³⁵, R³⁶, and R³⁷ are, for example, an alkyl group having 1 to 18 carbon atoms such as an ethyl group, a propyl group, a butyl group, or cyclohexylmethyl, an aryl group having 6 to 18 carbon atoms such as a phenyl group, or an aralkyl group having 7 to 18 carbon atoms such as a benzyl group, preferably two of the three substituent groups R³⁵ to R³⁷ are an unsubstituted phenyl group or a substituted phenyl group, and for example, a phenyl group or a tolyl group can be exemplified, and the remaining one is an alkyl group having 1 to 18 carbon atoms, an aryl group having 6 to 18 carbon atoms, or an aralkyl group having 7 to 18 carbon atoms. In addition, examples of the anion (Y⁻) include halide ions such as a chlorine ion (Cl⁻), a bromine ion (Br⁻), and an iodine ion (I⁻), and acid groups such as carboxylate (-COO⁻), sulfonate (-SO₃⁻), alcoholate (-O⁻), maleate anion, and nitrate anion. This compound is commercially available, and examples of the compound include trialkylsulfonium halides, such as tri-n-butylsulfonium halide and tri-n-propylsulfonium halide; dialkylbenzylsulfonium halides, such as diethylbenzylsulfonium halide; diphenylmonoalkylsulfonium halides, such as diphenylmethylsulfonium halide and diphenylethylsulfonium halide; triphenylsulfonium halides, where the halogen atom is a chlorine atom or a bromine atom; trialkylsulfonium carboxylates, such as tri-n-butylsulfonium carboxylate and tri-n-propylsulfonium carboxylate; dialkylbenzylsulfonium carboxylates, such as diethylbenzylsulfonium carboxylate; diphenylmonoalkylsulfonium carboxylates, such as diphenylmethylsulfonium carboxylate and diphenylethylsulfonium carboxylate; and triphenylsulfonium carboxylate. Triphenylsulfonium halide and triphenylsulfonium carboxylate are preferably used.

In addition, a nitrogen-containing silane compound may be added as a curing catalyst. Examples of the nitrogen-containing silane compound include silane compounds containing an imidazole ring, such as N-(3-triethoxysilylpropyl)-4,5-dihydroimidazole.

The content of the curing catalyst [D] in the silicon-containing resist underlayer film-forming composition according to the first embodiment is preferably 0.1 to 30 parts by mass, more preferably 0.5 to 25 parts by mass, and still more preferably 1 to 20 parts by mass relative to 100 parts by mass of the polysiloxane [A] from the viewpoint of more sufficiently achieving the effects of the present invention.

The content of the curing catalyst [D] in the silicon-containing resist underlayer film-forming composition according to the second embodiment is preferably 0.1 to 30 parts by mass, more preferably 0.5 to 25 parts by mass, and still more preferably 1 to 20 parts by mass relative to 100 parts by mass of the polysiloxane [A'] from the viewpoint of more sufficiently achieving the effects of the present invention.

### <Component [E]: Nitric Acid>

The silicon-containing resist underlayer film-forming composition preferably contains nitric acid [E].

Nitric acid [E] may be added during preparation of the silicon-containing resist underlayer film-forming composition. However, nitric acid may be used as a hydrolysis catalyst or used for capping of silanol groups with an alcohol in the production of the polysiloxane described above, and may remain in the resultant polysiloxane varnish.

The amount of the nitric acid [E] (amount of residual nitric acid) added may be, for example, 0.0001 mass% to 1 mass%, 0.001 mass% to 0.1 mass%, or 0.005 mass% to 0.05 mass% relative to the total mass of the silicon-containing resist underlayer film-forming composition.

### <Additional Additives>

In the silicon-containing resist underlayer film-forming composition, various additives can be blended depending on the use of the composition.

Examples of the additive include known additives blended in a material (composition) for forming various films that can be used for manufacturing a semiconductor element, such as a resist underlayer film, an antireflection film, and a pattern reversal film, such as a crosslinking agent, a crosslinking catalyst, a stabilizer (organic acid, water, alcohols, or the like), an organic polymer, an acid generator, a surfactant (nonionic surfactant, anionic surfactant, cationic surfactant, silicon-based surfactant, fluorine-based surfactant, UV-curable surfactant, or the like), a pH adjuster, a metal oxide, a rheology controlling agent, and an adhesion aid.

Hereinafter, various additives will be exemplified, but the additives are not limited thereto.

### <<Stabilizer>>

The stabilizer may be added for the purpose of stabilizing the hydrolysis condensate of the hydrolyzable silane, and as a specific example thereof, an organic acid, water, alcohol, or a combination thereof may be added.

Examples of the organic acid include an oxalic acid, a malonic acid, a methylmalonic acid, a succinic acid, a maleic acid, a malic acid, a tartaric acid, a phthalic acid, a citric acid, a glutaric acid, a lactic acid, and a salicylic acid. Among them, an oxalic acid and a maleic acid are preferable. When the organic acid is added, the addition amount thereof is 0.1 to 5.0 mass% with respect to the hydrolysis condensate of the hydrolyzable silane. These organic acids can also serve as pH adjusters.

As the water, pure water, ultrapure water, ion exchanged water, or the like may be used. When pure water, ultrapure water, or ion exchanged water is used, the amount of the water added can be 1 to 20 parts by mass relative to 100 parts by mass of the silicon-containing resist underlayer film-forming composition.

The alcohol is preferably an alcohol that is easily scattered by heating after the application, and examples of the alcohol include methanol, ethanol, propanol, i-propanol, and butanol. When an alcohol is added, the amount of the alcohol added may be 1 to 20 parts by mass relative to 100 parts by mass of the silicon-containing resist underlayer film-forming composition.

### <<Organic Polymer>>

Addition of the organic polymer to the silicon-containing resist underlayer film-forming composition enables adjustment of the dry etching rate (the amount of reduction in film thickness per unit time), attenuation coefficient, refractive index, and the like of a film (resist underlayer film) formed from the composition. The organic polymer is not particularly limited, and is appropriately selected from various organic polymers (polycondensation polymer and addition polymerization polymer) depending on the purpose of addition thereof.

Specific examples thereof include addition polymerization polymers and polycondensation polymers such as polyester, polystyrene, polyimide, an acrylic polymer, a methacrylic polymer, polyvinyl ether, phenol novolac, naphthol novolac, polyether, polyamide, and polycarbonate.

In the present invention, an organic polymer containing an aromatic ring or a heteroaromatic ring such as a benzene ring, a naphthalene ring, an anthracene ring, a triazine ring, a quinoline ring, or a quinoxaline ring, which functions as a light absorption site, can also be suitably used when such a function is required. Specific examples of such an organic polymer include, but are not limited to, addition polymerization polymers containing, as structural units, addition polymerizable monomers, such as benzyl acrylate, benzyl methacrylate, phenyl acrylate, naphthyl acrylate, anthryl methacrylate, anthryl methyl methacrylate, styrene, hydroxystyrene, benzyl vinyl ether, and N-phenylmaleimide, and condensation polycondensation polymers, such as phenol novolac and naphthol novolac.

When an addition polymerization polymer is used as an organic polymer, the polymer may be either a homopolymer or a copolymer.

An addition polymerizable monomer is used for the production of the addition polymerization polymer. Specific examples of the addition polymerizable monomer include, but are not limited to, acrylic acid, methacrylic acid, an acrylate ester compound, a methacrylate ester compound, an acrylamide compound, a methacrylamide compound, a vinyl compound, a styrene compound, a maleimide compound, maleic anhydride, and acrylonitrile.

Specific examples of the acrylate ester compound include, but are not limited to, methyl acrylate, ethyl acrylate, normal hexyl acrylate, i-propyl acrylate, cyclohexyl acrylate, benzyl acrylate, phenyl acrylate, anthrylmethyl acrylate, 2-hydroxyethyl acrylate, 3-chloro-2-hydroxypropyl acrylate, 2-hydroxypropyl acrylate, 2,2,2-trifluoroethyl acrylate, 2,2,2-trichloroethyl acrylate, 2-bromoethyl acrylate, 4-hydroxybutyl acrylate, 2-methoxyethyl acrylate, tetrahydrofurfuryl acrylate, 2-methyl-2-adamantyl acrylate, 5-acryloyloxy-6-hydroxynorbornene-2-carboxylic-6-lactone, 3-acryloxypropyltriethoxysilane, and glycidyl acrylate.

Specific examples of the methacrylate ester compound include, but are not limited to, methyl methacrylate, ethyl methacrylate, normal hexyl methacrylate, i-propyl methacrylate, cyclohexyl methacrylate, benzyl methacrylate, phenyl methacrylate, anthrylmethyl methacrylate, 2-hydroxyethyl methacrylate, 2-hydroxypropyl methacrylate, 2,2,2-trifluoroethyl methacrylate, 2,2,2-trichloroethyl methacrylate, 2-bromoethyl methacrylate, 4-hydroxybutyl methacrylate, 2-methoxyethyl methacrylate, tetrahydrofurfuryl methacrylate, 2-methyl-2-adamantyl methacrylate, 5-methacryloyloxy-6-hydroxynorbornene-2-carboxylic-6-lactone, 3-methacryloxypropyltriethoxysilane, glycidyl methacrylate, 2-phenylethyl methacrylate, hydroxyphenyl methacrylate, and bromophenyl methacrylate.

Specific examples of the acrylamide compound include, but are not limited to, acrylamide, N-methylacrylamide, N-ethylacrylamide, N-benzylacrylamide, N-phenylacrylamide, N,N-dimethylacrylamide, and N-anthrylacrylamide.

Specific examples of the methacrylamide compound include, but are not limited to, methacrylamide, N-methylmethacrylamide, N-ethylmethacrylamide, N-benzylmethacrylamide, N-phenylmethacrylamide, N,N-dimethylmethacrylamide, and N-anthrylmethacrylamide.

Specific examples of the vinyl compound include, but are not limited to, vinyl alcohol, 2-hydroxyethyl vinyl ether, methyl vinyl ether, ethyl vinyl ether, benzyl vinyl ether, vinyl acetic acid, vinyltrimethoxysilane, 2-chloroethyl vinyl ether, 2-methoxyethyl vinyl ether, vinylnaphthalene, and vinylanthracene.

Specific examples of the styrene compound include, but are not limited to, styrene, hydroxystyrene, chlorostyrene, bromostyrene, methoxystyrene, cyanostyrene, and acetylstyrene.

Specific examples of the maleimide compound include, but are not limited to, maleimide, N-methylmaleimide, N-phenylmaleimide, N-cyclohexylmaleimide, N-benzylmaleimide, and N-hydroxyethylmaleimide.

When a polycondensation polymer is used as the polymer, the polymer is, for example, a polycondensation polymer composed of a glycol compound and a dicarboxylic acid compound. Examples of the glycol compound include diethylene glycol, hexamethylene glycol, and butylene glycol. Examples of the dicarboxylic acid compound include succinic acid, adipic acid, terephthalic acid, and maleic anhydride. Further, examples of the polymer include, but are not limited to, polyesters, polyamides, and polyimides, such as polypyromellitimide, poly(p-phenyleneterephthalamide), polybutylene terephthalate, and polyethylene terephthalate.

When the organic polymer contains a hydroxy group, the hydroxy group may be crosslinked with a hydrolysis condensate, or the like.

The organic polymer may ordinarily have a weight average molecular weight of 1,000 to 1,000,000. When an organic polymer is blended, the weight average molecular weight thereof can be set to, for example, 3,000 to 300,000, or 5,000 to 300,000, or 10,000 to 200,000 from the viewpoint of sufficiently obtaining the effect of the function as a polymer and preventing precipitation in the composition.

The organic polymer may be used singly or in combination of two or more kinds thereof.

When the silicon-containing resist underlayer film-forming composition contains an organic polymer, the content cannot be univocally determined, since the content is appropriately determined in consideration of the function of the organic polymer, or the like, and the content may usually be 1 to 200 mass% relative to polysiloxane [A] and polysiloxane [A'], from the viewpoint of, for example, suppressing the precipitation in the composition, the content may be, for example, 100 mass% or less, and is preferably 50 mass% or less, more preferably 30 mass% or less, and from the viewpoint of, for example, sufficiently achieving the effect, the content may be, for example, 5 mass% or more, and preferably 10 mass% or more, more preferably 30 mass% or more.

### <<Acid Generator>>

Examples of the acid generator include a thermal acid generator and a photoacid generator, and a photoacid generator may be preferably used.

Examples of the photoacid generator include, but are not limited to, an onium salt compound, a sulfonimide compound, and a disulfonyldiazomethane compound. The photoacid generator may also function as a curing catalyst depending on the type thereof, for example, a nitrate salt, a carboxylate salt (e.g. maleate), or a hydrochloride salt of an onium salt compound described below.

Examples of the thermal acid generator include, but are not limited to, tetramethylammonium nitrate.

Specific examples of the onium salt compound include, but are not limited to, iodonium salt compounds, such as diphenyliodonium hexafluorophosphate, diphenyliodonium trifluoromethanesulfonate, diphenyliodonium nonafluoro normal butanesulfonate, diphenyliodonium perfluoro normal octanesulfonate, diphenyliodonium camphorsulfonate, bis(4-t-butylphenyl)iodonium camphorsulfonate, and bis(4-t-butylphenyl)iodonium trifluoromethanesulfonate; and sulfonium salt compounds, such as triphenylsulfonium hexafluoroantimonate, triphenylsulfonium nonafluoro normal butanesulfonate, triphenylsulfonium camphorsulfonate, triphenylsulfonium trifluoromethanesulfonate, triphenylsulfonium nitrate, triphenylsulfonium trifluoroacetate, triphenylsulfonium maleate, and triphenylsulfonium chloride.

Specific examples of the sulfonimide compound include, but are not limited to, N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Specific examples of the disulfonyldiazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

When the silicon-containing resist underlayer film-forming composition contains an acid generator, the content cannot be univocally determined, since the content is appropriately determined in consideration of, for example, the type of the acid generator, the content is usually 0.01 to 5 mass% relative to polysiloxane [A] and polysiloxane [A'], from the viewpoint of, for example, suppressing the precipitation of the acid generator in the composition, the content is preferably 3 mass% or less, more preferably 1 mass% or less, and from the viewpoint of, for example, sufficiently achieving the effect, the content is preferably 0.1 mass% or more, more preferably 0.5 mass% or more.

The acid generators may be used singly or in combination of two or more kinds thereof. A photoacid generator and a thermal acid generator may be used in combination.

### <<Surfactant>>

When the silicon-containing resist underlayer film-forming composition is applied to a substrate or an organic underlayer film, the surfactant is effective for suppressing generation of pinholes, striations, and the like. Examples of the surfactant include a nonionic surfactant, an anionic surfactant, a cationic surfactant, a silicon-based surfactant, a fluorine-based surfactant, and a UV-curable surfactant. Specific examples of the surfactant include, but are not limited to, nonionic surfactants, for example, polyoxyethylene alkyl ethers, such as polyoxyethylene lauryl ether, polyoxyethylene stearyl ether, polyoxyethylene cetyl ether, and polyoxyethylene oleyl ether, polyoxyethylene alkylaryl ethers, such as polyoxyethylene octylphenol ether and polyoxyethylene nonylphenol ether, polyoxyethylene-polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as trade names EFTOP (registered trademark) EF301, EF303, and EF352 (manufactured by Mitsubishi Materials Electronic Chemicals Co., Ltd. (former Tohkem Products Corporation)), trade names MEGAFACE (registered trademark) F171, F173, R-08, R-30, R-30N, and R-40LM (manufactured by DIC Corporation), Fluorad FC430 and FC431 (manufactured by 3M Japan Limited), trade name Asahi Guard (registered trademark) AG710 (manufactured by AGC Inc.), and trade names SURFLON (registered trademark) S-382, SC101, SC102, SC103, SC104, SC105, and SC106 (manufactured by AGC Seimi Chemical Co., Ltd.); and Organosiloxane Polymer KP341 (manufactured by Shin-Etsu Chemical Co., Ltd.).

The surfactants may be used singly or in combination of two or more kinds thereof.

When the silicon-containing resist underlayer film-forming composition contains a surfactant, the content is usually 0.0001 to 5 mass%, preferably 0.001 to 4 mass%, and more preferably 0.01 to 3 mass% with respect to polysiloxane [A] or polysiloxane [A'].

### <<Rheology Controlling Agent>>

The rheology controlling agent is added mainly for the purpose of improving the fluidity of the silicon-containing resist underlayer film-forming composition, and particularly for the purpose of improving the uniformity of the film thickness of a film formed in a baking process or improving the fillability of the composition in the interior of a hole. Specific examples include phthalic acid derivatives, such as dimethyl phthalate, diethyl phthalate, di-i-butyl phthalate, dihexyl phthalate, and butyl-i-decyl phthalate; adipic acid derivatives, such as di-normal butyl adipate, di-i-butyl adipate, di-i-octyl adipate, and octyldecyl adipate; maleic acid derivatives, such as di-normal butyl maleate, diethyl maleate, and dinonyl maleate; oleic acid derivatives, such as methyl oleate, butyl oleate, and tetrahydrofurfuryl oleate; and stearic acid derivatives, such as normal butyl stearate and glyceryl stearate.

When such a rheology controlling agent is used, the amount of the rheology controlling agent added is ordinarily less than 30 mass% relative to all film-forming components of the silicon-containing resist underlayer film-forming composition.

### <<Adhesion Aid>>

The adhesion aid is added mainly for the purpose of improving the adhesion between a substrate, an organic underlayer film, or a resist, and a film (resist underlayer film) formed from the silicon-containing resist underlayer film-forming composition, and particularly for the purpose of suppressing and preventing removal of the resist during development. Specific examples of the adhesion aid include chlorosilanes, such as trimethylchlorosilane, dimethylvinylchlorosilane, methyldiphenylchlorosilane, and chloromethyldimethylchlorosilane; alkoxysilanes, such as trimethylmethoxysilane, dimethyldiethoxysilane, methyldimethoxysilane, and dimethylvinylethoxysilane; silazanes, such as hexamethyldisilazane, N,N'-bis(trimethylsilyl)urea, dimethyltrimethylsilylamine, and trimethylsilyl imidazole; other silanes, such as γ-chloropropyltrimethoxysilane, γ-aminopropyltriethoxysilane, and γ-glycidoxypropyltrimethoxysilane; heterocyclic compounds, such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, mercaptopyrimidine; and urea or thiourea compounds, such as 1,1-dimethylurea and 1,3-dimethylurea.

When such an adhesion aid is used, the amount of the adhesion aid added is ordinarily less than 5 mass%, preferably less than 2 mass%, relative to the film-forming components of the silicon-containing resist underlayer film-forming composition.

### <<pH Adjuster>>

In addition, the pH adjuster may be an acid having one or two or more carboxylic acid groups, for example, an organic acid described above in <<Stabilizer>>. When a pH adjuster is used, the amount of the pH adjuster added may be 0.01 to 20 parts by mass, 0.01 to 10 parts by mass, or 0.01 to 5 parts by mass relative to 100 parts by mass of the polysiloxane [A] or the polysiloxane [A'].

### <<Metal oxide>>

Examples of the metal oxide that may be added to the silicon-containing resist underlayer film-forming composition include, but are not limited to, oxides of a combination of one or more selected from among metals, such as tin (Sn), titanium (Ti), aluminum (Al), zirconium (Zr), zinc (Zn), niobium (Nb), tantalum (Ta), and W (tungsten), and semimetals, such as boron (B), silicon (Si), germanium (Ge), arsenic (As), antimony (Sb), and tellurium (Te).

The concentration of the film-forming component in the silicon-containing resist underlayer film-forming composition may be, for example, 0.1 to 50 mass%, 0.1 to 30 mass%, 0.1 to 25 mass%, or 0.5 to 20.0 mass% relative to the total amount of the composition.

The content of polysiloxane [A] or polysiloxane [A'] in the film-forming component is usually 20 mass% to 100 mass%, but from the viewpoint of obtaining the effect of the present invention with good reproducibility or the like, the lower limit thereof is preferably 50 mass%, more preferably 60 mass%, still more preferably 70 mass%, and yet still more preferably 80 mass%, the upper limit thereof is preferably 99 mass%, and the rest thereof can be an additive described below.

Further, the silicon-containing resist underlayer film-forming composition preferably has a pH of 2 to 5, more preferably a pH of 3 to 4.

The silicon-containing resist underlayer film-forming composition according to the first embodiment can be produced by mixing the polysiloxane [A], the solvent [C], and, if desired, an additional component. At this time, a solution containing polysiloxane [A] may be prepared in advance, and this solution may be mixed with solvent [C] and other components.

The mixing order is not particularly limited. For example, solvent [C] may be added to and mixed with the solution containing polysiloxane [A], and the other components may be added to the mixture, or the solution containing polysiloxane [A], solvent [C], and the other components may be simultaneously mixed.

If necessary, solvent [C] may be further added at the end, or some components relatively soluble in solvent [C] may not be included in the mixture, and the components may be added at the end, but, from the viewpoint of suppressing aggregation and separation of the constituent components and preparing a composition excellent in uniformity with good reproducibility, it is preferable to prepare a solution in which polysiloxane [A] is dissolved well in advance, and prepare a composition using the solution. Note that attention is paid to the fact that polysiloxane [A] may aggregate or precipitate when mixed, depending on the type and amount of solvent [C] to be mixed together, the amount and properties of other components, and the like. In addition, when a composition is prepared using the solution in which polysiloxane [A] is dissolved, attention is also paid to the fact that it is necessary to determine the concentration of the solution of polysiloxane [A] and the use amount thereof so that polysiloxane [A] in the finally obtained composition is in a desired amount.

During preparation of the composition, the composition may be appropriately heated so long as the components are not decomposed or denatured.

The silicon-containing resist underlayer film-forming composition according to the second embodiment can be produced by mixing the polysiloxane [A'], the hydrolyzable silane (A) represented by the Formula (A-1) [B], the solvent [C], and, when an additional component is contained if desired, the additional component. In this case, a solution containing the polysiloxane [A'] may be prepared in advance, and this solution may be mixed with the hydrolyzable silane (A) represented by the Formula (A-1) [B], the solvent [C], and an additional component.

The mixing order is not particularly limited. For example, the hydrolyzable silane (A) represented by the Formula (A-1) [B] and the solvent [C] may be added to and mixed with a solution containing the polysiloxane [A'], and an additional component may be added to the resultant mixture. Alternatively, a solution containing the polysiloxane [A'], the hydrolyzable silane (A) represented by the Formula (A-1) [B], the solvent [C], and an additional component may be mixed simultaneously.

If necessary, solvent [C] may be further added at the end, or some components relatively soluble in solvent [C] may not be included in the mixture, and the components may be added at the end, but, from the viewpoint of suppressing aggregation and separation of the constituent components and preparing a composition excellent in uniformity with good reproducibility, it is preferable to prepare a solution in which polysiloxane [A'] is dissolved well in advance, and prepare a composition using the solution. It should be noted that the polysiloxane [A'] may be aggregated or precipitated when mixed with the hydrolyzable silane (A) represented by the Formula (A-1) [B] and the solvent [C], or an additional component, depending on, for example, the type or amount of the solvent [C], or the amount or nature of the additional component. In addition, when a composition is prepared using the solution in which polysiloxane [A'] is dissolved, attention is also paid to the fact that it is necessary to determine the concentration of the solution of polysiloxane [A'] and the use amount thereof so that polysiloxane [A'] in the finally obtained composition is in a desired amount.

During preparation of the composition, the composition may be appropriately heated so long as the components are not decomposed or denatured.

In the present invention, the silicon-containing resist underlayer film-forming composition may be filtered with a submicrometer-order filter or the like during production of the composition or after mixing of all the components. The type of the material of the filter used is not limited. For example, a nylon-made filter or a fluororesin-made filter may be used.

The silicon-containing resist underlayer film-forming composition of the present invention may be suitably used as a composition for forming a resist underlayer film used in a lithography process.

### (Resist underlayer film, semiconductor processing substrate, and method for forming a pattern, and method for producing semiconductor element)

The resist underlayer film of the present invention is a cured product of the silicon-containing resist underlayer film-forming composition of the present invention.

The semiconductor processing substrate of the present invention includes, for example, the silicon-containing resist underlayer film of the present invention.

The method for producing a semiconductor element of the present invention includes, for example,
a step of forming an organic underlayer film on a substrate;
a step of forming a resist underlayer film on the organic underlayer film using the silicon-containing resist underlayer film-forming composition of the present invention; and
a step of forming a metal-containing resist film on the resist underlayer film.

The method for forming a pattern of the present invention includes, for example,
a step of forming an organic underlayer film on a semiconductor substrate;
a step of forming a resist underlayer film by applying and baking the silicon-containing resist underlayer film-forming composition of the present invention on the organic underlayer film;
a step of forming a metal-containing resist film on the resist underlayer film;
a step of obtaining a resist pattern by exposing and developing the metal-containing resist film;
a step of etching the resist underlayer film by using the resist pattern as a mask; and
a step of etching the organic underlayer film by using the patterned resist underlayer film as a mask..

Hereinafter, as one aspect of the present invention, a semiconductor processing substrate, a method for forming a pattern, and a method for producing a semiconductor element using the silicon-containing resist underlayer film of the present invention or the silicon-containing resist underlayer film-forming composition of the present invention will be described.

First, the silicon-containing resist underlayer film-forming composition of the present invention is applied onto a substrate used for the production of a precise integrated circuit element [e.g. a semiconductor substrate such as a silicon wafer coated with a silicon oxide film, a silicon nitride film, or a silicon oxynitride film, a silicon nitride substrate, a quartz substrate, a glass substrate (including alkali-free glass, low alkali glass, or crystallized glass), a glass substrate coated with an ITO (indium tin oxide) film or an IZO (indium zinc oxide) film, a plastic (e.g. polyimide or PET) substrate, a substrate coated with a low dielectric constant material (low-k material), or a flexible substrate] by an appropriate application method with, for example, a spinner or a coater. Thereafter, the composition is cured through baking by heating means (e.g. a hot plate) to form a resist underlayer film. Hereinafter, in the present description, the resist underlayer film refers to the silicon-containing resist underlayer film of the present invention or a film formed from the silicon-containing resist underlayer film-forming composition of the present invention.

The baking conditions are appropriately selected from a baking temperature of 40°C to 400°C, or 80°C to 250°C, and a baking time of 0.3 minutes to 60 minutes. Preferably, the baking temperature is 150°C to 250°C, and the baking time is 0.5 minutes to 2 minutes.

The resist underlayer film formed here has a thickness of, for example, 10 nm to 1,000 nm, or 20 nm to 500 nm, or 50 nm to 300 nm, or 100 nm to 200 nm, or 10 to 150 nm.

As the silicon-containing resist underlayer film-forming composition used for formation of the resist underlayer film, the silicon-containing resist underlayer film-forming composition filtered through a nylon filter may be used. Here, the term "silicon-containing resist underlayer film-forming composition filtered through a nylon filter" refers to a composition that has been subjected to filtration with a nylon filter during production of the silicon-containing resist underlayer film-forming composition or after mixing all the components.

In one aspect of the present invention, the organic underlayer film is formed on the substrate, and then the resist underlayer film is formed on the organic underlayer film. In some cases, an aspect may be employed in which the organic underlayer film is not provided.

The organic underlayer film used here is not particularly limited, and can be arbitrarily selected and used from those conventionally used in a lithography process.

By adopting an aspect in which an organic underlayer film is provided on a substrate, a resist underlayer film is provided thereon, and a metal-containing resist film described later is provided thereon, the pattern width of the metal-containing resist film is narrowed, and even when the metal-containing resist film is thinly covered in order to prevent pattern collapse, the substrate can be processed by selecting an appropriate etching gas described later. For example, the resist underlayer film can be processed using a fluorine-based gas having a sufficiently high etching rate with respect to the metal-containing resist film as an etching gas, the organic underlayer film can be processed using an oxygen-based gas having a sufficiently high etching rate with respect to the resist underlayer film as an etching gas, and the substrate can be processed using a fluorine-based gas having a sufficiently high etching rate with respect to the organic underlayer film as an etching gas.

The substrate and application method usable in this process are the same as those described above.

Subsequently, for example, a layer of a metal-containing resist material (metal-containing resist film) is formed on the resist underlayer film. The metal-containing resist film can be formed by a well-known method. Specifically, the metal-containing resist film can be formed by applying a coating-type resist material (e.g. a composition for forming a metal-containing resist film) onto the resist underlayer film, and baking the resist material.

The metal-containing resist film has a thickness of, for example, 5 nm to 10,000 nm, or 5 nm to 1,000 nm, or 5 nm to 40 nm.

The metal-containing resist film is not particularly limited, and preferably has at least one element of Si, Ge, Sn, Ti, Zr, Hf, Al, and Co.

The metal-containing resist is also called a metal oxide resist (metal oxide resist (MOR)), and typical examples thereof include a tin oxide-based resist.

The material of the metal oxide resist is, for example, a coating composition containing a metal oxo-hydroxo network having an organic ligand through a metal carbon bond and/or a metal carboxylate bond described in JP 2019-113855 A.

In an example of the metal-containing resist, a peroxo ligand is used as a radiation-sensitive stabilizing ligand. Details of the peroxo based metal oxo-hydroxo compounds are described, for example, in paragraph [0011] of JP 2019-532489 A: Patent Literature. Examples of the Patent Literature include US 9,176,377 B2, US 2013/0224652 A1, US 9,310,684 B2, US 2016/0116839 A1, and US 15/291738 A.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein to the same extent as all the contents are specified.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as all the contents are specified. In JP 2017-116923 A, the metal-containing resist film in the present invention is referred to as a metal oxide-containing film.

Subsequently, light exposure is performed on the metal-containing resist film formed above the resist underlayer film through a predetermined mask (reticle). The light exposure may be performed using a KrF excimer laser (wavelength: 248 nm), an ArF excimer laser (wavelength: 193 nm), an F₂ excimer laser (wavelength: 157 nm), EUV (wavelength: 13.5 nm), electron beams, or the like.

After the exposure, post exposure bake may be performed as necessary. The post exposure bake is performed under appropriately selected conditions: a heating temperature of 70°C to 250°C and a heating time of 0.3 minutes to 10 minutes.

In the present invention, an organic solvent can be used as a developer. Development is performed with a developer (solvent) after light exposure. As a result, for example, when a metal-containing negative resist film is used, the metal-containing resist film in an unexposed portion is removed, and a pattern of the metal-containing resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Furthermore, a surfactant or the like may be added to these developers. Development conditions are appropriately selected from a temperature of 5°C to 50°C, and a time of 10 seconds to 600 seconds.

The resultant patterned metal-containing resist film (upper layer) is used as a protective film to remove the resist underlayer film (intermediate layer). Then, a film including the patterned metal-containing resist film and the patterned resist underlayer film (intermediate layer) is used as a protective film to remove the organic underlayer film (underlayer). Finally, the substrate is processed using the patterned resist underlayer film (intermediate layer) and the patterned organic underlayer film (underlayer) as protective films.

The resist underlayer film (intermediate layer) is removed (patterned) through dry etching by using the patterned metal-containing resist film (upper layer) as a protective film. The dry etching can be performed using any of gases, such as tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, and dichloroborane.

A halogen-based gas is preferably used for dry etching of the resist underlayer film. In dry etching using a halogen-based gas, it is basically difficult to remove the metal-containing resist film. On the other hand, the resist underlayer film rich in silicon atoms is quickly removed with a halogen-based gas. Therefore, a decrease in the film thickness of the metal-containing resist film due to dry etching of the resist underlayer film can be prevented. As a result, the metal-containing resist film can be used as a thin film. Thus, the dry etching of the resist underlayer film is preferably performed using a fluorine-containing gas. Examples of the fluorine-containing gas include tetrafluoromethane (CF₄), perfluorocyclobutane (C₄F₈), perfluoropropane (C₃F₈), trifluoromethane, and difluoromethane (CH₂F₂), but are not limited to.

When the organic underlayer film is present between the substrate and the resist underlayer film, a film including the patterned metal-containing resist film (upper layer) (if remains) and the patterned resist underlayer film (intermediate layer) is used as a protective film to remove (pattern) the organic underlayer film (underlayer). The organic underlayer film (underlayer) is preferably removed (patterned) by dry etching with an oxygen-containing gas (e.g. oxygen gas or oxygen/carbonyl sulfide (COS) mixed gas). This is because the resist underlayer film of the present invention, which contains numerous silicon atoms, is less likely to be removed by dry etching with an oxygen-containing gas.

Thereafter, the patterned resist underlayer film (intermediate layer) and, if desired, the patterned organic underlayer film (underlayer) are used as protective films to process (pattern) the (semiconductor) substrate. The (semiconductor) substrate is preferably processed (patterned) by dry etching with a fluorine-containing gas.

Examples of the fluorine-containing gas include tetrafluoromethane (CF₄), perfluorocyclobutane (C₄F₈), perfluoropropane (C₃F₈), trifluoromethane, and difluoromethane (CH₂F₂).

After the removal (patterning) of the organic underlayer film or after the processing (patterning) of the substrate, the resist underlayer film may be removed. The resist underlayer film may be removed by dry etching or wet etching (wet method).

The dry etching of the resist underlayer film is preferably performed with a fluorine-based gas as mentioned in the patterning, and examples thereof include tetrafluoromethane (CF₄), perfluorocyclobutane (C₄F₈), perfluoropropane (C₃F₈), trifluoromethane, and difluoromethane (CH₂F₂), but are not limited thereto.

Examples of a chemical liquid used for wet etching of the resist underlayer film include alkaline solutions such as dilute fluorinated acid (hydrofluoric acid), buffered fluorinated acid (mixed solution of HF and NH₄F), an aqueous solution containing hydrochloric acid and hydrogen peroxide (SC-2 chemical liquid), an aqueous solution containing sulfuric acid and hydrogen peroxide (SPM chemical liquid), an aqueous solution containing fluorinated acid and hydrogen peroxide (FPM chemical liquid), and an aqueous solution containing ammonia and hydrogen peroxide (SC-1 chemical liquid). Examples of the alkaline solution include, in addition to the ammonia hydrogen peroxide obtained by mixing ammonia, aqueous hydrogen peroxide, and water (SC-1 chemical liquid), an aqueous solution containing 1 to 99 mass% of ammonia, tetramethylammonium hydroxide (TMAH), tetraethylammonium hydroxide, tetrapropylammonium hydroxide, tetrabutylammonium hydroxide, choline hydroxide, benzyltrimethylammonium hydroxide, benzyltriethylammonium hydroxide, DBU (diazabicycloundecene), DBN (diazabicyclononene), hydroxylamine, 1-butyl-1-methylpyrrolidinium hydroxide, 1-propyl-1-methylpyrrolidinium hydroxide, 1-butyl-1-methylpiperidinium hydroxide, 1-propyl-1-methylpiperidinium hydroxide, mepiquat hydroxide, trimethylsulfonium hydroxide, a hydrazine, an ethylenediamine, or guanidine. These chemical liquids may be used in the form of mixture.

An organic anti-reflective coating may be formed on the resist underlayer film before formation of the metal-containing resist film. The composition used for formation of the anti-reflective coating is not particularly limited, and for example, the composition may be appropriately selected from anti-reflective coating compositions commonly used in a lithography process. The anti-reflective coating can be formed by a commonly used method, for example, application of the composition with a spinner or a coater, and baking of the composition.

In addition, the substrate to which the silicon-containing resist underlayer film-forming composition is applied may have an organic or inorganic anti-reflective coating formed thereon by, for example, a CVD process. The resist underlayer film may be formed on the anti-reflective coating. Even in a case where the resist underlayer film of the present invention is formed on the organic underlayer film formed on the substrate, the substrate used may have an organic or inorganic anti-reflective coating formed thereon by, for example, a CVD process.

The resist underlayer film formed from the silicon-containing resist underlayer film-forming composition may absorb light used in a lithography process depending on the wavelength of the light. In such a case, the resist underlayer film can function as an antireflection film having the effect of preventing reflection of light from the substrate.

Furthermore, the resist underlayer film can be used as, for example, a layer for preventing the interaction between the substrate and the metal-containing resist film; a layer having the function of preventing the adverse effect, on the substrate, of a material used for the metal-containing resist film or a substance generated during the exposure of the metal-containing resist film to light; a layer having the function of preventing diffusion of a substance generated from the substrate during heating and baking to the metal-containing resist film; and a barrier layer for reducing a poisoning effect of a dielectric layer of the semiconductor substrate on the metal-containing resist film.

The resist underlayer film can be applied to a substrate having via holes for use in a dual damascene process, and can be used as a hole filling material (embedding material) to fill up the holes. In addition, it can also be used as a planarizing material for planarizing the surface of a semiconductor substrate having irregularities.

In addition, the resist underlayer film of the present invention serves as an underlayer film for an EUV metal-containing resist film and, for example, can prevent reflection of exposure light undesirable for EUV exposure (wavelength 13.5 nm), for example, UV (ultraviolet) light or DUV (deep ultraviolet) light (ArF light and KrF light) from the substrate or the interface without intermixing with the EUV metal-containing resist film, in addition to the function as a hard mask. Therefore, in order to form an underlayer antireflection film of an EUV metal-containing resist film, the silicon-containing resist underlayer film-forming composition of the present invention can be suitably used. That is, reflection can be efficiently prevented as an underlayer of an EUV metal-containing resist film. When the resist underlayer film is used as an EUV resist underlayer film, the film can be processed in a similar manner to the photoresist underlayer film.

When the semiconductor processing substrate including the resist underlayer film of the present invention described above and a semiconductor substrate is used, the semiconductor substrate can be suitably processed.

In addition, according to the method for producing a semiconductor element, the method including a step of forming an organic underlayer film, a step of forming a resist underlayer film on the organic underlayer film using the silicon-containing resist underlayer film-forming composition of the present invention, and a step of forming a metal-containing resist film on the resist underlayer film, a high-precision semiconductor substrate can be processed with good reproducibility, and it is expected that a semiconductor element can be stably produced.

### Examples

Hereinafter, the present invention will be described more specifically with reference to Synthesis Examples and Examples, but the present invention is not limited to only the following Examples.

In the Examples, apparatuses and conditions used for analysis of the physical properties of samples are as follows.

### (1) Measurement of Molecular Weight

The molecular weight of the polysiloxane used in the present invention is determined by GPC analysis in terms of polystyrene.

The GPC analysis can be performed, for example, under the following conditions: GPC apparatus (trade name: HLC-8220GPC, manufactured by Tosoh Corporation), GPC columns (trade name: Shodex (registered trademark) KF803L, KF802, and KF801, manufactured by Showa Denko K.K.), column temperature of 40°C, tetrahydrofuran as an eluent (elution solvent), flow amount (flow rate) of 1.0 mL/min, and polystyrene (manufactured by Showa Denko K.K.) as a standard sample.

### [1] Synthesis of Polymer (Hydrolysis Condensate)

### (Synthesis Example 1)

A 300 ml flask was charged with 20.8 g of tetraethoxysilane, 5.1 g of methyltriethoxysilane, 3.3 g of 3-(trimethoxysilyl) propyl acrylate, and 43.9 g of propylene glycol monoethyl ether. While the resultant mixed solution was stirred with a magnetic stirrer, 18.0 g of a 0.2 M aqueous nitric acid solution was added dropwise to the mixed solution.

After the dropwise addition, the flask was transferred to an oil bath set at 60°C and the mixed solution was refluxed for 20 hours. Thereafter, ethanol, methanol, and water, i.e. reaction by-products, were distilled off under reduced pressure for concentration to obtain a hydrolysis condensate (polymer) solution.

Further, propylene glycol monoethyl ether was added to the solution to achieve a solvent proportion of propylene glycol monoethyl ether of 100% and a concentration of 20 mass% in terms of solid residue at 150°C. The resultant solution was subjected to filtration with a nylon-made filter (pore size: 0.1 µm). The resultant polymer was found to contain a structure represented by the following Formula (E1), and to have a weight average molecular weight Mw of 4,300 as determined by GPC in terms of polystyrene.

In the following chemical formula, the number attached to the side of the siloxane unit represents a molar ratio (total 100).

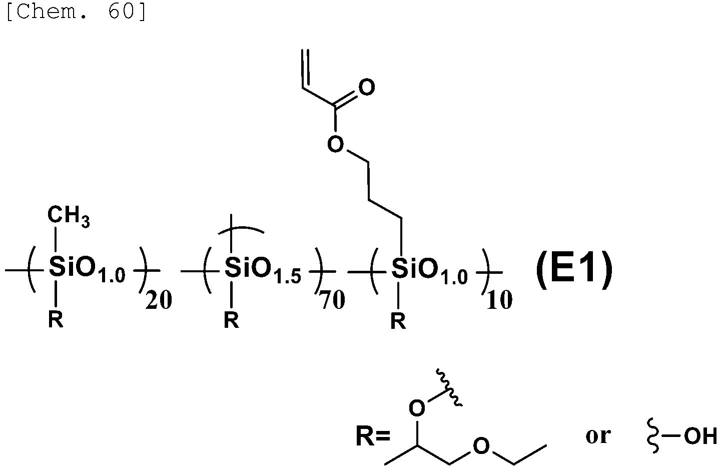

### (Synthesis Example 2)

A 300 ml flask was charged with 20.8 g of tetraethoxysilane, 5.1 g of methyltriethoxysilane, 3.5 g of 3-(trimethoxysilyl) propyl methacrylate, and 44.2 g of propylene glycol monoethyl ether. While the resultant mixed solution was stirred with a magnetic stirrer, 18.0 g of a 0.2 M aqueous nitric acid solution was added dropwise to the mixed solution.

After the dropwise addition, the flask was transferred to an oil bath set at 60°C and the mixed solution was refluxed for 20 hours. Thereafter, ethanol, methanol, and water, i.e. reaction by-products, were distilled off under reduced pressure for concentration to obtain a hydrolysis condensate (polymer) solution.

Further, propylene glycol monoethyl ether was added to the solution to achieve a solvent proportion of propylene glycol monoethyl ether of 100% and a concentration of 20 mass% in terms of solid residue at 150°C. The resultant solution was subjected to filtration with a nylon-made filter (pore size: 0.1 µm). The resultant polymer was found to contain a structure represented by the following Formula (E2), and to have a weight average molecular weight Mw of 3,400 as determined by GPC in terms of polystyrene.

In the following chemical formula, the number attached to the side of the siloxane unit represents a molar ratio (total 100).

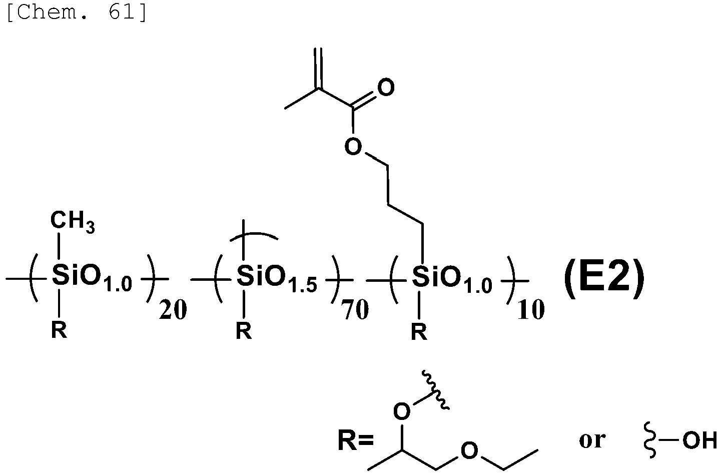

### (Synthesis Example 3)

A 300 ml flask was charged with 20.8 g of tetraethoxysilane, 5.1 g of methyltriethoxysilane, 3.2 g of trimethoxy(4-vinylphenyl)silane, and 43.7 g of propylene glycol monoethyl ether. While the resultant mixed solution was stirred with a magnetic stirrer, 18.0 g of 0.2 M aqueous nitric acid solution was added dropwise to the mixed solution.

After the dropwise addition, the flask was transferred to an oil bath set at 60°C and the mixed solution was refluxed for 20 hours. Thereafter, ethanol, methanol, and water, i.e. reaction by-products, were distilled off under reduced pressure for concentration to obtain a hydrolysis condensate (polymer) solution.

Further, propylene glycol monoethyl ether was added to the solution to achieve a solvent proportion of propylene glycol monoethyl ether of 100% and a concentration of 20 mass% in terms of solid residue at 150°C. The resultant solution was subjected to filtration with a nylon-made filter (pore size: 0.1 µm). The resultant polymer was found to contain a structure represented by the following Formula (E3), and to have a weight average molecular weight Mw of 2,300 as determined by GPC in terms of polystyrene.

In the following chemical formula, the number attached to the side of the siloxane unit represents a molar ratio (total 100).

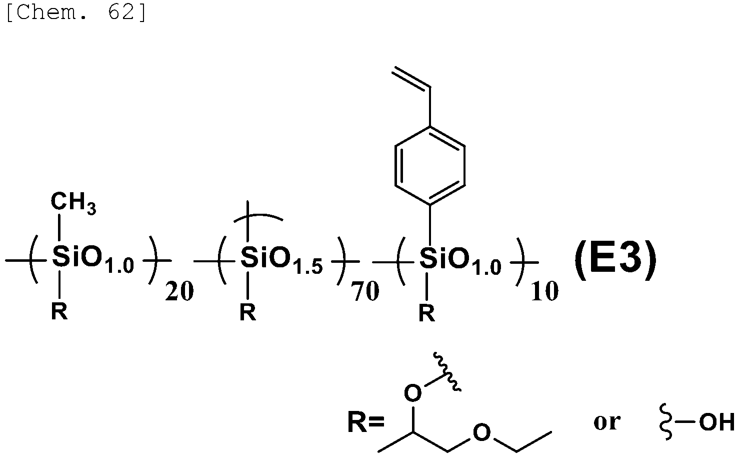

### (Synthesis Example 4)

A 300 ml flask was charged with 20.8 g of tetraethoxysilane, 5.1 g of methyltriethoxysilane, 2.3 g of allyltrimethoxysilane, and 42.4 g of propylene glycol monoethyl ether. While the resultant mixed solution was stirred with a magnetic stirrer, 18.0 g of 0.2 M aqueous nitric acid solution was added dropwise to the mixed solution.

After the dropwise addition, the flask was transferred to an oil bath set at 60°C and the mixed solution was refluxed for 20 hours. Thereafter, ethanol, methanol, and water, i.e. reaction by-products, were distilled off under reduced pressure for concentration to obtain a hydrolysis condensate (polymer) solution.

Further, propylene glycol monoethyl ether was added to the solution to achieve a solvent proportion of propylene glycol monoethyl ether of 100% and a concentration of 20 mass% in terms of solid residue at 150°C. The resultant solution was subjected to filtration with a nylon-made filter (pore size: 0.1 µm). The resultant polymer was found to contain a structure represented by the following Formula (E4), and to have a weight average molecular weight Mw of 3,400 as determined by GPC in terms of polystyrene.

In the following chemical formula, the number attached to the side of the siloxane unit represents a molar ratio (total 100).

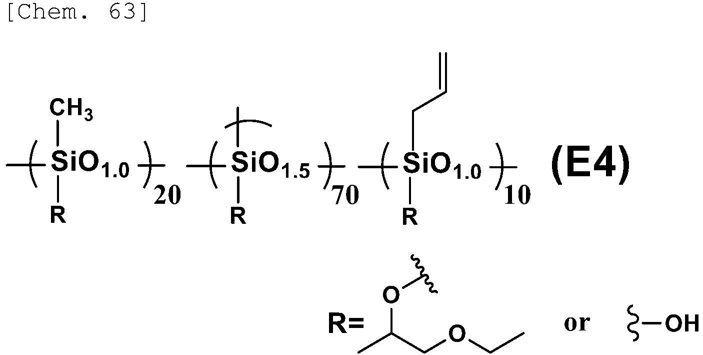

### (Comparative Synthesis Example 1)

In a 300 ml flask, 20.8 g of tetraethoxysilane, 7.6 g of methyltriethoxysilane, and 62.1 g of propylene glycol monoethyl ether were placed, and 8.4 g of a 0.2 M nitric acid aqueous solution was added dropwise thereto while the resulting mixed solution was stirred with a magnetic stirrer.

After the dropwise addition, the flask was transferred to an oil bath set at 60°C and the mixed solution was refluxed for 20 hours. Thereafter, ethanol and water as reaction by-products were distilled off under reduced pressure and the residue was concentrated to obtain a hydrolysis condensate (polymer) aqueous solution.

Further, propylene glycol monoethyl ether was added to the solution to achieve a solvent proportion of propylene glycol monoethyl ether of 100% and a concentration of 20 mass% in terms of solid residue at 150°C. The resultant solution was subjected to filtration with a nylon-made filter (pore size: 0.1 µm). The resultant polymer was found to contain a structure represented by the following Formula (E5), and to have a weight average molecular weight Mw of 2,400 as determined by GPC in terms of polystyrene.

In the following chemical formula, the number attached to the side of the siloxane unit represents a molar ratio (total 100).

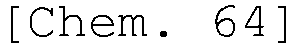

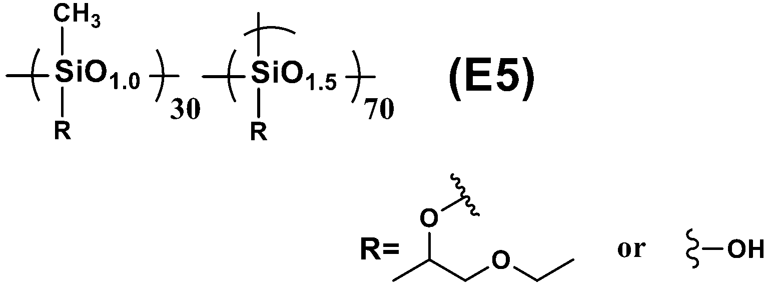

### [2] Preparation of silicon-containing resist underlayer film-forming composition

The polysiloxane (polymer) produced in each of the Synthesis Examples describe above, an acid (additive 1), a condensation catalyst (additive 2), and a solvent were mixed in proportions shown in Table 1. The resultant mixture was filtered through a 0.1 µm fluororesin filter, and thus each silicon-containing resist underlayer film-forming composition is prepared. In Table 1, the amount of each component added is shown by part(s) by mass.

Although the composition was prepared from the solution containing the hydrolysis condensate (polymer) produced in each Synthesis Example, the amount of each polymer shown in Table 1 corresponds not to the amount of the polymer solution, but to the amount of the polymer itself.

DIW means ultrapure water, PGEE means propylene glycol monoethyl ether, and PGME means propylene glycol monomethyl ether, respectively.

Further, MA means maleic acid, IMTEOS means triethoxysilylpropyl-4,5-dihydroimidazole, and TPSNO3 means triphenylsulfonium nitrate, respectively.

**[Table 1]**

| | Polymer | Additive 1 | Additive 2 | Solvent | | |
|---|---|---|---|---|---|---|
| Example 1 | Synthesis Example 1 | MA | TPSNO3 | PGEE | PGME | DIW |
| (Parts by mass) | 0.5 | 0.005 | 0.005 | 80 | 8 | 12 |
| Example 2 | Synthesis Example 1 | MA | IMTEOS | PGEE | PGME | DIW |
| (Parts by mass) | 0.5 | 0.005 | 0.015 | 80 | 8 | 12 |
| Example 3 | Synthesis Example 2 | MA | TPSNO3 | PGEE | PGME | DIW |
| (Parts by mass) | 0.5 | 0.005 | 0.005 | 80 | 8 | 12 |
| Example 4 | Synthesis Example 3 | MA | TPSNO3 | PGEE | PGME | DIW |
| (Parts by mass) | 0.5 | 0.005 | 0.005 | 80 | 8 | 12 |
| Example 5 | Synthesis Example 4 | MA | TPSNO3 | PGEE | PGME | DIW |
| (Parts by mass) | 0.5 | 0.005 | 0.005 | 80 | 8 | 12 |
| Comparative Example 1 | Comparative Synthesis Example 1 | MA | TPSNO3 | PGEE | PGME | DIW |
| (Parts by mass) | 0.5 | 0.005 | 0.005 | 80 | 8 | 12 |

| | | | | | | |
|---|---|---|---|---|---|---|
| * Examples 1 to 5 and Comparative Example 1 further contain nitric acid contained in the polymer solution prepared in each Synthesis Example. | | | | | | |

### [3] Preparation of organic underlayer film-forming composition

In a nitrogen atmosphere, a 100-mL four-necked flask was charged with 6.69 g (0.040 mol) of carbazole (manufactured by Tokyo Chemical Industry Co., Ltd.), 7.28 g (0.040 mol) of 9-fluorenone (manufactured by Tokyo Chemical Industry Co., Ltd.), and 0.76 g (0.0040 mol) of p-toluenesulfonic acid monohydrate (manufactured by Tokyo Chemical Industry Co., Ltd.), and then 6.69 g of 1,4-dioxane (manufactured by Kanto Chemical Co., Inc.) was added to the flask. The resultant mixture was stirred and then heated to 100°C for dissolution, and thus polymerization was initiated. After 24 hours, the mixture was allowed to cool to 60°C.

The cooled reaction mixture was diluted with 34 g of chloroform (manufactured by Kanto Chemical Co., Inc.), and the diluted mixture was added to 168 g of methanol (manufactured by Kanto Chemical Co., Inc.) for precipitation.

The resultant precipitate was subjected to filtration and recovery, and the recovered solid was dried with a reduced-pressure dryer at 80°C for 24 hours to obtain 9.37 g of a desired polymer represented by the Formula (X) (hereinafter, abbreviated as PCzFL).

The results of ¹H-NMR measurement of PCzFL were as follows.
¹H-NMR (400MHz, DMSO-d₆) : δ7.03-7.55 (br, 12H), δ7.61-8.10(br,4H), δ11.18(br, 1H)

Further, PCzFL was found to have a weight average molecular weight (Mw) of 2,800 as determined by GPC in terms of polystyrene and a polydispersity Mw/Mn of 1.77.

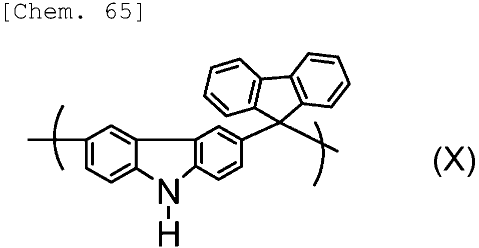

PCzFL (20 g), 3.0 g of tetramethoxymethyl glycoluril (Powder Link 1174 (trade name), manufactured by Nippon Cytec Industries (former Mitsui Cytec Ltd.)) as a crosslinking agent, 0.30 g of pyridinium p-toluenesulfonate as a catalyst, and 0.06 g of MEGAFACE R-30 (manufactured by DIC Corporation, trade name) as a surfactant were mixed, and the resulting mixture was dissolved in 88 g of propylene glycol monomethyl ether acetate to prepare a solution. Thereafter, the obtained solution was filtered using a polyethylene microfilter having a pore size of 0.10 um, and further filtered using a polyethylene microfilter having a pore size of 0.05 µm to prepare an organic underlayer film-forming composition.

### [4] Test for Solvent Resistance

The compositions prepared in Examples 1 to 5 and Comparative Example 1 were applied onto silicon wafers with a spinner. Si-containing resist underlayer films were each formed by heating at 215°C for 1 minute on a hot plate, and the film thickness of the obtained resist underlayer film was measured. The film thickness was about 10 nm.

Thereafter, a mixed solvent of propylene glycol monomethyl ether/propylene glycol monomethyl ether acetate (7/3 (V/V)) was applied onto each resist underlayer film, and then spin-dried. The film thickness of the underlayer was measured after application of the solvent, thereby evaluating the change (%) in film thickness between before application of the mixed solvent as a reference (100%) and after application of the mixed solvent. Solvent resistance was evaluated as "Good" when a film had a film thickness change of 1% or less before and after application of the mixed solvent, whereas solvent resistance was evaluated as "Not cured" when a film had a film thickness change of more than 1%.

The obtained results are shown in Table 2.

**[Table 2]**

| | Solvent resistance |
|---|---|
| Example 1 | Good |
| Example 2 | Good |
| Example 3 | Good |
| Example 4 | Good |
| Example 5 | Good |
| Comparative Example 1 | Good |

### [4] Formation of resist pattern by EUV exposure: negative development with organic solvent

The organic underlayer film-forming composition was applied onto a silicon wafer by spin coating, and heated on a hot plate at 215°C for 1 minute to form an organic underlayer film (layer A) (film thickness: 90 nm).

The composition obtained in Example 1 was applied thereon by spin coating, and heated on a hot plate at 215°C for 1 minute to form a resist underlayer film (B) layer (film thickness: 10 nm).

Further, a resist solution for EUV (tin oxide-based resist) was applied thereon by spin coating, and heated at 130°C for 1 minute to form an EUV resist layer (C) layer, and thereafter, the layer was exposed using an EUV exposure apparatus (NXE3300B) manufactured by ASML under the conditions of NA = 0.33, σ = 0.67/0.90, and Dipole. At the time of exposure, exposure was performed through a mask set so that the line width and the inter-line width (space width) of the EUV resist were 16 nm after the following development, that is, a 16 nm line-and-space (L/S) = 1/1 dense line was formed.

After the exposure, the film was subjected to post exposure bake (PEB, 170°C for 1 min), cooled to room temperature on a cooling plate, developed for 60 seconds using an organic solvent (propylene glycol monomethyl ether acetate), and rinsed to form a resist pattern.

In the same procedure, a resist pattern was formed using each of the compositions obtained in Examples 2 to 5 and Comparative Example 1.

Using a CD-SEM (CG4100) manufactured by Hitachi High-Technologies Corporation, the exposure amount at the time of formation with a line dimension of 16 nm was measured and taken as sensitivity, and the dimension of 60 lines at this time was measured to determine a line width roughness (LWR). The results are shown in Table 3.

**[Table 3]**

| | Sensitivity (mJ/cm²) | Roughness (nm) |
|---|---|---|
| Example 1 | 64.6 | 3.7 |
| Example 2 | 64.8 | 3.7 |
| Example 3 | 63.9 | 3.7 |
| Example 4 | 65.3 | 3.7 |
| Example 5 | 64.3 | 3.6 |
| Comparative Example 1 | 65.9 | 3.8 |

As shown in Table 3, it is found that when a polysiloxane film containing a carbon-carbon double bond formed using the silicon-containing resist underlayer film-forming composition of the present invention is used as a resist underlayer film, sensitivity can be improved without deterioration of roughness. On the other hand, the composition of Comparative Example 1 having no carbon-carbon double bond resulted in poor sensitivity.

## Claims

1. A silicon-containing resist underlayer film-forming composition comprising:
component [A]: a polysiloxane; and
component [C]: a solvent,
wherein
the polysiloxane contains a constituent unit derived from a hydrolyzable silane (A) represented by Formula (A-1) below: 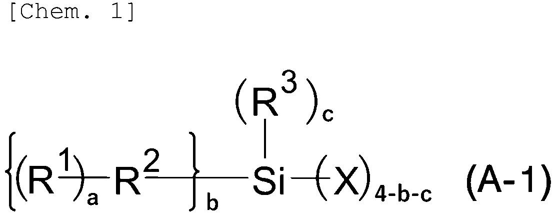
in the Formula (A-1), a and b each independently represent an integer of 1 to 3,
c represents an integer of 0 to 2,
b+c represents an integer of 1 to 3,
R¹ represents a group represented by Formula (A-1-1) below,
R² represents a (a+1)-valent group having no ring structure or a (a+1)-valent group having an aromatic hydrocarbon ring,
R³ represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group or an optionally substituted alkoxyaralkyl group, or an organic group having an epoxy group, an organic group having a mercapto group, an organic group having an amino group, an organic group having an alkoxy group, an organic group having a sulfonyl group or an organic group having a cyano group, or a combination of two or more thereof,
X represents an alkoxy group, an aralkyloxy group, an acyloxy group, or a halogen atom, and
for a plurality of R¹, R², R³, and X, the plurality of R¹, R², R³, and X may be same or different, 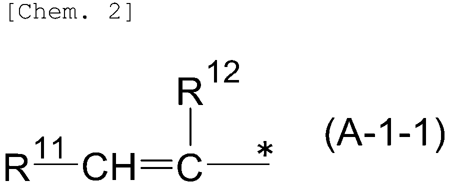
in the Formula (A-1-1), R¹¹ represents a hydrogen atom or a hydrocarbon group having 1 to 6 carbon atoms, R¹² represents a hydrogen atom, a hydrocarbon group having 1 to 4 carbon atoms, or a halogen atom, and * represents a bonding hand.

2. The silicon-containing resist underlayer film-forming composition comprising:
component [A']: a polysiloxane;
component [B]: a hydrolyzable silane (A) represented by Formula (A-1) below; and
component [C]: a solvent, 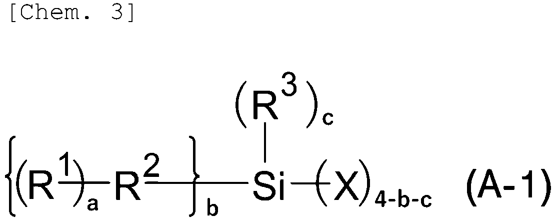
in the Formula (A-1), a and b each independently represent an integer of 1 to 3,
c represents an integer of 0 to 2,
b+c represents an integer of 1 to 3,
R¹ represents a group represented by Formula (A-1-1) below,
R² represents a (a+1)-valent group having no ring structure or a (a+1)-valent group having an aromatic hydrocarbon ring,
R³ represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group or an optionally substituted alkoxyaralkyl group, or an organic group having an epoxy group, an organic group having a mercapto group, an organic group having an amino group, an organic group having an alkoxy group, an organic group having a sulfonyl group or an organic group having a cyano group, or a combination of two or more thereof,
X represents an alkoxy group, an aralkyloxy group, an acyloxy group, or a halogen atom, and
for a plurality of R¹, R², R³, and X, the plurality of R¹, R², R³, and X may be same or different, 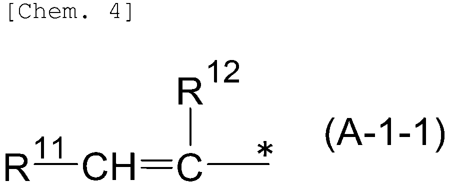
in the Formula (A-1-1), R¹¹ represents a hydrogen atom or a hydrocarbon group having 1 to 6 carbon atoms, R¹² represents a hydrogen atom, a hydrocarbon group having 1 to 4 carbon atoms, or a halogen atom, and * represents a bonding hand.

3. The silicon-containing resist underlayer film-forming composition according to claim 1 or 2, wherein the silicon-containing resist underlayer film-forming composition is a composition for forming a silicon-containing resist underlayer film formed between a metal-containing resist film and a substrate.

4. The silicon-containing resist underlayer film-forming composition according to claim 1, wherein the component [A] does not have an alkyl iodide group.

5. The silicon-containing resist underlayer film-forming composition according to claim 2, wherein the component [A'] does not have an alkyl iodide group.

6. The silicon-containing resist underlayer film-forming composition according to claim 1, wherein
the component [A] contains a constituent unit derived from a hydrolyzable silane (1) represented by Formula (1) below,
b in the Formula (A-1) is 1, and c is 0, and
a total molar ratio of the constituent unit (Aᵤₙᵢₜ) derived from the hydrolyzable silane (A) represented by the Formula (A-1) and the constituent unit (1ᵤₙᵢₜ) derived from the hydrolyzable silane (1) represented by the Formula (1) in all T units in the component [A] is 5 mol% or more and 100 mol% or less,
[Chem. 5]
R¹ₐSi(R²)₄₋ₐ (1)
in the Formula (1), R¹ is a group bonded to a silicon atom, and each independently represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, or an optionally substituted alkenyl group, or an organic group having an epoxy group, an organic group having a mercapto group, an organic group having an amino group, an organic group having an alkoxy group, an organic group having a sulfonyl group, or an organic group having a cyano group, or a combination of two or more thereof,
R² is a group or atom bonded to a silicon atom, and each independently represents an alkoxy group, an aralkyloxy group, an acyloxy group, or a halogen atom, and
a represents 1.

7. The silicon-containing resist underlayer film-forming composition according to claim 1 or 2, wherein the component [C] contains an alcohol-based solvent.

8. The silicon-containing resist underlayer film-forming composition according to claim 7, wherein the component [C] contains a propylene glycol monoalkyl ether.

9. The silicon-containing resist underlayer film-forming composition according to claim 1 or 2, further comprising component [D]: a curing catalyst.

10. The silicon-containing resist underlayer film-forming composition according to claim 1 or 2, further comprising component [E]: nitric acid.

11. The silicon-containing resist underlayer film-forming composition according to claim 1 or 2, wherein the component [C] contains water.

12. The silicon-containing resist underlayer film-forming composition according to claim 1 or 2, which is for forming a resist underlayer film for EUV lithography.

13. The silicon-containing resist underlayer film-forming composition according to claim 1 or 2, which is used in EUV lithography using a metal oxide resist film.

14. A silicon-containing resist underlayer film which is a cured product of the silicon-containing resist underlayer film-forming composition according to claim 1 or 2.

15. A semiconductor processing substrate comprising:
a semiconductor substrate; and
the silicon-containing resist underlayer film according to claim 14.

16. A method for producing a semiconductor element, the method comprising:
a step of forming an organic underlayer film on a substrate;
a step of forming a resist underlayer film on the organic underlayer film using the silicon-containing resist underlayer film-forming composition according to claim 1 or 2; and
a step of forming a metal-containing resist film on the resist underlayer film.

17. The method for producing a semiconductor element according to claim 16, wherein
the metal-containing resist film is formed from a metal-containing resist for use in EUV lithography.

18. The method for manufacturing a semiconductor element according to claim 16, wherein
in the step of forming a resist underlayer film, a silicon-containing resist underlayer film-forming composition filtered through a nylon filter is used.

19. A method for forming a pattern, the method comprising:
a step of forming an organic underlayer film on a semiconductor substrate;
a step of forming a resist underlayer film by applying and baking the silicon-containing resist underlayer film-forming composition according to claim 1 or 2 on the organic underlayer film;
a step of forming a metal-containing resist film on the resist underlayer film;
a step of obtaining a resist pattern by exposing and developing the metal-containing resist film;
a step of etching the resist underlayer film by using the resist pattern as a mask; and
a step of etching the organic underlayer film by using the patterned resist underlayer film as a mask.

20. The method for forming a pattern according to claim 19, further comprising
a step of removing the resist underlayer film by a wet method using a chemical liquid after the step of etching the organic underlayer film.

21. The method for forming a pattern according to claim 19, wherein
the metal-containing resist film is formed from a metal-containing resist for use in EUV lithography.
